(19) Europäisches Patentamt
European Patent Office
Office européen des brevets

(11) **EP 4 318 057 A1**

(12) **EUROPEAN PATENT APPLICATION**
published in accordance with Art. 153(4) EPC

(43) Date of publication:
**07.02.2024 Bulletin 2024/06**

(21) Application number: **22780390.5**

(22) Date of filing: **23.03.2022**

(51) International Patent Classification (IPC):
***G02B 5/20*** *(2006.01)* ***C09B 67/20*** *(2006.01)*
***C09D 4/00*** *(2006.01)* ***C09D 7/61*** *(2018.01)*
***C09D 7/62*** *(2018.01)* ***C09D 7/63*** *(2018.01)*
***G02B 5/00*** *(2006.01)* ***G03F 7/004*** *(2006.01)*
***G03F 7/027*** *(2006.01)* ***H01L 27/146*** *(2006.01)*

(52) Cooperative Patent Classification (CPC):
**C09B 67/006; C09D 4/00; C09D 7/61; C09D 7/62; C09D 7/63; G02B 5/00; G02B 5/20; G03F 7/004; G03F 7/027; H01L 27/146**

(86) International application number:
**PCT/JP2022/013566**

(87) International publication number:
**WO 2022/210175 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **29.03.2021 JP 2021055075**
**11.06.2021 JP 2021097851**

(71) Applicant: **FUJIFILM Corporation**
**Tokyo 106-8620 (JP)**

(72) Inventors:
- **ADACHI Misaho**
  **Haibara-gun, Shizuoka 421-0396 (JP)**
- **IDEI Hiroaki**
  **Haibara-gun, Shizuoka 421-0396 (JP)**
- **YOKOYAMA Norifumi**
  **Haibara-gun, Shizuoka 421-0396 (JP)**

(74) Representative: **HGF**
**HGF Limited**
**1 City Walk**
**Leeds LS11 9DX (GB)**

(54) **BLACK PHOTOSENSITIVE COMPOSITION, MANUFACTURING METHOD OF BLACK PHOTOSENSITIVE COMPOSITION, CURED FILM, COLOR FILTER, LIGHT-SHIELDING FILM, OPTICAL ELEMENT, SOLID-STATE IMAGE CAPTURING ELEMENT, AND HEADLIGHT UNIT**

(57) The present invention provides a black photosensitive composition which has excellent residue suppressibility in a case where a pattern is formed and which makes it possible to form a pattern having excellent adhesiveness with a smaller exposure amount, a production method for a black photosensitive composition, a cured film, a color filter, a light shielding film, an optical element, a solid-state imaging element, and a headlight unit. The black photosensitive composition according to the present invention is a black photosensitive composition containing a black pigment, a resin, a carboxylic acid anhydride, and a polymerizable compound, in which the carboxylic acid anhydride has a molecular weight of 50 to 550, the carboxylic acid anhydride has a content of 0.30% to 10.0% by mass with respect to a total solid content of the black photosensitive composition, and the black pigment has an average particle diameter of 250 nm or less.

FIG. 1

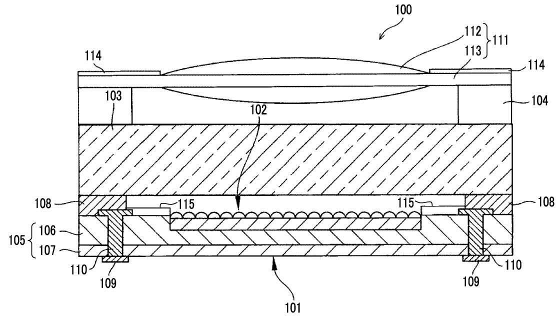


EP 4 318 057 A1

## Description

## BACKGROUND OF THE INVENTION

1. Field of the Invention

The present invention relates to a black photosensitive composition, a production method for a black photosensitive composition, a cured film, a color filter, a light shielding film, an optical element, a solid-state imaging element, and a headlight unit.

2. Description of the Related Art

A color filter used in a liquid crystal display device includes a light shielding film which is called a black matrix, for the intended purpose of, for example, shielding light between colored pixels or enhancing contrast.

In addition, currently, a compact and thin imaging unit is mounted on a mobile terminal of electronic apparatus such as a mobile phone and a personal digital assistant (PDA). A solid-state imaging element such as a charge coupled device (CCD) image sensor or a complementary metal-oxide semiconductor (CMOS) image sensor includes a light shielding film for intended the purpose of, for example, preventing the generation of noise or improving image quality.

For example, JP2005-258254A discloses "a black photosensitive resin composition containing a black colorant (A), a binder resin (B), an addition-polymerizable compound (C) having an ethylenically unsaturated bond, one or two or more kinds of photopolymerization initiators (D), an aliphatic monocarboxylic acid (E) having 12 or more and 24 or less carbon atoms, and a solvent (F)".

## SUMMARY OF THE INVENTION

As a result of examining the black photosensitive resin composition described in JP2005-258254A, the inventors of the present invention found that it is difficult to achieve both the suppression of a residue in a case of forming a pattern using the black photosensitive composition and the adhesiveness of a pattern to be formed with respect to a base material. In particular, regarding the adhesiveness, it is preferable that a pattern having excellent adhesiveness is formed with a smaller exposure amount.

Therefore, an object of the present invention is to provide a black photosensitive composition which has excellent residue suppressibility in a case where a pattern is formed and which makes it possible to form a pattern having excellent adhesiveness with a smaller exposure amount.

In addition, another object of the present invention is to provide a production method for a black photosensitive composition, a cured film, a color filter, a light shielding film, an optical element, a solid-state imaging element, and a headlight unit.

As a result of carrying out extensive studies, the inventors of the present invention found that the above objects can be achieved by the following configurations, whereby the present invention was completed.

(1) A black photosensitive composition comprising:

a black pigment;
a resin;
a carboxylic acid anhydride; and
a polymerizable compound,
wherein the carboxylic acid anhydride has a molecular weight of 50 to 550,
the carboxylic acid anhydride has a content of 0.30% to 10.0% by mass with respect to a total solid content of the black photosensitive composition, and
the black pigment has an average particle diameter of 250 nm or less.

(2) The black photosensitive composition according to (1), wherein the carboxylic acid anhydride is a cyclic carboxylic acid anhydride, and a compound obtained by subjecting the cyclic carboxylic acid anhydride to ring opening has a pKa of -1.20 to 4.50.

(3) The black photosensitive composition according to (1) or (2), wherein the carboxylic acid anhydride has a ClogP value of 6.00 or less.

(4) The black photosensitive composition according to any one of (1) to (3), wherein the carboxylic acid anhydride has 1 to 40 carbon atoms.

(5) The black photosensitive composition according to any one of (1) to (4), wherein the carboxylic acid anhydride

is a carboxylic acid anhydride selected from the group consisting of a carboxylic acid anhydride represented by Formula (P1) described later and a carboxylic acid anhydride represented by Formula (P2) described later.

(6) The black photosensitive composition according to (5), wherein the divalent organic group represents an alkylene group which may have a substituent, an alkenylene group which may have a substituent, or an arylene group which may have a substituent,

a $-CH_2-$ group in the alkylene group may be substituted with a -NH- group,

in a case where the alkylene group has a plurality of substituents, the substituents may be bonded to each other to form a ring, in a case where the alkenylene group has a plurality of substituents, the substituents may be bonded to each other to form a ring, and in a case where the arylene group has a plurality of substituents, the substituents may be bonded to each other to form a ring,

the tetravalent organic group represents a tetravalent aromatic ring group which may have a substituent, a tetravalent aliphatic group which may have a substituent, a tetravalent group representative of Formula (Q1) described later, or a tetravalent group represented by Formula (Q2) described later.

(7) The black photosensitive composition according to any one of (1) to (6), wherein the black pigment is one or more selected from the group consisting of titanium black, carbon black, and a bisbenzofuranone compound.

(8) The black photosensitive composition according to any one of (1) to (7), wherein the black photosensitive composition contains inorganic particles different from the black pigment, or the black photosensitive composition contains the inorganic particles different from the black pigment and modified inorganic particles having a coating layer that coats at least a part of the inorganic particles.

(9) A production method for the black photosensitive composition according to any one of (1) to (8), the production method comprising:

a step 1 of mixing a pre-mixture containing the black pigment, the resin, and the carboxylic acid anhydride with a beads mill to obtain a mixture; and

a step 2 of mixing the mixture with the polymerizable compound to obtain the black photosensitive composition.

(10) A cured film that is formed from the black photosensitive composition according to any one of (1) to (8).

(11) A color filter comprising the cured film according to (10).

(12) A light shielding film comprising the cured film according to (10).

(13) An optical element comprising the cured film according to (10).

(14) A solid-state imaging element comprising the cured film according to (10).

(15) A headlight unit of a lighting tool for a vehicle, comprising:

a light source; and

a light shielding unit that shields at least a part of light emitted from the light source, wherein the light shielding unit includes the cured film according to (10).

According to the present invention, it is possible to provide a black photosensitive composition which has excellent residue suppressibility in a case where a pattern is formed and which makes it possible to form a pattern having excellent adhesiveness with a smaller exposure amount.

In addition, according to the present invention, it is also possible to provide a production method for a black photosensitive composition, a cured film, a color filter, a light shielding film, an optical element, a solid-state imaging element, and a headlight unit.

## BRIEF DESCRIPTION OF THE DRAWINGS

Fig. 1 is a schematic cross-sectional view showing an example of the configuration of a solid-state imaging device.

Fig. 2 is a schematic cross-sectional view showing an imaging unit included in the solid-state imaging device shown in Fig. 1 in an enlarged manner.

Fig. 3 is a schematic cross-sectional view showing an example of the configuration of an infrared sensor.

Fig. 4 is a schematic view showing an example of the configuration of a headlight unit.

Fig. 5 is a schematic perspective view showing an example of the configuration of a light shielding unit of the headlight unit.

Fig. 6 is a schematic view showing an example of a light distribution pattern formed by the headlight unit.

Fig. 7 is a schematic view showing another example of the light distribution pattern formed by the headlight unit.

## DESCRIPTION OF THE PREFERRED EMBODIMENTS

Hereinafter, the present invention will be specifically described.

The constituent requirements described below may be embodied based on the representative embodiments of the present invention. However, the present invention is not limited to such embodiments.

It is noted that in the present specification, a numerical range expressed using "to" means a range including numerical values described before and after "to" as a lower limit value and an upper limit value.

In the present specification, regarding the description of a group (atomic group), in a case where whether the group is substituted or unsubstituted is not described, the group includes a group which has a substituent as well as a group which does not have a substituent. For example, the "alkyl group" includes not only an alkyl group (unsubstituted alkyl group) which does not have a substituent but also an alkyl group (substituted alkyl group) which has a substituent.

In addition, in the present specification, the organic group is a group containing at least one carbon atom.

In addition, in the present specification, the "actinic rays" or the "radiations" refer to, for example, far ultraviolet rays, extreme ultraviolet rays (EUV: extreme ultraviolet lithography), X-rays, and electron beams. In addition, the "light" in the present specification means actinic rays or radiations. In the present specification, unless otherwise specified, the "exposure" includes not only exposure with far ultraviolet rays, X-rays, EUV light, or the like but also drawing by corpuscular beams such as electron beams and ion beams.

In the present specification, "(meth)acrylate" means acrylate and methacrylate. In the present specification, "(meth)acryl" means acryl and methacryl. In the present specification, "(meth)acryloyl" means acryloyl and methacryloyl. In the present specification, "(meth)acrylamide" means acrylamide and methacrylamide. In the present specification, the "monomeric substance" and the "monomer" have the same definition.

In the present specification, "ppm" means "parts-per-million ($10^{-6}$)", "ppb" means "parts-per-billion ($10^{-9}$)", and "ppt" means "parts-per-trillion ($10^{-12}$)".

In addition, in the present specification, the "weight-average molecular weight (Mw)" is a value in terms of polystyrene, as measured according to a gel permeation chromatography (GPC) method.

In the present specification, the "GPC method" means a method using HLC-8020GPC (manufactured by Tosoh Corporation) as a measuring instrument, TSKgel SuperHZM-H, TSKgel SuperHZ4000, and TSKgel SuperHZ2000 (manufactured by Tosoh Corporation, 4.6 mm ID x 15 cm) as columns, and tetrahydrofuran (THF) as an eluent.

A bonding direction of a divalent group (for example, -COO-) described in the present specification is not limited unless otherwise specified. For example, in a case where Y is -COO- in a compound represented by General Formula "X-Y-Z", the compound may be "X-O-CO-Z" or may be "X-CO-O-Z".

In the present specification, examples of the halogen atom include a fluorine atom, a chlorine atom, a bromine atom, and an iodine atom.

[Black photosensitive composition]

The black photosensitive composition according to the embodiment of the present invention (hereinafter, also simply referred to as the "composition") is a composition containing a black pigment, a resin, a carboxylic acid anhydride, and a polymerizable compound, in which the carboxylic acid anhydride has a molecular weight of 50 to 550, the carboxylic acid anhydride has a content of 0.3% to 10% by mass with respect to a total solid content of the composition, and the black pigment has an average particle diameter of 250 nm or less.

Although the mechanism by which the objects of the present invention are achieved is not necessarily revealed clearly in a case where the composition having the above constitution has been used, the inventors of the present invention presume as follows.

That is, in a case where the composition contains a predetermined amount or more of the carboxylic acid anhydride, the acidity of the coating film formed from the composition is increased, and concurrently, an adequate amount of the carboxylic acid anhydride interacts in the composition with the surface of the black pigment. Therefore, the non-exposed portion in the composition according to the embodiment of the present invention has a good affinity with a developer, and a residue in a case of carrying out development to form a pattern is suppressed. In addition, since the amount of the carboxylic acid anhydride contained in the composition is equal or smaller than a predetermined amount, the adhesiveness of the pattern to the base material is also kept favorable. In addition, since the carboxylic acid anhydride does undergo ring opening and the hydrophilicity does not increase before the development, it is also presumed that the developer does not easily permeate and the adhesiveness of the pattern to the base material is improved. Further, due to the fact that the black photosensitive composition contains a black pigment having an average particle diameter equal to or smaller than a predetermined value and the average particle diameter of the black pigment is not too large, it is presumed to be suppressed that a residue remains between the patterns or the like during development in a case

of forming a pattern.

In addition, the composition according to the embodiment of the present invention can also suppress the undercut of the formed pattern to be formed.

Hereinafter, in a case where at least one or more effects of an effect that the residue suppressibility in a case of forming a pattern using a composition is more excellent, an effect that a pattern exhibiting more excellent adhesiveness can be formed with a smaller exposure amount, and an effect that the suppressibility of undercut of a pattern formed from a composition is excellent, are obtained, it is also said the effect of the present invention is more excellent.

Hereinafter, components contained in the composition according to the embodiment of the present invention will be described.

[Carboxylic acid anhydride (specific acid anhydride)]

The composition according to the embodiment of the present invention contains a carboxylic acid anhydride.

The molecular weight of the carboxylic acid anhydride is in a range of 50 to 550, and an acid anhydride that satisfies the requirement of the molecular weight is also referred to as a specific acid anhydride.

The carboxylic acid anhydride is a compound having a carboxylic acid anhydride group (a group represented by -CO-O-CO-).

The specific acid anhydride has one or more carboxylic acid anhydride groups, and it has preferably 1 to 5 carboxylic acid anhydride groups and more preferably has one or two carboxylic acid anhydride groups.

It is also preferable that the specific acid anhydride is a cyclic carboxylic acid anhydride. The cyclic carboxylic acid anhydride is a compound having a ring (an acid anhydride ring) containing a carboxylic acid anhydride group as a constitutional element that forms a cyclic structure.

In a case where the cyclic carboxylic acid anhydride has a plurality of carboxylic acid anhydride groups, only a part of the carboxylic acid anhydride groups may be contained in the acid anhydride ring, or all the carboxylic acid anhydride groups may be contained in the acid anhydride ring.

In general, in a case where the cyclic carboxylic acid anhydride comes into contact with an alkali (an alkali developer described below or the like), the acid anhydride ring thereof usually undergoes ring opening (hydrolysis).

The number of ring member atoms in the acid anhydride ring which can be contained in the specific acid anhydride is preferably 4 to 20 and more preferably 5 to 6. It is noted that the preferred number of the ring member atoms of the acid anhydride ring referred to here is intended to indicate the number of ring member atoms of only the ring containing the acid anhydride group, even in a case where the acid anhydride ring is fused with another ring. For example, in a case where both terminals of a group represented by -CO-O-CO- are respectively bonded to adjacent carbon atoms in a benzene ring group, the number of ring member atoms of the acid anhydride ring to be formed is 5.

The molecular weight of the specific acid anhydride is 50 to 550, preferably 74 to 450, and more preferably 90 to 358.

The number of carbon atoms of the specific acid anhydride is preferably 1 to 40, more preferably 2 to 30, and still more preferably 4 to 20.

From the viewpoint that the effect of the present invention is more excellent, the ClogP value of the specific acid anhydride is preferably 8.00 or less, more preferably 6.00 or less, still more preferably 5.00 or less, and particularly preferably 3.00 or less. The ClogP value of the specific acid anhydride is preferably -6.00 or more and more preferably -3.00 or more.

In addition, in a case where the specific acid anhydride is a cyclic carboxylic acid anhydride, the ClogP value of the compound obtained by subjecting the specific acid anhydride to ring opening, for example, by bringing the specific acid anhydride into contact with an alkali, is preferably 8.00 or less, more preferably 6.00 or less, still more preferably 5.00 or less, and particularly preferably 3.00 or less. The ClogP value of the compound obtained by the ring opening is preferably -6.00 or more and more preferably -3.00 or more.

The ClogP value is a value calculated by a program "CLOGP" available from Daylight Chemical Information System, Inc. This program provides a value of "calculated logP" calculated by the fragment approach (see the following documents) of Hansch and Leo. The fragment approach is based on a chemical structure of a compound, and the logP value of the compound is estimated by dividing the chemical structure into partial structures (fragments) and summing up degrees of contribution to logP which are assigned to the fragments. Details of the method are described in the following documents. In the present specification, a ClogP value calculated by a program CLOGP v 4.82 is used.

A. J. Leo, Comprehensive Medicinal Chemistry, Vol. 4, C. Hansch, P. G. Sammnens, J. B. Taylor and C. A. Ramsden, Eds., p. 295, Pergamon Press, 1990, C. Hansch & A. J. Leo. Substituent Constants For Correlation Analysis in Chemistry and Biology. John Wiley & Sons. A. J. Leo. Calculating logPoct from structure. Chem. Rev., 93, 1281 to 1306, 1993.

The logP refers to a common logarithm of a partition coefficient P, is a physical property value that shows how a certain organic compound is partitioned in an equilibrium of a two-phase system consisting of oil (generally, 1-octanol)

and water by using a quantitative numerical value, and is expressed by the following expression.

$$\log P = \log(Coil/Cwater)$$

In the formula, Coil represents a molar concentration of a compound in an oil phase, and Cwater represents a molar concentration of the compound in a water phase.

The greater the positive logP value based on 0, the higher the oil solubility, and the greater the absolute value of negative logP, the higher the water solubility. Accordingly, the value of logP has a negative correlation with the water solubility of an organic compound and is widely used as a parameter for estimating the hydrophilicity and hydrophobicity of an organic compound.

From the viewpoint that the effect of the present invention is more excellent, the pKa of the specific acid anhydride is preferably -3.00 to 8.00, more preferably -2.00 to 6.00, and still more preferably -1.40 to 4.50. In addition, in a case where the specific acid anhydride is a cyclic acid anhydride, the pKa value of the compound obtained by subjecting the specific acid anhydride to ring opening, for example, by bringing the specific acid anhydride into contact with an alkali, is preferably -3.00 to 8.00, more preferably -2.00 to 6.00, and still more preferably -1.20 to 4.50.

In the present specification, an acid dissociation constant (pKa) represents a pKa in an aqueous solution and is specifically a value determined by computation from a value based on the Hammett's substituent constant and the database of publicly known literature values, using the following software package 1. Any of the pKa values described in the present specification indicate values determined by computation using the software package.

Software Package 1: Advanced Chemistry Development (ACD/Labs) Software V 8.14 for Solaris (1994 - 2007 ACD/Labs).

From the viewpoint that the effect of the present invention is more excellent, the specific acid anhydride is preferably a carboxylic acid anhydride represented by Formula (P1) or a carboxylic acid anhydride represented by Formula (P2).

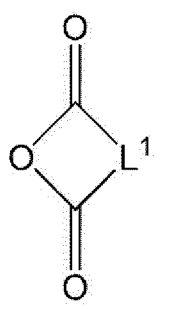

(P1)

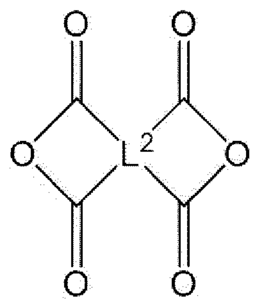

(P2)

$L^1$ represents a divalent organic group.

Examples of the divalent organic group include a divalent hydrocarbon group which may have a substituent, and a group obtained by combining a divalent hydrocarbon group which may have a substituent with -O-, -S-, $-NR^a-$, -CO-, or a divalent heterocyclic group.

$R^a$ represents a hydrogen atom or an alkyl group.

Examples of the above-described combined group include $-NR^a$-divalent hydrocarbon group- and -divalent hydrocarbon group-CO-divalent hydrocarbon group-.

The divalent hydrocarbon group may have one substituent or may have a plurality of (two or more) substituents.

The substituent may be a monovalent substituent or may be a divalent substituent.

The monovalent substituent is not particularly limited. Examples thereof include an alkyl group, a carboxyl group, an amino group, an alkoxy group, an aryloxy group, an aromatic heterocyclic oxy group, an acyl group, an alkoxycarbonyl group, an aryloxycarbonyl group, an acyloxy group, an acylamino group, an alkoxycarbonylamino group, an aryloxycarbonylamino group, an alkylthio group, an arylthio group, an aromatic heterocyclic thio group, a ureide group, a halogen atom, a cyano group, a hydrazino group, a heterocyclic group (for example, a heteroaryl group), a silyl group, and groups obtained by combining these (for example, *-NH-CO-O-alkylene group-aryl group, where * represents a bonding position). It is noted that the substituent may be further substituted with a substituent.

The divalent substituent is not particularly limited, and examples thereof include $*=P(Ph)_3$. * represents a

bonding position.

In a case where the divalent hydrocarbon group has a plurality of substituents, the substituents may be bonded to each other to form a ring. The ring to be formed may be an aromatic ring or may be an aliphatic ring.

The ring to be formed may be a monocyclic ring or may be a polycyclic ring.

Examples of the aromatic ring include an aromatic hydrocarbon ring and an aromatic heterocyclic ring.

Examples of the aromatic hydrocarbon ring include a benzene ring, a naphthalene ring, an anthracene ring, a phenanthrene ring, and a pyrene ring. Examples of the aromatic heterocyclic ring include a furan ring, a pyrrole ring, a pyrazole ring, an imidazole ring, a thiophene ring, an oxazole ring, and a thiazole ring.

In a case where the aromatic ring constituting the aromatic ring is a polycyclic ring, it may be a polycyclic ring obtained by combining an aromatic hydrocarbon ring and an aromatic heterocyclic ring.

Examples of the divalent hydrocarbon group include a divalent aliphatic hydrocarbon group such as an alkylene group, an alkenylene group, or an alkynylene group, a divalent aromatic hydrocarbon group such as an arylene group, and groups obtained by combining these. Examples of the combined group include -divalent aliphatic hydrocarbon group-divalent aromatic hydrocarbon group-.

The divalent aliphatic hydrocarbon group (the alkylene group or the alkenylene group) and the divalent aromatic hydrocarbon group may have a substituent. That is, the divalent hydrocarbon group may be an alkylene group which may have a substituent, an alkenylene group which may have a substituent, and an arylene group which may have a substituent.

The kind of the above-described substituent is not particularly limited, and examples thereof include the groups exemplified in the substituent which may be contained in the divalent hydrocarbon group described above.

In addition, in a case where the divalent aliphatic hydrocarbon group (alkylene group or alkenylene group) and the divalent aromatic hydrocarbon group (arylene group) have a plurality of substituents, the substituents are bonded to each other to form a ring. The kind of the ring to be formed is as described above in the case where the divalent hydrocarbon group has a plurality of substituents.

The number of carbon atoms of the divalent hydrocarbon group is not particularly limited and is preferably 1 to 20 and more preferably 1 to 10.

The number of carbon atoms of the alkylene group is not particularly limited, and it is preferably 1 to 10, more preferably 1 to 5, and still more preferably 2 or 3.

The alkylene group may be linear, branched, or cyclic.

Each of the numbers of carbon atoms of the alkenylene group and the alkynylene group is not particularly limited, and it is preferably 2 to 10, more preferably 2 to 5, and still more preferably 2 or 3.

The arylene group may be a monocyclic ring or a polycyclic ring, and it preferably has 6 to 15 carbon atoms. The arylene group is preferably a phenylene group (a 1,2-phenylene group or the like) or a naphthalenediyl group (a naphthalene-1,8-diyl group).

Among the above, from the viewpoint that the effect of the present invention is more excellent, the divalent linking group represented by $L^1$ is preferably an alkylene group which may have a substituent, an alkenylene group which may have a substituent, or an arylene group which may have a substituent.

It is noted that the $-CH_2-$ group in the alkylene group may be substituted with an -NH-group.

In addition, In a case where the alkylene group has a plurality of substituents, the substituents may be bonded to each other to form a ring, in a case where the alkenylene group has a plurality of substituents, the substituents may be bonded to each other to form a ring, and in a case where the arylene group has a plurality of substituents, the substituents may be bonded to each other to form a ring.

$L^2$ represents a tetravalent organic group.

The tetravalent organic group is not particularly limited. Examples thereof include groups obtained by removing any four hydrogen atoms from various compounds such as a compound having a chain-type hydrocarbon such as ethylene and propane in a basic skeleton; a compound having a cyclic hydrocarbon such as cyclohexane in a basic skeleton; a compound having an aromatic hydrocarbon such as benzene or naphthalene in a basic skeleton; a compound having a benzophenone skeleton such as benzophenone; a compound having a diphenyl ether skeleton such as diphenyl ether; a compound having a diphenyl sulfone skeleton such as diphenyl sulfone; and a compound having a biphenyl skeleton such as biphenyl.

From the viewpoint that the effect of the present invention is more excellent, examples of the tetravalent linking group include a tetravalent aromatic ring group which may have a substituent, a tetravalent aliphatic group which may have a substituent, a tetravalent group representative of Formula (Q1), or a tetravalent group represented by Formula (Q2).

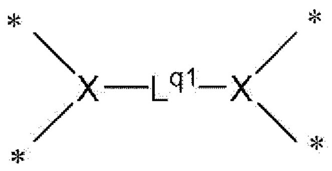
(Q1)

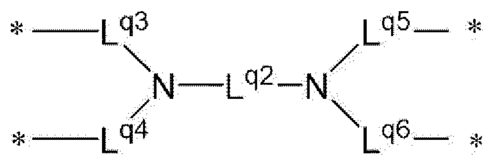
(Q2)

The tetravalent aromatic ring group represents a group obtained by removing any four hydrogen atoms from an aromatic ring. Examples of the aromatic ring constituting the tetravalent aromatic ring group include an aromatic hydrocarbon ring and an aromatic heterocyclic ring, where an aromatic hydrocarbon ring is preferable.

The aromatic ring may be a monocyclic ring or may be a polycyclic ring.

Examples of the aromatic hydrocarbon ring include a benzene ring, a naphthalene ring, an anthracene ring, a phenanthrene ring, and a pyrene ring.

The tetravalent aromatic ring group may have a substituent. The number of substituents is not particularly limited and may be one or plural. The kind of the above-described substituent is not particularly limited, and examples thereof include the groups exemplified in the substituent which may be contained in the divalent hydrocarbon group described above.

In addition, in a case where the tetravalent aromatic ring group has a plurality of substituents, the substituents may be bonded to each other to form a ring. The kind of the ring to be formed is as described above in the case where the divalent hydrocarbon group has a plurality of substituents.

Examples of the tetravalent aromatic ring group include the following groups. In the formulae, * represents a bonding position.

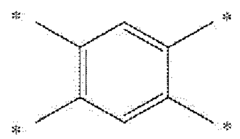

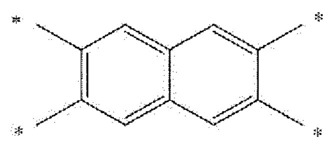

The tetravalent aliphatic group represents a group obtained by removing any four hydrogen atoms from an aliphatic group.

The number of carbon atoms of the tetravalent aliphatic group is not particularly limited, and it is preferably 2 to 20 and more preferably 3 to 15.

The aliphatic group may be linear, branched, or cyclic. In a case where the aliphatic group is cyclic, the tetravalent aliphatic ring group is obtained by removing any four hydrogen atoms from the aliphatic group.

Examples of the aliphatic ring constituting the tetravalent aliphatic ring group include an aliphatic hydrocarbon ring and an aliphatic heterocyclic ring, where an aliphatic hydrocarbon group is preferable.

The aliphatic ring may be a monocyclic ring or may be a polycyclic ring.

Examples of the aliphatic hydrocarbon ring include a cyclohexane ring and a cycloheptane ring.

The tetravalent aliphatic group may have a substituent. The number of substituents is not particularly limited and may be one or plural. The kind of the above-described substituent is not particularly limited, and examples thereof include the groups exemplified in the substituent which may be contained in the divalent hydrocarbon group described above.

In addition, in a case where the tetravalent aliphatic group has a plurality of substituents, the substituents may be bonded to each other to form a ring. The kind of the ring to be formed is as described above in the case where the divalent hydrocarbon group has a plurality of substituents.

Examples of the tetravalent aliphatic ring group include the following groups. In the formulae, * represents a bonding position.

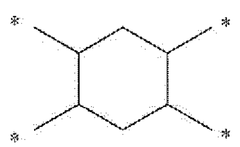

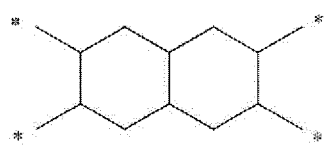

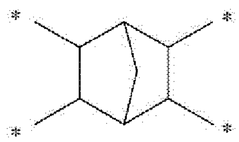

In Formula (Q1), X's each independently represents a trivalent aromatic ring group or a trivalent aliphatic ring group.

The trivalent aromatic ring group represents a group obtained by removing any three hydrogen atoms from an aromatic ring. Examples of the aromatic ring constituting the trivalent aromatic ring group include an aromatic hydrocarbon ring and an aromatic heterocyclic ring, where an aromatic hydrocarbon ring is preferable.

The aromatic ring may be a monocyclic ring or may be a polycyclic ring.

Examples of the aromatic hydrocarbon ring include a benzene ring, a naphthalene ring, an anthracene ring, a phenanthrene ring, and a pyrene ring.

The trivalent aliphatic ring group represents a group obtained by removing any three hydrogen atoms from an aliphatic ring. Examples of the aliphatic ring constituting the trivalent aliphatic ring group include an aliphatic hydrocarbon ring and an aliphatic heterocyclic ring, where an aliphatic hydrocarbon group is preferable.

The aliphatic ring may be a monocyclic ring or may be a polycyclic ring.

Examples of the aliphatic hydrocarbon ring include a cyclohexane ring and a cycloheptane ring.

$L^{q1}$ represents a single bond or a divalent linking group.

The divalent linking group is not particularly limited, and examples thereof include divalent hydrocarbon groups (for example, divalent aliphatic hydrocarbon groups such as an alkylene group, an alkenylene group, and an alkynylene group, and divalent aromatic hydrocarbon group such as an arylene group) which may have a substituent, and groups (for example, -CO-O-, -O-divalent hydrocarbon group-, -divalent hydrocarbon group-$NR^a$-divalent hydrocarbon group-, -divalent hydrocarbon group-O-CO-, and -CO-O-divalent hydrocarbon group-O-CO-) obtained by combining a divalent heterocyclic group, -O-, -S-, $-NR^a-$, -CO-, or the above-described divalent hydrocarbon groups which may have a substituent. $R^a$ represents a hydrogen atom or an alkyl group which may have a substituent. Examples of the substituent which may be contained in the alkyl group represented by $R^a$ include the groups exemplified in the substituent which may be contained in the divalent hydrocarbon group described above.

Examples of the substituent which may be contained in the divalent hydrocarbon group include the groups exemplified in the substituent which may be contained in the divalent hydrocarbon group described above.

The number of carbon atoms of the alkylene group is not particularly limited, and it is preferably 1 to 10, more preferably 1 to 5, and still more preferably 2 or 3.

The alkylene group may be linear, branched, or cyclic.

Each of the numbers of carbon atoms of the alkenylene group and the alkynylene group is not particularly limited, and it is preferably 2 to 10, more preferably 2 to 5, and still more preferably 2 or 3.

The arylene group may be a monocyclic ring or a polycyclic ring, and it preferably has 6 to 15 carbon atoms. The arylene group is preferably a phenylene group.

Examples of the tetravalent group represented by Formula (Q1) include the following groups. In the formulae, * represents a bonding position.

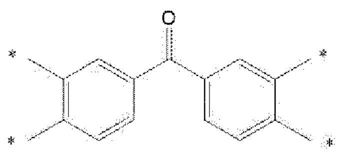

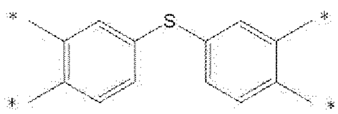

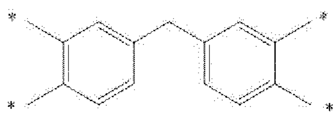

$L^{q2}$ represents a divalent linking group.

Examples of the divalent linking group represented by $L^{q2}$ include the groups exemplified in the divalent linking group represented by $L^{q1}$, and the like.

$L^{q3}$ to $L^{q6}$ each independently represent an alkylene group, and

The number of carbon atoms of the alkylene group is not particularly limited and is preferably 1 to 10, more preferably 1 to 5, and still more preferably 1 to 3.

The alkylene group may be linear, branched, or cyclic.

Examples of the carboxylic acid anhydride include aliphatic carboxylic acid anhydrides such as acetic acid anhydride, propionic acid anhydride, isobutyric acid anhydride, butyric acid anhydride, 2-methylbutyric acid anhydride, pivalic acid anhydride, isovaleric acid anhydride, valeric acid anhydride, 2-methyl valeric acid anhydride, 3-methyl valeric acid anhydride, 4-methyl valeric acid anhydride, hexanoic acid anhydride, 2-methylhexanoic acid anhydride, 3-methylhexanoic acid anhydride, 4-methylhexanoic acid anhydride, 5-methylhexanoic acid anhydride, heptanic acid anhydride, 2-methylheptanoic acid anhydride, 3-methylheptanoic acid anhydride, 4-methylheptanoic acid anhydride, 5-methylheptanoic acid anhydride, 6-methylheptanoic acid anhydride, 3-phenylpropionic acid anhydride, phenylacetic acid anhydride, methacrylic acid anhydride, acrylic acid anhydride, trichloroacetic acid anhydride, trifluoroacetic acid anhydride, tetrahydrophthalic acid anhydride, succinic acid anhydride, maleic acid anhydride, itaconic acid anhydride, and glutamic acid anhydride; and aromatic carboxylic acid anhydrides such as benzoic acid anhydride, phthalic acid anhydride, 4-methylphthalic acid anhydride, trimellitic acid anhydride, pyromellitic acid anhydride, naphthalic acid anhydride, and 4,4'-biphthalic acid anhydride.

Examples of the commercial product of the carboxylic acid anhydride include RIKACID MH, RIKACID HNA-100, RIKACID OSA, and RIKACID DDSA (manufactured by New Japan Chemical Co., Ltd.).

The content of the carboxylic acid anhydride is 0.30% to 10.0% by mass and preferably 0.50% to 8.0% by mass with respect to the total solid content of the composition.

In the present specification, the "solid content" of the composition refers to components that form a cured film and refers to all components except a solvent in a case where the composition contains the solvent (an organic solvent, water, or the like). In addition, in a case where the components are components forming a cured film, the components are considered to be solid contents even in a case where the components are liquid components.

The composition may contain only one kind of carboxylic acid anhydride or may contain two or more kinds thereof. In a case where two or more kinds thereof are contained, the total amount thereof is preferably within the above-described range.

[Black pigment]

The composition according to the embodiment of the present invention contains a black pigment.

In the present specification, the black pigment means a pigment which has an absorption over the entire wavelength range of 400 to 700 nm.

More specifically, for example, a black pigment, which conforms to an evaluation standard Z described below, is preferable.

First, a composition, which contains a black pigment, a transparent resin matrix (acrylic resin or the like), and a solvent, and in which the content of the black pigment with respect to the total solid content is 60% by mass, is prepared. A cured film is formed by applying the obtained composition onto a glass substrate so that the film thickness of the cured film after drying is 1 μm. The light shielding properties of the cured film after drying are evaluated using a spectrophotometer (UV-3600 manufactured by Shimadzu Corporation, or the like). In a case where the maximum value of the light transmittance of the cured film after drying is less than 10% at wavelengths of 400 to 700 nm, the coloring material can be determined to be a black colorant conforming to the evaluation standard Z. Regarding the black colorant, in the evaluation standard Z, the maximum value of the light transmittance of the cured film after drying is more preferably less than 8% and still more preferably less than 5%, at wavelengths of 400 to 700 nm.

For the black pigment, a plurality of pigments, each of which cannot be used by itself as a black pigment, may be combined and adjusted to be black as a whole, thereby being used as a black pigment.

For example, a combination of a plurality of pigments, each of which has a color other than the black color, may be used by itself as a black pigment.

The black pigment contained in the composition according to the embodiment of the present invention has an average particle diameter of 250 nm or less, preferably 200 nm or less, and more preferably 150 nm or less. From the viewpoint that the handleability is more excellent, the average particle diameter is preferably 1 nm or more, more preferably 5 nm or more, and still more preferably 20 nm or more.

The average particle diameter is calculated according to the following method.

The composition according to the embodiment of the present invention is diluted with propylene glycol monomethyl ether acetate (PGMEA) to prepare a measurement solution having a concentration of solid contents of 0.2% by mass. Next, using a dynamic light scattering type particle size distribution measuring device (LB-500 (product name) manufactured by HORIBA, Ltd.) according to JIS8826: 2005, the data of the measurement solution is taken 50 times using a 2 ml quartz cell for measurement at a temperature of 25°C, and the obtained number-based particle diameters are arithmetically averaged to obtain an average particle diameter.

It is noted that, in the above description, although the measurement solution was prepared using the composition according to the embodiment of the present invention, the measurement may be carried out using a coloring material

dispersion liquid in which a black pigment is dispersed. For example, in a case where the composition according to the embodiment of the present invention contains particles other than the black pigment, the average particle diameter of the black pigment may be measured using a coloring material dispersion liquid in which the black pigment to be used in the preparation of the composition according to the embodiment of the present invention has been dispersed. In a case where the composition according to the embodiment of the present invention contains particles other than the black pigment, the average particle diameter of the black pigment may be measured after separating the black pigment and the other particles from each other by any method.

The black pigment is preferably a pigment that exhibits black color by itself. In addition, a black pigment that exhibits black color by itself and absorbs infrared rays may be used.

Here, the black pigment which absorbs infrared rays has an absorption in a wavelength range of an infrared range (preferably, a wavelength of 650 to 1,300 nm). A black pigment having a maximal absorption wavelength in a wavelength range of wavelengths of 675 to 900 nm is also preferable.

As the black pigment, various known black pigments can be used as long as the particle diameter is within a predetermined range. The black pigment may be an inorganic pigment or an organic pigment.

As the black pigment, from the viewpoint that the light resistance of the light shielding film is superior, an inorganic pigment is preferable.

Among the above, the black pigment is preferably one or more selected from the group consisting of titanium black, carbon black, and a bisbenzofuranone compound.

<Inorganic pigment>

The inorganic pigment that is used as the black pigment is not particularly limited as long as the inorganic pigment has light shielding properties and is a particle containing an inorganic compound, and a known inorganic pigment can be used.

From the viewpoint that the low reflection properties and the light shielding properties of the light shielding film are superior, an inorganic pigment is preferable as the black colorant.

Examples of the inorganic pigment include a metal oxide, a metal nitride, and a metal oxynitride which contain a metal element of group 4 such as titanium (Ti) and zirconium (Zr), a metal element of group 5 such as vanadium (V) and niobium (Nb), or one or more metal elements selected from the group consisting of yttrium (Y), aluminum (Al), cobalt (Co), chromium (Cr), copper (Cu), manganese (Mn), ruthenium (Ru), iron (Fe), nickel (Ni), tin (Sn), and silver (Ag).

Among the above, a metal oxide, a metal nitride, or a metal oxynitride, which contains one or two or more metal elements selected from the group consisting of titanium (Ti), zirconium (Zr), vanadium (V), yttrium (Y), aluminum (Al), and iron (Fe), is preferable. That is, the inorganic pigment may contain two or more kinds of metal atoms.

As the metal oxide, the metal nitride, and the metal oxynitride, particles in which other metal atoms are further mixed may be used. For those described above, for example, metal nitride-containing particles, which further contain an atom (preferably, an oxygen atom and/or a sulfur atom) selected from elements of groups 13 to 17 of the periodic table, can be used.

In addition, the metal oxide, the metal nitride, and the metal oxynitride may be coated with an inorganic substance and/or an organic substance.

Examples of the inorganic substance include metal atoms contained in the inorganic pigment.

Examples of the organic substance include an organic substance having the hydrophobic group, where a silane compound is preferable.

A production method for the metal nitride, metal oxide, or metal oxynitride is not particularly limited as long as a black pigment having desired physical properties can be obtained, and known production methods such as a gas-phase reaction method can be used. Examples of the gas-phase reaction method include an electric furnace method and a thermal plasma method; however, from the viewpoint that few impurities are mixed in, particle diameters are likely to be uniform, and productivity is high, a thermal plasma method is preferable.

The metal nitride, metal oxide, or metal oxynitride may be subjected to a surface modification treatment. For example, the metal nitride, metal oxide, or metal oxynitride may be subjected to a surface modification treatment with a surface-treating agent having both a silicone group and an alkyl group. Examples of such inorganic particles include "KTP-09" series (manufactured by Shin-Etsu Chemical Co., Ltd.).

Examples of the inorganic pigment include zirconium nitride containing yttrium.

In a case where the composition contains zirconium nitride containing yttrium, it is possible to improve the light shielding properties against visible light while maintaining the i-line light transmittance.

The particle diameter (average primary particle diameter) of the zirconium nitride containing yttrium is preferably 10 to 100 nm from the viewpoint of suppressing a decrease in light shielding properties at a wavelength of 550 nm (visible light). The average primary particle diameter of the zirconium nitride powder containing yttrium can be measured by spherical conversion from the measured value of the specific surface area.

It is noted that yttrium is contained in a solid solution state in the zirconium nitride powder.

In a spectral transmission spectrum in a case where the concentration of the zirconium nitride powder containing yttrium is 50 ppm in a dispersion liquid, X1 is preferably 7.5% or less and more preferably 6.5% or less, where the light transmittance at a wavelength of 550 nm is denoted as X1 and the light transmittance at a wavelength of 365 nm is denoted as X2. X2 is preferably 25% or more and more preferably 26% or more.

The ratio of X2 to X1 (X2/X1) is preferably 3.5 or more and more preferably 4.0 or more.

The content of yttrium is preferably 1.0% to 12.0% by mass and more preferably 2.0% to 11.0% by mass with respect to the total mass of the zirconium nitride and the yttrium from the viewpoint of suppressing a decrease in light shielding properties at a wavelength of 550 nm (visible light). The content can be measured according to the ICP emission spectroscopic analysis method.

Examples of the zirconium nitride containing yttrium and the production method therefor include those described in JP2020-180036A, the contents of which are incorporated in the present specification, the contents of which are incorporated in the present specification.

Examples of the inorganic pigment also include zirconium nitride containing aluminum.

The zirconium containing aluminum is preferably zirconium nitride coated with alumina. In a case where the zirconium nitride is coated with alumina, moisture resistance is improved.

The volume resistivity of the zirconium nitride coated with alumina is preferably $1 \times 10^6\ \Omega \cdot cm$ or more and more preferably $1 \times 10^7\ \Omega \cdot cm$ or more.

The volume resistivity of the zirconium nitride coated with alumina can be determined as follows.

Zirconium nitride coated with alumina is placed in a pressure container and compressed at 5 to 10 MPa to be formed into a green compact, and the resistance value of this green compact is measured with a digital multimeter. Then, the obtained resistance value is multiplied by the thickness of the green compact, the device shape, and the resistivity correction factor (RCF) referred to based on the thickness of the green compact, whereby the volume resistivity ($\Omega \cdot cm$) of the green compact is obtained.

The coating amount of alumina is preferably 1.5% to 9% by mass and more preferably 3% to 7% by mass with respect to 100% by mass of zirconium nitride.

The isoelectric point of the zirconium nitride coated with alumina is preferably 5.7 or more and more preferably 5.8 or more.

"The isoelectric point of the zirconium nitride coated with alumina" means a pH at which the charge per one molecule is zero as a whole in a case where a pH of a dispersion liquid in which the zirconium nitride coated with alumina is dispersed is changed, and the powder does not move even in a case where a voltage is applied to the dispersion liquid.

In other words, an inorganic nitride powder such as a zirconium nitride powder has an isoelectric point at which the zeta potential changes significantly in a case where the pH changes, the surface potential (zeta potential) becomes zero at a specific pH, and electrophoresis does not occur at all. It is noted that the "zeta potential" means a potential of a sliding surface on which liquid flow begins to occur in an electrical double layer which is an electrical double structure formed by attracting, in a dispersion liquid, ions having a charge of opposite polarity around a powder having a charge of a certain polarity. This zeta potential is measured as follows by using, for example, a zeta potential meter (model: DT1202) manufactured by Dispersion Technology Inc. This device carries out measuring using the colloidal vibration current method. The dispersion liquid is placed in a container and sandwiched between a pair of electrodes, and a predetermined voltage is applied to these electrodes, whereby the powder in the dispersion liquid moves. As a result, the polarization between the charged particle and the counter ion in the vicinity of the charged particle occurs, and an electric field called a colloidal vibration potential is generated, which can be detected as a current. This current becomes a colloidal vibration current. From the measured colloidal vibration current, the zeta potential can be determined using the Smoluchowski equation and the total connection theory. Here, a pH at which the zeta potential becomes zero is the isoelectric point of the powder.

The L* value of the zirconium nitride coated with alumina is preferably 13 or less.

"The L* value of the zirconium nitride coated with alumina" is a brightness index in the CIE 1976 L*a*b* color space (measurement light source C: color temperature, 6,774 K).

The CIE 1976 L*a*b* color space is a color space determined by the International Lighting Commission (CIE) by converting the CIEXYZ color system in 1976 so that a certain distance in the color system has a difference almost perceptually equivalent in any color region. In addition, the brightness indices L* value, a* value, and b* value are quantities determined in the rectangular coordinate system in the CIE 1976 L*a*b* color space and are represented by Expressions (1) to (3), respectively.

$$L^* = 116\,(Y/Y_0)^{1/3} - 16 \qquad (1)$$

$$a^* = 500[(X/X_0)^{1/3} - (Y/Y_0)^{1/3}] \qquad (2)$$

$$b^* = 200[(Y/Y_0)^{1/3} - (Z/Z_0)^{1/3}] \qquad (3)$$

However, each of $X/X_0$, $Y/Y_0$, and $Z/Z_0$ is more than 0.008856, where X, Y, and Z are tristimulus values of the object color. In addition, $X_0$, $Y_0$, and $Z_0$ are tristimulus values of the light source that illuminates the object color, and they are standardized to $Y_0 = 100$. In addition, the brightness index L* value of the zirconium nitride coated with alumina is determined using, for example, a spectral color difference meter (model: SE7700) manufactured by NIPPON DENSHOKU INDUSTRIES Co., Ltd. In a case where the L* value is 13 or less, the degree of blackness is satisfied, and a predetermined color tone is obtained as a color tone for the black pigment.

The BET specific surface area of the zirconium nitride coated with alumina is preferably 20 $m^2/g$ or more. The upper limit thereof is preferably 1,000 $m^2/g$ or less.

The BET specific surface area is determined by using, for example, a specific surface area measuring device (model: SA1100) manufactured by SIBATA SCIENTIFIC TECHNOLOGY LTD., adsorbing, on the surface of the powder (black pigment), a gas molecule (for example, a nitrogen gas or the like) of which the adsorption-occupied area is known, and obtaining the adsorption amount thereof. However, the BET expression (an expression showing a relationship between the adsorption equilibrium pressure and the adsorption amount at this pressure in a state of adsorption equilibrium at a constant temperature) is applied in response to the information on the process in which the gas molecules adsorbed on the surface of the zirconium nitride coated with alumina shift from the adsorption on the first layer to the adsorption on multiple layers, whereby the amount of gas molecules in only one layer is measured, which makes it possible to measure an accurate specific surface area. In a case where the BET specific surface area is 20 $m^2/g$ or more, it is possible to suppress a decrease in coloring power (color developing power).

Examples of the zirconium nitride coated with alumina and the production method therefor include those described in JP2020-158377A, the contents of which are incorporated in the present specification.

Among the above, a nitride or oxynitride of one or more metals selected from the group consisting of titanium, vanadium, zirconium, niobium, and iron is more preferable, and a nitride or oxynitride of zirconium or a nitride or oxynitride (titanium black) of titanium is still more preferable, from the viewpoint that the occurrence of undercut in a case of forming the light shielding film can be suppressed.

The titanium black is black particles containing titanium oxynitride.

As necessary, the surface of the titanium black can be modified, for example, according to the purpose of improving dispersibility or suppressing aggregating properties. The titanium black can be coated with silicon oxide, titanium oxide, germanium oxide, aluminum oxide, magnesium oxide, or zirconium oxide, and can also be treated with a water-repellent substance as described in JP2007-302836A.

Examples of the production method for the titanium black include a method (JP1974-05432A (JP-S49-05432A)) for heating and reducing a mixture of titanium dioxide and titanium metal in a reduction atmosphere, a method (JP1982-205322A (JP-S57-205322A)) for reducing ultrafine titanium dioxide obtained by hydrolyzing titanium tetrachloride at a high temperature in a reduction atmosphere containing hydrogen, a method (JP1985-065069A (JP-S60-065069A) and JP1986-201610A (JP-S61-201610A)) for reducing titanium dioxide or titanium hydroxide at a high temperature in the presence of ammonia, and a method (JP1986-201610A (JP-S61-201610A)) for attaching a vanadium compound to titanium dioxide or titanium hydroxide, and reducing the resultant at a high temperature in the presence of ammonia.

The particle diameter of the titanium black is not particularly limited; however, it is preferably 10 to 45 nm and more preferably 12 to 20 nm. The specific surface area of the titanium black is not particularly limited. However, in order for the water repellency after a surface treatment with a water repelling agent to have a predetermined performance, a value measured according to the Brunauer-Emmett-Teller (BET) method is preferably 5 to 150 $m^2/g$ and more preferably 20 to 100 $m^2/g$.

Examples of the titanium black include TITANIUM BLACK 10S, 12S, 13R, 13M, 13M-C, 13R, 13R-N, and 13M-T (product names, manufactured by Mitsubishi Materials Corporation), Tilack D (product name, manufactured by AKO KASEI CO., LTD.), and MT-150A (product name, manufactured by TAYCA).

It is also preferable that the composition contains titanium black in a form of a substance to be dispersed containing titanium black and a Si atom. In this form, the titanium black is contained as a substance to be dispersed in the composition. A content ratio (Si/Ti) of a Si atom to a Ti atom in the substance to be dispersed is preferably 0.05 to 0.5 and more preferably 0.07 to 0.4, in terms of mass. Here, the substance to be dispersed includes both titanium black which is in a state of primary particles and titanium black which is in a state of an aggregate (secondary particles).

In addition, in a case where the Si/Ti of the substance to be dispersed is equal to or larger than a predetermined value, residues are less likely to remain in a removal part in a case where a composition layer using the substance to

be dispersed is patterned by optical lithography or the like, and in a case where the Si/Ti of the substance to be dispersed is equal to or smaller than a predetermined value, a light shielding ability is likely to be favorable.

In order to change the Si/Ti of the substance to be dispersed (for example, to be equal to or greater than 0.05), the following means can be used. First, a dispersion is obtained by dispersing titanium oxide and silica particles using a disperser, this mixture is subjected to a reduction treatment at a high temperature (for example, 850°C to 1,000°C), and thus a substance to be dispersed, which has titanium black particles as a main component and contains Si and Ti, can be obtained. The titanium black having the adjusted Si/Ti can be produced, for example, according to the method described in paragraphs [0005] and [0016] to [0021] of JP2008-266045A.

It is noted that the content ratio (Si/Ti) of the Si atom to the Ti atom in the substance to be dispersed can be measured, for example, by using the method (2-1) or method (2-3) described in paragraphs [0054] to [0056] of WO2011/049090A.

In the substance to be dispersed containing titanium black and a Si atom, the aforementioned titanium black can be used as the titanium black. In addition, in this substance to be dispersed, for the intended purpose of adjusting dispersibility, colorability, or the like, one black pigment, which consists of a complex oxide of a plurality of metals selected from Cu, Fe, Mn, V, Ni, and the like, cobalt oxide, iron oxide, carbon black, aniline black, and the like, or a combination of two or more black pigments may be used as a substance to be dispersed in combination with the titanium black. In this case, it is preferable that a substance to be dispersed consisting of titanium black accounts for equal to or more than 50% by mass of the total substance to be dispersed.

As the inorganic pigment, carbon black is also mentioned.

Examples of the carbon black include furnace black, channel black, thermal black, acetylene black, and lamp black.

As the carbon black, carbon black produced by known methods such as an oil furnace method may be used, or a commercial product may be used.

Specific examples of the commercial product of the carbon black include an inorganic pigment such as C. I. Pigment Black 7.

As the carbon black, carbon black subjected to a surface treatment is preferable. The surface treatment can reform a particle surface state of the carbon black and improve dispersion stability in the composition. Examples of the surface treatment include a coating treatment with a resin, a surface treatment for introducing an acidic group, and a surface treatment with a silane coupling agent.

As the carbon black, carbon black subjected to a coating treatment with a resin is preferable. The light shielding properties and the insulating properties of the light shielding film can be improved by coating a particle surface of carbon black with an insulating resin. In addition, the reliability or the like of an image display device can be improved by reducing a leakage current or the like. Therefore, the aforementioned carbon black is suitable for a case where a light shielding film is used in a use application which requires insulating properties.

Examples of the coating resin include an epoxy resin, polyamide, polyamideimide, a novolak resin, a phenol resin, a urea resin, a melamine resin, polyurethane, a diallyl phthalate resin, an alkylbenzene resin, polystyrene, polycarbonate, polybutylene terephthalate, and modified polyphenylene oxide.

From the viewpoint that the light shielding properties and the insulating properties of the light shielding film are superior, a content of the coating resin is preferably 0.1% to 40% by mass and more preferably 0.5% to 30% by mass, with respect to the total of the carbon black and the coating resin.

The crystallite size of the inorganic pigment is preferably 10 nm or more and more preferably 20 nm or more. The upper limit thereof is preferably 60 nm or less, more preferably 50 nm or less, and still more preferably 40 nm or less.

In a case of setting the crystallite size of the inorganic pigment in the above-described range, the transmitted light of the colored film exhibits such a bluish purple color that the peak wavelength thereof is 400 nm or less, and the light transmittance in the ultraviolet region can be improved. Since the transmittance in the ultraviolet region (particularly, the i-line (365 nm)) is more excellent than that of the light shielding material in the related art, photocuring or photolysis sufficiently proceeds to the bottom part of the film, and the sensitivity can be improved.

In a case where the crystallite size is 10 nm or more, the particle surface is less likely to be oxidized, and a decrease in light shielding properties is suppressed. In a case where the crystallite size is 60 nm or less, a shift of the transmission peak to a long wavelength in a case of being formed into a colored film is suppressed, a decrease in light transmittance in an ultraviolet region is suppressed, and at the same time, a decrease in light shielding properties in a visible light range is suppressed.

The crystallite size can be determined, for example, by the following method.

It can be calculated from the half-width of the X-ray diffraction peak derived from the (111) plane in the X-ray diffraction spectrum in a case where a CuK$\alpha$ ray is used as an X-ray source.

For example, in an X-ray diffraction spectrum of a zirconia compound particle containing zirconium nitride, zirconium oxide, and/or zirconium oxynitride, where a CuK$\alpha$ ray is used as an X-ray source, in a case of zirconium nitride, a peak derived from the (111) plane is observed in the vicinity of the diffraction angle $2\theta$ = 33.5 to 34.0°. In a

case of zirconium oxide, a peak derived from the (011) plane is observed in the vicinity of the diffraction angle 2θ = 30.3°, and a peak derived from the (-111) plane is observed in the vicinity of the diffraction angle 2θ = 28.2°. In a case of zirconium oxynitride, a peak derived from the (211) plane is observed in the vicinity of the diffraction angle 2θ = 33.4°. Then, from the half-widths of these X-ray diffraction peaks, the crystallite size can be calculated according to the Scherrer equation represented by Expression (4).

$$\text{Crystallite size (nm)} = K\lambda/\beta\cos\theta \quad (4)$$

$$\beta = \sqrt{(\beta_e^2 - \beta_o^2)} \quad (5)$$

In Expression (4), K represents a constant of 0.9. λ represents 0.15406 nm. β is a value represented by Expression (5). θ is as described above. In Expression (5), $\beta_e$ represents the half-width of the diffraction peak. $\beta_o$ represents a correction value (0.12°) of the half-width. However, β, $\beta_e$, and $\beta_o$ are calculated in terms of radians.

The X-ray diffraction spectrum is measured according to a wide-angle X-ray diffraction method using a CuKα ray as an X-ray source.

As the X-ray diffractometer, for example, RU-200R manufactured by Rigaku Corporation can be used. The measurement conditions are set as follows: an output of 50 kV/200 mA, a slit system of 1°-1°-0.15 mm-0.45 mm, a measurement step (2θ) of 0.02°, and a scanning speed of 2 °/min.

In addition, examples of the value of the X-ray diffraction peak include those in paragraphs [0027] and [0028] of JP2009-091205A, the contents of which are incorporated in the present specification.

Examples of the method of setting the crystallite size within the above-described range include a method of adjusting crystal growth conditions in a case of synthesizing particles according to a gas phase reaction. For example, in the thermal plasma method, the crystallite size can be easily adjusted within the above-described range by adjusting the cooling time and the cooling rate after the particles are vaporized.

Examples of the inorganic pigment that is used as the black colorant include zirconium of JP2017-222559A, WO2019/130772, WO2019/059359, and JP2009-091205A, the contents of which are incorporated in the present specification.

<Organic pigment>

The organic pigment that is used as the black pigment is not particularly limited as long as the organic pigment has light shielding properties and is a particle containing an organic compound, and a known organic pigment can be used.

In the present invention, examples of the organic pigment include a bisbenzofuranone compound, an azomethine compound, a perylene compound, and an azo-based compound, and a bisbenzofuranone compound or a perylene compound is preferable.

Examples of the bisbenzofuranone compound include the compounds described in JP2010-534726A, JP2012-515233A, and JP2012-515234A. The bisbenzofuranone compound is available as "Irgaphor Black" (product name) manufactured by BASF SE.

Examples of the perylene compound include the compounds described in JP1987-001753A (JP-S62-001753A) and JP1988-026784B (JP-S63-026784B). The perylene compound is available as C. I. Pigment Black 21, 30, 31, 32, 33, and 34.

The content of the black pigment is preferably 10% to 90% by mass, more preferably 25% to 80% by mass, and still more preferably 45% to 70% by mass, with respect to the total solid content of the composition.

The composition may contain only one kind of black pigment or may contain two or more kinds thereof. In a case where two or more kinds thereof are contained, the total amount thereof is preferably within the above-described range.

<Inorganic particle and modified inorganic particle>

The composition according to the embodiment of the present invention may contain inorganic particles or modified inorganic particles.

The inorganic particles are particles different from the black pigment described above.

The modified inorganic particles have inorganic particles that are different from the black pigment, and a coating layer that coats at least a part of the inorganic particles. That is, the modified inorganic particles are inorganic particles having a coating layer on the surface thereof.

From the viewpoint of excellent balance between the performance and handleability of the cured film, the

particle diameter of the inorganic particles is preferably 200 nm or less, more preferably less than 100 nm, still more preferably 10 to 90 nm, particularly preferably 20 to 80 nm, and most preferably 30 to 70 nm,

It is noted that the "particle diameter" means an average primary particle diameter of particles measured according to the following method. The average primary particle diameter can be measured using a transmission electron microscope (TEM). As the transmission electron microscope, it is possible to use, for example, a transmission microscope HT7700 manufactured by Hitachi High-Tech Corporation.

A maximum length (Dmax: a maximum length between two points on a contour of the particle image) and a length vertical to the maximum length (DV-max: in a case where an image is sandwiched between two straight lines parallel to the maximum length, the shortest length that vertically connects the two straight lines) of a particle image obtained using the transmission electron microscope were measured, and a geometric mean value thereof $(Dmax \times DV\text{-}max)^{1/2}$ was taken as a particle diameter. Particle diameters of 100 particles were measured by this method, and an arithmetic average value thereof was taken as an average primary particle diameter of particles.

Examples of the shape of the inorganic particle include a fibrous shape, a needle shape, a plate shape, a spherical shape, a tetrapod shape, and a balloon shape, where a spherical shape is preferable.

The form of the inorganic particle may be a monodisperse particle or an aggregated particle.

The inorganic particle may be a hollow particle or a solid particle.

The hollow particles refer to particles in which a cavity is present inside the particle. The hollow particles may have a structure in which particles consist of an inner cavity and an outer shell surrounding the cavity. In addition, the hollow particles may have a structure in which a plurality of cavities are present inside the particle.

The void ratio of the hollow particle is preferably 3% or more. The upper limit thereof is not particularly limited; however, it is preferably less than 100% and more preferably 90% or less.

Examples of the hollow particles include the hollow silica particle described in JP2001-233611A and JP3272111B, and THRULYA 4110 (product name, manufactured by JGC Catalysts and Chemicals Ltd.).

The solid particles refer to particles in which a cavity is not substantially present inside the particle.

Specifically, the void ratio of the solid particle is preferably less than 3%.

Examples of the solid particle include IPA-ST-L (product name, manufactured by Nissan Chemical Corporation).

The form of the inorganic particles may be a particle aggregate in which a plurality of inorganic particles are connected in a chain shape (hereinafter, also referred to as rosary-shaped inorganic particles). As the rosary-shaped inorganic particles, particles in which a plurality of spherical colloidal inorganic particles having a particle diameter of 5 to 50 nm are bonded to each other by metal oxide-containing inorganic particles are preferable.

Examples of the rosary-shaped inorganic particles include the silica sols described in JP4328935B and JP2013-253145A, where rosary-shaped colloidal inorganic particles are preferable.

The inorganic particle preferably has a color other than black. The inorganic particle may have a color such as red, blue, yellow, green, purple, orange, or white, or may have no color. Among them, it is preferable that the inorganic particles are white or have no color.

Examples of the material constituting inorganic particles include an inorganic oxide, an inorganic nitride, an inorganic carbide, carbonate, sulfate, silicate, phosphate, and a composite of two or more thereof, where an inorganic oxide, an inorganic nitride, or carbonate is preferable, and an inorganic oxide is more preferable. It is noted that the inorganic particles preferably contain at least silicon.

Examples of the material constituting inorganic particles include silica (silicon dioxide), titania (titanium dioxide), alumina (aluminum oxide), a mica compound, zinc oxide, zircon oxide, tin oxide, potassium titanate, strontium titanate, aluminum borate, magnesium oxide, magnesium borate, aluminum hydroxide, magnesium hydroxide, calcium hydroxide, titanium hydroxide, basic magnesium sulfate, calcium carbonate, magnesium carbonate, calcium sulfate, magnesium sulfate, calcium silicate, magnesium silicate, calcium phosphate, silicon nitride, titanium nitride, aluminum nitride, silicon carbide, titanium carbide, and zinc sulfide.

Among them, inorganic particles containing at least one selected from the group consisting of silica, titania, alumina, a mica compound, glass, potassium titanate, strontium titanate, aluminum borate, magnesium oxide, calcium carbonate, magnesium carbonate, calcium silicate, magnesium silicate, calcium phosphate, and calcium sulfate are preferable, inorganic particles containing at least one selected from the group consisting of silica, titania, alumina, and calcium carbonate are more preferable, inorganic particles containing at least one selected from the group consisting of silica, titania, and alumina are still more preferable, and inorganic particles containing silica are particularly preferable.

The refractive index of the inorganic particles is preferably 1.10 to 1.40 and more preferably 1.15 to 1.35.

The inorganic particles may be used alone or in a combination of two or more thereof.

In a case where the inorganic particles contain silica (silicon dioxide), the content of silica (silicon dioxide) is preferably 75% to 100% by mass, more preferably 90% to 100% by mass, and still more preferably 99% to 100% by mass, with respect to the total mass of the inorganic particles.

The modified inorganic particles have a coating layer that coats at least a part of the inorganic particles.

In other words, the coating layer is a layer that coats a part or all of the inorganic particles. That is, in the coating

of the inorganic particles with the coating layer, the entire surface of the inorganic particles may be coated, or only a part of the inorganic particles may be coated. The coverage of the inorganic particles with the coating layer is preferably 10% or more, more preferably 30% or more, and still more preferably 50% or more, with respect to the total surface area of the inorganic particles. The upper limit thereof is preferably 100% or less and more preferably 80% or less with respect to the total surface area of the inorganic particles.

The coating layer may be disposed directly on the surface of the inorganic particle or may be disposed with another layer being interposed between the coating layer and the inorganic particle.

The coating layer may have a substituent, and examples of the substituent include a hydrophobic group and a substituent other than the hydrophobic group.

The hydrophobic group is not particularly limited as long as it is a hydrophobic group.

Examples of the hydrophobic group include a group containing a silicon atom, a group containing a fluorine atom, an alkyl group which may contain a substituent, and an aryl group which may contain a substituent.

Among them, the hydrophobic group preferably contains at least one selected from the group consisting of a fluorine atom and a silicon atom, and it more preferably contains a silicon atom.

The group containing a silicon atom is preferably a siloxane group or a silyl group, more preferably a siloxane group, and still more preferably a dialkylsiloxane group. The group containing a silicon atom may be either chain-like, branched, or cyclic.

The group containing a fluorine atom is preferably a fluoroalkyl group and more preferably a perfluoroalkyl group. The group containing a fluorine atom may be either chain-like, branched, or cyclic.

It is noted that in a case where a silane coupling agent is used for producing the modified inorganic particles, the silicon atom does not include a silicon atom derived from a hydrolyzable silyl group directly bonded to the inorganic particles.

For example, even in a case where a trimethoxysilyl group of 3-methacryloxypropyltrimethoxysilane is reacted with silica to produce a modified silica having a methacryloyl group, a silicon atom derived from the trimethoxysilyl group which has reacted with the silica does not correspond to the silicon atom contained in the coating layer.

The hydrophobic group is preferably a group contained in a repeating unit represented by Formula (A1) described later (preferably a group represented by $S^{S1}$ in Formula (A1)). In other words, the coating layer preferably contains a polymer containing a repeating unit represented by Formula (A1).

The coating layer may contain the polymer as a part, or the coating layer may be the polymer itself. The content of the polymer is preferably 10% to 100% by mass, more preferably 70% to 100% by mass, and still more preferably 95% to 100% by mass, with respect to a total mass of the coating layer.

The repeating unit, which is contained in the polymer and represented by Formula (A1), is shown below.

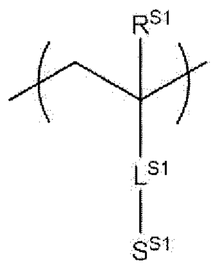

(A1)

In Formula (A1), $R^{S1}$ represents an alkyl group which may have a substituent, or a hydrogen atom,

The alkyl group may be either linear or branched. In addition, the alkyl group may have a cyclic structure as a whole or may partially have a cyclic structure.

The number of carbon atoms in the alkyl group is preferably 1 to 10 and more preferably 1 to 3. In a case where the alkyl group has a substituent, the preferred number of carbon atoms mentioned here is intended to indicate the number of carbon atoms which also includes the number of carbon atoms that can be present in the substituent.

Among them, $R^{S1}$ is preferably a hydrogen atom or a methyl group.

In Formula (A1), $L^{S1}$ represents a single bond or a divalent linking group.

Examples of the divalent linking group include an ether group (-O-), a carbonyl group (-CO-), an ester group (-COO-), a thioether group (-S-), $-SO_2-$, $-NR^N-$ ($R^N$ represents a hydrogen atom or an alkyl group), a divalent hydrocarbon group (an alkylene group, an alkenylene group (for example, -CH=CH-), or an alkynylene group (for example, -C=C- or the like), or an arylene group), $-SiR^{SX}{}_2-$ ($R^{SX}$ represents a hydrogen atom or a substituent), and a group obtained by combining these groups.

The divalent linking group may have a substituent, if possible, and the substituent of the divalent linking group may be a group represented by $S^{S1}$, which will be described later, or may be a group partially having a group represented

by $S^{S1}$, which will be described later.

Among them, the divalent linking group is preferably a group obtained by combining groups selected from the group consisting of an ester group and an alkylene group (preferably an alkylene group having 1 to 10 carbon atoms).

Among them, the divalent linking group is preferably a group represented by *A-CO-O-*B or *A-CO-O-alkylene group-*B.

*B represents a bonding position to $S^{S1}$ in Formula (A1), and *A represents a bonding position on a side opposite to *B.

The alkylene group may be either linear or branched. In addition, the alkylene group may have a cyclic structure as a whole or may partially have a cyclic structure. The alkylene group is preferably linear.

The number of carbon atoms in the alkylene group is preferably 1 to 10 and more preferably 1 to 3. In a case where the alkylene group has a substituent, the preferred number of carbon atoms mentioned here is intended to indicate the number of carbon atoms which also includes the number of carbon atoms that can be present in the substituent. It is preferable that the alkylene group is unsubstituted.

$S^{S1}$ represents a hydrophobic group.

The hydrophobic group preferably contains a silicon atom or a fluorine atom.

The hydrophobic group is preferably an unsubstituted alkyl group, a fluoroalkyl group, or a group represented by Formula (SS1) described later, more preferably a fluoroalkyl group or a group represented by Formula (SS1) described later, and still more preferably a dialkylsiloxane group or a fluoroalkyl group.

The unsubstituted alkyl group represented by $S^{S1}$ may be either linear or branched. In addition, the unsubstituted alkyl group may have a cyclic structure as a whole or may partially have a cyclic structure.

The number of carbon atoms in the unsubstituted alkyl group is preferably 1 to 10 and more preferably 1 to 5.

The alkyl group moiety in the fluoroalkyl group represented by $S^{S1}$ may be linear or branched. In addition, the alkyl group moiety may have a cyclic structure as a whole or may partially have a cyclic structure.

The number of carbon atoms in the alkyl group moiety is preferably 1 to 15 and more preferably 1 to 10.

It is also preferable that the alkyl group moiety does not have a substituent other than a fluorine atom.

The number of fluorine atoms contained in the fluoroalkyl group is preferably 1 to 30 and more preferably 5 to 20.

It is also preferable that the whole or a part of the fluoroalkyl group is a perfluoroalkyl group.

$S^{S1}$ is preferably a group represented by Formula (SS1).

$$*\text{-}L^{S2}\text{-O-Si}R^{S2}_3 \qquad (SS1)$$

In Formula (SS1), $R^{S2}$ represents a hydrocarbon group which may have a substituent and has 1 to 20 carbon atoms. * represents a bonding position.

The hydrocarbon group preferably has 1 to 20 carbon atoms, more preferably has 1 to 10 carbon atoms, and still more preferably has 1 to 5 carbon atoms. In a case where the hydrocarbon group has a substituent, the number of carbon atoms mentioned here is intended to indicate the number of carbon atoms which also includes the number of carbon atoms that can be present in the substituent.

The hydrocarbon group is preferably an alkyl group.

The alkyl group may be either linear or branched. In addition, the alkyl group may have a cyclic structure as a whole or may partially have a cyclic structure.

A plurality of $R^{S2}$'s may be the same as or different from each other.

$L^{S2}$ represents a single bond or a divalent linking group.

Examples of the divalent linking group as $L^{S2}$ include the groups exemplified as the divalent linking group as $L^{S1}$ in Formula (A1).

In addition, the divalent linking group for $L^{S2}$ may contain one or more (for example, one to 1,000) $-SiR^{S2}_2-O-$'s. It is noted that $R^{S2}$ in $-SiR^{S2}2-O-$ is the same as the aforementioned $R^{S2}$.

$S^{S1}$ is more preferably a group represented by Formula (A2).

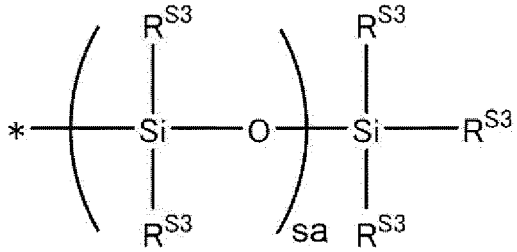

(A2)

In Formula (A2), * represents a bonding position. sa represents an integer of 1 to 1,000. $R^{S3}$'s each independently represents a hydrocarbon group, which may have a substituent and has 1 to 20 carbon atoms, or a group represented by Formula (A3).

In Formula (A2), a plurality of $R^{S3}$'s may be the same or different from each other.

Examples of the hydrocarbon group, which can be represented by $R^{S3}$, include the hydrocarbon group which may have a substituent and can be represented by the aforementioned $R^{S2}$.

Among them, it is preferable that $R^{S3}$'s bonded to rightmost Si in Formula (A2) are each independently the hydrocarbon group.

In a case where sa in Formula (A2) is 1, it is preferable that $R^{S3}$'s in "$-(-SiR^{S3}{}_2-O-)_{sa}-$" are each independently the group represented by Formula (A3).

The number of $R^{S3}$'s, which are groups represented by Formula (A3), among "2 × sa" pieces of $R^{S3}$'s in "$-(-SiR^{S3}{}_2-O-)_{sa}-$" is preferably 0 to 1,000, more preferably 0 to 10, and still more preferably 0 to 2.

The group represented by Formula (A3) is shown below.

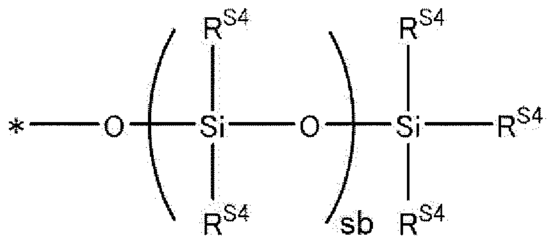

(A3)

In Formula (A3), * represents a bonding position. sb represents an integer of 0 to 300. $R^{S4}$ represents a hydrocarbon group which may have a substituent and has 1 to 20 carbon atoms, and

In Formula (A3), a plurality of $R^{S4}$'s may be the same or different from each other.

Examples of the hydrocarbon group, which can be represented by $R^{S4}$, include the hydrocarbon group which may have a substituent and can be represented by the aforementioned $R^{S2}$.

The polymer containing the repeating unit represented by Formula (A1) may contain another repeating unit other than the repeating unit represented by Formula (A1).

The other repeating unit is preferably a repeating unit derived from (meth)acryl or a repeating unit containing no silicon atom.

The molecular weight of the other repeating unit is preferably 86 to 1,000 and more preferably 100 to 500.

In the polymer contained in the coating layer, the content of the repeating unit represented by Formula (A1) is preferably 10% to 100% by mass, more preferably 60% to 100% by mass, and still more preferably 90% to 100% by mass, with respect to all the repeating units.

The coating layer may have a substituent other than the hydrophobic group. Examples of the substituent other than the hydrophobic group include a carboxylic acid group, a carboxylic acid anhydride group, a (meth)acryloyl group, a styryl group, a vinyl group, an epoxy group, a mercapto group, a ureide group, and an amino group.

Among them, a (meth)acryloyl group, an epoxy group, or a thiol group is preferable from the viewpoint of imparting curing properties, and a carboxylic acid group or a carboxylic acid anhydride group is preferable from the viewpoint of imparting alkali developability.

From the viewpoint that the effect of the present invention is more excellent, the content of the coating layer in the modified inorganic particles is preferably 1% by mass or more, more preferably 3% by mass or more, and still more preferably 5% by mass or more, with respect to the total mass of the modified inorganic particles. The upper limit thereof is preferably 30% by mass or less, more preferably 20% by mass or less, and still more preferably 15% by mass or less, with respect to the total mass of the modified inorganic particles.

The modified inorganic particles may be used alone or in a combination of two or more kinds thereof.

Among the above, it is preferable that one kind of modified inorganic particles is used alone or two kinds thereof are mixedly used.

In a case where two or more kinds of modified inorganic particles are used, the total content thereof is preferably within the above-described range.

The content of the modified inorganic particles with respect to the total solid content of the composition is preferably 0.1% to 30.0% by mass and more preferably 0.5% to 20.0% by mass, and it is still more preferably 1.0% to 20.0% by mass and particularly preferably 2.5% to 16.0% by mass from the viewpoint that the effect of the present invention is more excellent.

The production method for the modified inorganic particles is not particularly limited; however, examples thereof include the following production method.

It includes a production method for modified inorganic particles, which has a step (a coating layer forming step) of reacting inorganic particles with a silane coupling agent containing a hydrophobic group and a silane coupling agent containing a substituent other than the hydrophobic group to form a coating layer on the surface of the inorganic particles, thereby coating the inorganic particles.

It is noted that the modified inorganic particles obtained according to the above-described production method correspond to inorganic particles which have been subjected to surface modification with a silane coupling agent including at least a silane coupling agent containing a hydrophobic group and a silane coupling agent containing a substituent other than the hydrophobic group.

Examples of the silane coupling agent containing a hydrophobic group include a silane coupling agent containing the group represented by $S^{S1}$ in Formula (A1) described above. Specific examples thereof include compounds having the following structural formulae.

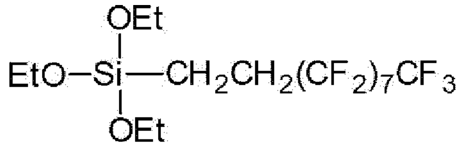

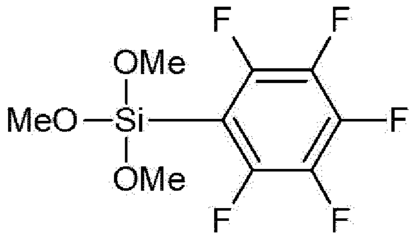

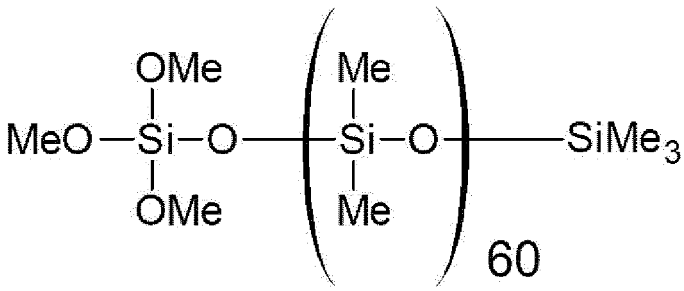

Examples of the commercial product of the silane coupling agent include KR-515 and KP-983 (each of which are manufactured by Shin-Etsu Silicone Co., Ltd.).

Examples of the silane coupling agent containing a substituent other than the hydrophobic group include a silane coupling agent containing a carboxylic acid group, a carboxylic acid anhydride group, a (meth)acryloyl group, a styryl group, a vinyl group, an epoxy group, a mercapto group, a ureide group, or an amino group.

Examples of the compound and commercial product of the silane coupling agent include 3-trimethoxysilylpropyl succinic acid anhydride (for a carboxylic acid anhydride group), 3-methacryloxypropyltrimethoxysilane, 3-acryloxypropyltrimethoxysilane, KBM-5803 and KR-513 (each of which is manufactured by Shin-Etsu Silicone Co., Ltd.) (for a (meth)acryloyl group), p-styryltrimethoxysilane (for a styryl group), vinyltrimethoxysilane (for a vinyl group), 3-glycidoxypropyltrimethoxysilane (for an epoxy group), 3-mercaptopropyltrimethoxysilane (for a mercapto group), 3-ureidopropyltrialkoxysilane (for a ureide group), and 3-aminopropyltrimethoxysilane (for an amino group).

After the coating layer forming step, it is preferable to carry out a purification treatment, in which a part or whole of the uncoated substance not incorporated into the coating layer in the coating layer forming step is separated from the obtained modified inorganic particles. The uncoated substance refers to a raw material remaining without being reacted (in the coating layer forming step B, a silane coupling agent or a hydrolyzate of a silanol moiety thereof) or a polymerization product generated (in the coating layer forming step B, a condensate between silane coupling agents).

The purification treatment is not particularly limited; however, examples thereof include filtration and washing of a filtrate, a centrifugation treatment, a reprecipitation treatment, a liquid separation treatment, an ultrafiltration treatment, and a treatment with an adsorbing material.

(Filtration and washing of filtrate)

Examples of the filtration and washing treatment of the filtrate include a treatment in which a solution obtained by carrying out the coating layer forming step is filtered (preferably, microfiltered) to obtain modified inorganic particles as a filtrate, and the above-described uncoated substance is separated in a liquid. Further, examples thereof include a method of additionally carrying out a step of washing a filtrate with a solvent that easily dissolves the uncoated substance.

(Centrifugation treatment)

Examples of the centrifugation treatment include a treatment in which a solution obtained by carrying out the coating layer forming step is centrifuged to be separated into a supernatant solution containing the uncoated substance and a deposit containing modified inorganic substance particles, and after removing the supernatant solution, a solvent is added to the deposit containing the modified inorganic particles to redisperse the deposit. Examples of the redispersion include a stirring treatment, a beads mill treatment, a paint shaker treatment, and a heating treatment.

(Reprecipitation treatment)

Examples of the reprecipitation treatment include a method of adding a poor solvent for modified inorganic particles to a solution containing the modified inorganic particles to precipitate the modified inorganic particles, and removing the supernatant containing the uncoated substance. In addition, examples thereof include a method of subjecting the modified inorganic particles precipitated by the above method to the filtration and washing treatment of a filtrate described above.

(Liquid separation treatment)

Examples of the liquid separation treatment include a treatment in which a solution obtained by carrying out the coating layer forming step is subjected to a liquid separation treatment to be separated into a solution in which modified inorganic particles are dispersed and a solution in which an uncoated substance is dissolved.

(Ultrafiltration treatment)

Examples of the ultrafiltration treatment include a treatment in which a solution obtained by carrying out the coating layer forming step is subjected to ultrafiltration to separate an uncoated substance. Although the preferred cut-off of molecular weight of the ultrafiltration membrane to be used varies depending on the particle diameter of the particles, it is preferably 50,000 or more and more preferably 100,000 or more.

(Adsorption treatment)

Examples of the adsorption treatment include a treatment in which an adsorbing material having a particle diameter sufficiently larger than that of the modified inorganic particles is added to a solution obtained by carrying out the coating layer forming step to adsorb the uncoated substance, and then the adsorbing material is removed by filtration or the like, whereby the uncoated substance is separated.

In a case where the purification treatment is carried out, the solution obtained by carrying out the coating layer forming step may be subjected to a treatment (for example, the addition of an adequate solvent and/or partial distillation of a solvent) for efficiently carrying out the purification treatment.

In addition, the solvent of the solution obtained by carrying out the coating layer forming step may be evaporated without carrying out the purification treatment, to obtain modified inorganic particles in a state where the polymerization product is attached to the surface.

In the product obtained by the production method for modified inorganic particles and in the purified product obtained by carrying out the purification treatment, the content of the uncoated substance is preferably 50% by mass or less, more preferably 20% by mass or less, still more preferably 10% by mass or less, and most preferably 2% by mass or less, with respect to the mass of the modified inorganic particles from the viewpoint that the effect of the present invention is more excellent. The lower limit thereof is not particularly limited; however, 0% by mass can be mentioned.

[Polymerizable compound]

The composition according to the embodiment of the present invention contains a polymerizable compound.

The "polymerizable compound" in the present specification refers to an organic compound (for example, an

organic compound containing an ethylenically unsaturated group) which can be polymerized by an action of a polymerization initiator, which will be described later, or the like.

In a case where the composition according to the embodiment of the present invention contains a solvent, the polymerizable compound is preferably present in a state of being dissolved in the solvent.

The polymerizable compound is a polymerizable compound having a low molecular weight and is a component different from the resin described below.

The content of the polymerizable compound in the composition is preferably 5% to 60% by mass, more preferably 7% to 30% by mass, and still more preferably 10% to 20% by mass, with respect to the total solid content of the composition.

In addition, the content of the polymerizable compound is preferably 10% to 70% by mass, more preferably 20% to 60% by mass, and still more preferably 25% to 50% by mass, with respect to a total non-colored organic solid content of the composition.

The non-colored organic solid content is a solid content and refers to an organic component having non-colorability. For example, the above-described inorganic particles do not correspond to the organic component and are not included in the non-colored organic solid content.

In addition, a component (an organic pigment or the like), which is used as a coloring material or a colorant even in a case of being an organic component, is a component having colorability, and thus it is not included in the non-colored organic solid content.

Examples of the non-colored organic solid content include a polymerizable compound, a resin which will be described later and does not contain a group (ethylenically unsaturated group or the like) polymerized by the action of the polymerization initiator, a polymerization initiator, a surfactant, and a polymerization inhibitor.

The composition may contain only one kind of polymerizable compound or may contain two or more kinds thereof. In a case where two or more kinds thereof are contained, the total amount thereof is preferably within the above-described range.

The molecular weight (or the weight-average molecular weight in a case of having a molecular weight distribution) of the polymerizable compound is not particularly limited; however, it is preferably 2,500 or less. The lower limit thereof is preferably 100 or more.

The polymerizable compound is preferably a compound containing an ethylenically unsaturated group (a group containing an ethylenically unsaturated bond).

That is, the composition according to the embodiment of the present invention preferably contains, as a polymerizable compound, a low-molecular-weight compound containing an ethylenically unsaturated group.

The polymerizable compound is preferably a compound containing one or more ethylenically unsaturated bonds, more preferably a compound containing two or more ethylenically unsaturated bonds, still more preferably a compound containing three or more ethylenically unsaturated bonds, and particularly preferably a compound containing four or more ethylenically unsaturated bonds. The upper limit of the number of ethylenically unsaturated bonds is, for example, 15 or less. Examples of the ethylenically unsaturated group include a vinyl group, a (meth)allyl group, and a (meth)acryloyl group.

As the polymerizable compound, for example, the compounds described in paragraph [0050] of JP2008-260927A and paragraph [0040] of JP2015-068893A can be used, and the contents are incorporated in the present specification.

The polymerizable compound may have any chemical form such as a monomer, a prepolymer, an oligomer, or a mixture thereof, or a multimer thereof.

The polymerizable compound is preferably a tri- to pentadeca-functional (meth)acrylate compound, and more preferably a tri- to hexa-functional (meth)acrylate compound.

As the polymerizable compound, a compound which contains one or more ethylenically unsaturated groups and has a boiling point equal to or higher than 100°C under normal pressure is also preferable. Reference can be made to, for example, the compounds described in paragraph [0227] of JP2013-029760A and paragraphs [0254] to [0257] of JP2008-292970A, the contents of which are incorporated into the present specification.

The polymerizable compound is preferably any one of the following compounds; dipentaerythritol triacrylate (as a commercial product, for example, KAYARAD D-330; manufactured by Nippon Kayaku Co., Ltd.), dipentaerythritol tetraacrylate (as a commercial product, for example, KAYARAD D-320; manufactured by Nippon Kayaku Co., Ltd.), dipentaerythritol penta(meth)acrylate (as a commercial product, for example, KAYARAD D-310; manufactured by Nippon Kayaku Co., Ltd.), dipentaerythritol hexa(meth)acrylate (as a commercial product, for example, KAYARAD DPHA; manufactured by Nippon Kayaku Co., Ltd., and A-DPH-12E; manufactured by SHIN-NAKAMURA CHEMICAL Co., Ltd.), as well as compounds (for example, SR454 and SR499 commercially available from Sartomer Company Inc.) having a structure in which the (meth)acryloyl group of the above compounds is contained through an ethylene glycol residue or a propylene glycol residue. Oligomer types thereof can also be used. In addition, NK ester A-TMMT (pentaerythritol tetraacrylate, manufactured by SHIN-NAKAMURA CHEMICAL Co., Ltd.), KAYARAD RP-1040, KAYARAD DPEA-12LT, KAYARAD DPHA LT, KAYARAD RP-3060, KAYARAD DPEA-12 (all product names, manufactured by Nippon Kayaku

Co., Ltd.), or the like may be used. In addition, as the polymerizable compound, a urethane (meth)acrylate-based compound, which is a compound having both a (meth)acryloyl group and a urethane bond, may be used, and, for example, KAYARAD DPHA-40H (product name, manufactured by Nippon Kayaku Co., Ltd.) may be used.

The preferred aspects of the polymerizable compound are shown below.

The polymerizable compound may have an acid group such as a carboxylic acid group, a sulfonate group, and a phosphate group. The polymerizable compound containing an acid group is preferably an ester of an aliphatic polyhydroxy compound and an unsaturated carboxylic acid, more preferably a polymerizable compound having an acid group by reacting a nonaromatic carboxylic acid anhydride with an unreacted hydroxyl group of an aliphatic polyhydroxy compound, and still more preferably a compound in which the aliphatic polyhydroxy compound in the ester is pentaerythritol and/or dipentaerythritol. Examples of the commercial product thereof include ARONIX TO-2349, M-305, M-510, and M-520, manufactured by Toagosei Co., Ltd.

The acid value of the polymerizable compound containing an acid group is preferably 0.1 to 40 mg KOH/g and more preferably 5 to 30 mg KOH/g. In a case where the acid value of the polymerizable compound is 0.1 mgKOH/g or more, development dissolution characteristics are favorable, and in a case where the acid value is 40 mgKOH/g or less, the polymerizable compound is advantageous in terms of production and/or handling. Further, excellent photopolymerization performance and excellent curing properties are obtained.

As the polymerizable compound, a compound having a caprolactone structure is also a preferred aspect.

The compound having a caprolactone structure is not particularly limited, for example, as long as the compound has a caprolactone structure in a molecule, but examples thereof include ε-caprolactone-modified polyfunctional (meth)acrylate which is obtained by esterifying polyhydric alcohol such as trimethylolethane, ditrimethylolethane, trimethylolpropane, ditrimethylolpropane, pentaerythritol, dipentaerythritol, tripentaerythritol, glycerin, diglycerol, and trimethylol melamine, (meth)acrylic acid, and ε-caprolactone. Among them, a compound which has a caprolactone structure and is represented by Formula (Z-1) is preferable.

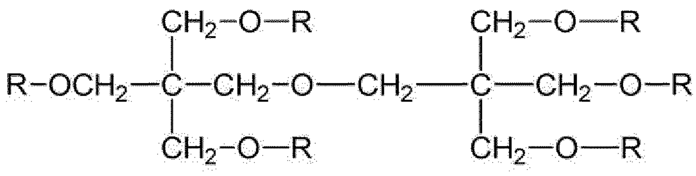

(Z-1)

In Formula (Z-1), all six R's are groups represented by Formula (Z-2), or one to five among the six R's are groups represented by Formula (Z-2), and the others are groups represented by Formula (Z-3).

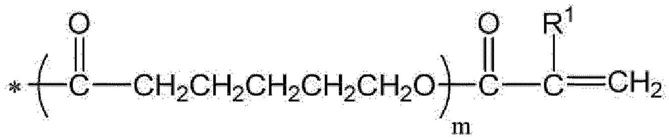

(Z-2)

In Formula (Z-2), $R^1$ represents a hydrogen atom or a methyl group, m represents an integer of 1 or 2, and * represents a bonding position.

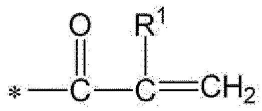

(Z-3)

In Formula (Z-3), $R^1$ represents a hydrogen atom or a methyl group, and "*" represents a bonding position.

The polymerizable compound having a caprolactone structure is commercially available, for example, as KAYARAD DPCA series from Nippon Kayaku Co., Ltd. Examples thereof include DPCA-20 (a compound in which m in Formulae (Z-1) to (Z-3) is 1, the number of groups represented by Formula (Z-2) is 2, and all of $R^1$'s represent hydrogen atoms), DPCA-30 (a compound in which m in Formulae (Z-1) to (Z-3) is 1, the number of groups represented by Formula (Z-2) is 3, and all of $R^1$'s represent hydrogen atoms), DPCA-60 (a compound in which m in Formulae (Z-1) to (Z-3) is 1, the number of groups represented by Formula (Z-2) is 6, and all of $R^1$'s represent hydrogen atoms), and DPCA-120 (a compound in which m in Formulae (Z-1) to (Z-3) is 2, the number of groups represented by Formula (Z-2) is 6, and all of $R^1$'s represent hydrogen atoms). In addition, examples of the commercial product of the polymerizable compound having a caprolactone structure also include M-350 (product name) (trimethylolpropane triacrylate) manufactured by

TOAGOSEI CO., LTD.

As the polymerizable compound, a compound represented by Formula (Z-4) or Formula (Z-5) can also be used.

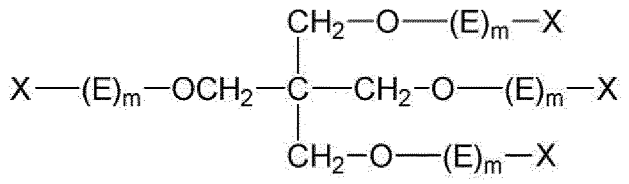

(Z-4)

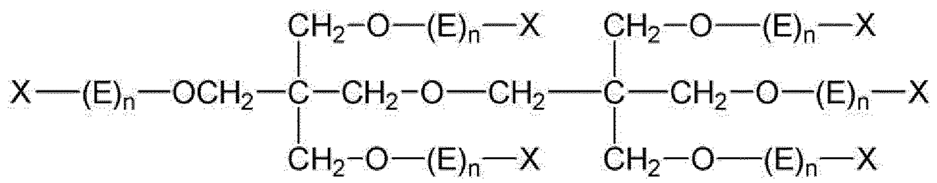

(Z-5)

In Formulae (Z-4) and Formula (Z-5), E represents $-((CH_2)_yCH_2O)-$ or $-((CH_2)yCH(CH_3)O)-$, y represents an integer of 0 to 10, and X represents a (meth)acryloyl group, a hydrogen atom, or a carboxylic acid group.

In Formula (Z-4), the total number of (meth)acryloyl groups is 3 or 4, m represents an integer of 0 to 10, and the sum of each m is an integer of 0 to 40.

In Formula (Z-5), the total number of (meth)acryloyl groups is 5 or 6, n represents an integer of 0 to 10, and the total of n's is an integer of 0 to 60.

In Formula (Z-4), m is preferably an integer of 0 to 6, and more preferably an integer of 0 to 4.

In addition, the total of m's is preferably an integer of 2 to 40, more preferably an integer of 2 to 16, and still more preferably an integer of 4 to 8.

In Formula (Z-5), n is preferably an integer of 0 to 6, and more preferably an integer of 0 to 4.

In addition, the sum of each n is preferably an integer of 3 to 60, more preferably an integer of 3 to 24, and still more preferably an integer of 6 to 12.

In addition, $-((CH_2)_yCH_2O)-$ or $-((CH_2)_yCH(CH_3)O)-$ in Formula (Z-4) or Formula (Z-5) preferably has a form in which the terminal on the oxygen atom side is bonded to X.

The compound represented by Formula (Z-4) or Formula (Z-5) may be used alone or in a combination of two or more thereof. In particular, it is preferable to employ an aspect in which all of six X's in Formula (Z-5) are an acryloyl group or an aspect in which a compound where all of six X's in Formula (Z-5) are an acryloyl group and a compound where at least one of six X's in Formula (Z-5) are a hydrogen atom form a mixture. This constitution can further improve developability.

In addition, the total content of the compounds represented by Formula (Z-4) or Formula (Z-5) in the polymerizable compound is preferably equal to or greater than 20% by mass and more preferably equal to or greater than 50% by mass.

Among the compounds represented by Formula (Z-4) or Formula (Z-5), a pentaerythritol derivative and/or a dipentaerythritol derivative is more preferable.

In addition, the polymerizable compound may have a cardo skeleton.

The polymerizable compound having a cardo skeleton is preferably a polymerizable compound having a 9,9-bisarylfluorene skeleton.

Examples of the polymerizable compound having a cardo skeleton include ONCOAT EX series (manufactured by NAGASE & CO., LTD.), and OGSOL (manufactured by Osaka Gas Chemicals Co., Ltd.).

As the polymerizable compound, a compound having an isocyanuric acid skeleton as a core is also preferable. Examples of such a polymerizable compound include NK ESTER A-9300 (manufactured by SHIN-NAKAMURA CHEMICAL Co., Ltd.).

The content of ethylenically unsaturated groups in the polymerizable compound (the content means a value obtained by dividing the number of ethylenically unsaturated groups in the polymerizable compound by the molecular weight (g/mol) of the polymerizable compound) is preferably 5.0 mmol/g or more. The upper limit thereof is preferably 20.0 mmol/g or less.

[Resin]

The composition according to the embodiment of the present invention contains a resin.

The resin is formulated in, for example, an application for dispersing particles such as a pigment in a composition

or an application as a binder. It is noted that a resin which is used for dispersing mainly particles such as a pigment is also referred to as a dispersant. However, the dispersant is also preferably a dispersant which contains neither a fluorine atom nor a silicon atom.

The use applications of the resin are merely exemplary, and the resin can also be used for other purposes in addition to such applications.

The weight-average molecular weight (Mw) of the resin is preferably more than 2,500 and 2,000,000 or less. The upper limit thereof is more preferably 1,000,000 or lower and still more preferably 500,000 or lower. The lower limit thereof is preferably 3,000 or more and more preferably 5,000 or more.

Examples of the other resins include a (meth)acrylic resin, an epoxy resin, an ene-thiol resin, a polycarbonate resin, a polyether resin, a polyarylate resin, a polysulfone resin, a polyether sulfone resin, a polyphenylene resin, a polyarylene ether phosphine oxide resin, a polyimide resin, a polyamideimide resin, a polyolefin resin, a cyclic olefin resin, a polyester resin, a styrene resin, and a polyalkyleneimine resin (a polyethyleneimine resin or the like). These resins may be used singly or as a mixture of two or more kinds thereof. From the viewpoint of improving heat resistance, the cyclic olefin resin is preferably a norbornene resin. Examples of the commercial product of the norbornene resin include ARTON series manufactured by JSR Corporation (for example, ARTON F4520). Examples of the epoxy resin include an epoxy resin which is a glycidyl etherified product of a phenol compound, an epoxy resin which is a glycidyl etherified product of various novolak resins, an alicyclic epoxy resin, an aliphatic epoxy resin, a heterocyclic epoxy resin, a glycidyl ester-based epoxy resin, a glycidyl amine-based epoxy resin, an epoxy resin obtained by glycidylating halogenated phenols, a condensate of a silicon compound containing an epoxy group and another silicon compound, and a copolymer of a polymerizable unsaturated compound having an epoxy group and another polymerizable unsaturated compound. In addition, as the epoxy resin, MARPROOF G-0150M, G-0105SA, G-0130SP, G-0250SP, G-1005S, G-1005SA, G-1010S, G-2050M, G-01100, or G-01758 (manufactured by NOF Corporation, an epoxy group-containing polymer) can also be used. In addition, as the resin, resins described in Examples of WO2016/088645A can be used. In addition, in a case where the resin contains an ethylenically unsaturated group, particularly a (meth)acryloyl group in the side chain, it is also preferable that the main chain and the ethylenically unsaturated group are bonded through a divalent linking group including an alicyclic structure.

The resin may be a cardo resin having a cardo skeleton.

It is noted that although, as described above, the resin may have a polymerizable group such as an ethylenically unsaturated group or a part or whole of the resin may have a polymerizable property, the resin is not included in the polymerizable compound described above.

The resin in this case preferably has an ethylenically unsaturated group, and examples of the ethylenically unsaturated group include a vinyl group, a (meth)allyl group, and a (meth)acryloyl group.

In the composition according to the embodiment of the present invention, the content of the resin having a polymerizable property is preferably 10% to 100% by mass, more preferably 60% to 100% by mass, and still more preferably 85% to 100% by mass, with respect to the total mass of the resin.

<Alkali-soluble resin>

The composition according to the embodiment of the present invention preferably contains an alkali-soluble resin. In a case where the composition according to the embodiment of the present invention contains an alkali-soluble resin, the developability of the composition is improved, and in a case where a pattern is formed by a photolithography method using the composition according to the embodiment of the present invention, the generation of development residues and the like can be effectively suppressed. Examples of the alkali-soluble resin include resins having an acid group. Examples of the acid group include a carboxyl group, a phosphate group, a sulfo group, and a phenolic hydroxy group, and a carboxyl group is preferable. The acid group included in the alkali-soluble resin may be used singly or in a combination of two or more kinds thereof. It is noted that the alkali-soluble resin can also be used as a dispersant.

The alkali-soluble resin preferably contains a repeating unit having an acid group in the side chain, and more preferably contains 5% to 70% by mole of repeating units having an acid group in the side chain with respect to the total repeating units of the resin. The upper limit of the content of the repeating unit having an acid group in the side chain is preferably 50% by mole or less and more preferably 30% by mole or less. The lower limit of the content of the repeating unit having an acid group in the side chain is preferably 10% by mole or more and more preferably 20% by mole or more.

The alkali-soluble resin is also preferably an alkali-soluble resin having a polymerizable group. Examples of the polymerizable group include a (meth)allyl group (which means both an allyl group and a methallyl group) and a (meth)acryloyl group. The alkali-soluble resin having a polymerizable group is preferably a resin containing a repeating unit having a polymerizable group in the side chain and a repeating unit having an acid group in the side chain.

It is also preferable that the alkali-soluble resin includes a repeating unit derived from a compound represented by Formula (ED1) and/or a compound represented by Formula (ED2) (hereinafter, these compounds may be referred to as an "ether dimer").

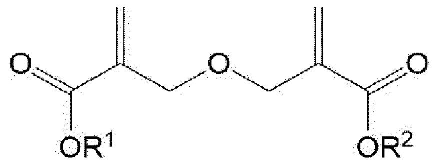

(ED1)

In Formula (ED1), $R^1$ and $R^2$ each independently represent a hydrogen atom or a hydrocarbon group having 1 to 25 carbon atoms, which may have a substituent.

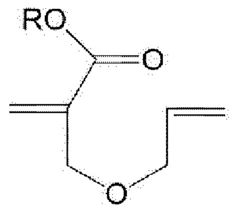

(ED2)

In Formula (ED2), R represents a hydrogen atom or an organic group having 1 to 30 carbon atoms. With regard to details of Formula (ED2), reference can be made to the description in JP2010-168539A, the contents of which are incorporated into the present specification.

With regard to the specific examples of the ether dimer, reference can be made to the description in paragraph [0317] of JP2013-029760A, the contents of which are incorporated into the present specification.

It is also preferable that the alkali-soluble resin contains a repeating unit derived from a compound represented by Formula (X).

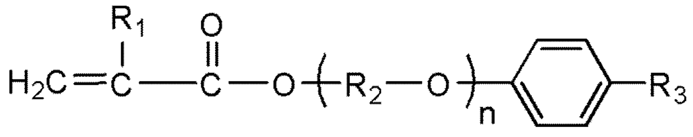

(X)

In Formula (X), $R_1$ represents a hydrogen atom or a methyl group, $R_2$ represents an alkylene group having 2 to 10 carbon atoms, and $R_3$ represents a hydrogen atom or an alkyl group having 1 to 20 carbon atoms which may include a benzene ring. n represents an integer of 1 to 15.

The alkali-soluble resin may be a cardo resin having a cardo skeleton. Examples of the cardo resin include V-259ME (manufactured by NIPPON STEEL & SUMITOMO METAL CORPORATION).

With regard to the alkali-soluble resin having an acid group, reference can be made to the description in paragraphs [0558] to [0571] of JP2012-208494A (paragraphs [0685] to [0700] of the corresponding US2012/0235099A) and the description in paragraphs [0076] to [0099] of JP2012-198408A, the contents of which are incorporated into the present specification by reference.

The resin (particularly, the alkali-soluble resin) preferably has an acid value of 10 to 500 mgKOH/g. The lower limit thereof is preferably 30 mgKOH/g or more. The upper limit thereof is preferably 400 mgKOH/g or less, more preferably 300 mgKOH/g or less, still more preferably 200 mgKOH/g or less, and particularly preferably 100 mgKOH/g or less.

The ethylenically unsaturated bond equivalent (which means a value obtained by dividing the number of ethylenically unsaturated groups in the polymerizable compound by the molecular weight (g/mol) of the polymerizable compound) of the resin (particularly, the alkali-soluble resin) is preferably 0.4 to 2.5 mmol/g. The lower limit thereof is preferably 1.0 mmol/g or more and more preferably 1.2 mmol/g or more. The upper limit thereof is preferably 2.3 mmol/g or less and more preferably 2.0 mmol/g or less.

In particular, in a case where the composition according to the embodiment of the present invention contains a resin having an acid value of 10 to 100 mgKOH/g and an ethylenically unsaturated bond equivalent of 1.0 to 2.0 mmol/g, it is possible to further suppress the occurrence of peeling after the humidity test.

Specific examples of the alkali-soluble resin include resins having the following structures. In the following structural formulae, Me represents a methyl group.

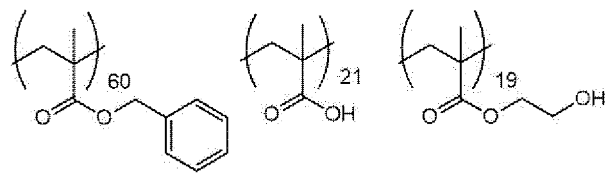

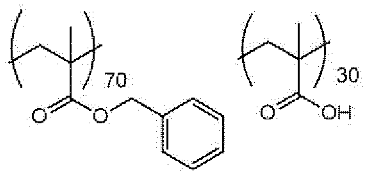

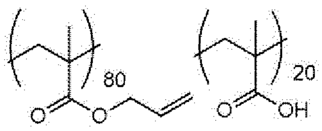

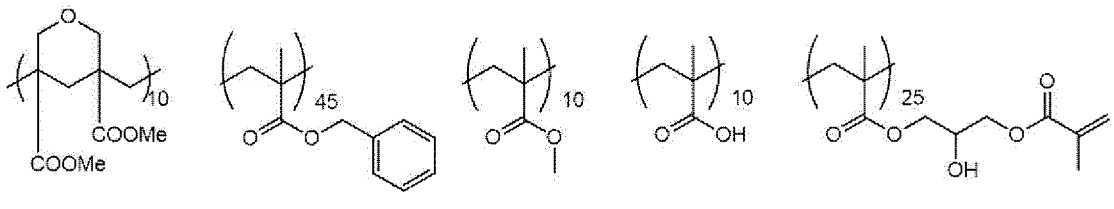

The composition according to the embodiment of the present invention preferably contains a resin having a basic group. Examples of the basic group include an amino group and an ammonium base. The resin having a basic group may further have an acid group in addition to the basic group. It is noted that in a case where the resin having a basic group further has an acid group, such a resin is also an alkali-soluble resin.

The amine value of the resin having a basic group is preferably 10 to 250 mgKOH/g and more preferably 50 to 200 mgKOH/g.

Examples of the resin having a basic group include a resin having a tertiary amino group and a quaternary ammonium base. The resin having a tertiary amino group and a quaternary ammonium base is preferably a resin having a repeating unit having a tertiary amino group and a repeating unit having a quaternary ammonium base. In addition, the resin having a tertiary amino group and a quaternary ammonium base may further have a repeating unit having an acid group. The resin having a tertiary amino group and a quaternary ammonium base preferably has a block structure. The resin having a tertiary amino group and a quaternary ammonium base preferably has an amine value of 10 to 250 mgKOH/g and a quaternary ammonium salt value of 10 to 90 mgKOH/g, and more preferably an amine value of 50 to 200 mgKOH/g and a quaternary ammonium salt value of 10 to 50 mgKOH/g. The weight-average molecular weight (Mw) of the resin having a tertiary amino group and a quaternary ammonium base is preferably 3,000 to 300,000 and more preferably 5,000 to 30,000. The resin having a tertiary amino group and a quaternary ammonium base can be manufactured by copolymerizing an ethylenically unsaturated monomer having a tertiary amino group, an ethylenically unsaturated monomer having a quaternary ammonium base, and as necessary, another ethylenically unsaturated monomer. Examples of the ethylenically unsaturated monomer having a tertiary amino group and the ethylenically unsaturated monomer having a quaternary ammonium base include those described in paragraphs [0150] to [0170] of WO2018/230486A, the contents of which are incorporated into the present specification. In addition, the resins having an acidic group described in paragraphs [0079] to [0160] of JP2018-087939A may be used in combination.

Further, as the resin having a basic group, a resin containing a nitrogen atom in the main chain is also preferable. The resin containing a nitrogen atom in the main chain (hereinafter, also referred to as an oligoimine-based resin) preferably contains at least one repeating unit having a nitrogen atom, selected from a poly(lower alkyleneimine)-based repeating unit (a poly(ethyleneimine)-based repeating unit or the like), a polyallylamine-based repeating unit, a polydiallylamine-based repeating unit, a metaxylene diamine-epichlorohydrin polycondensate-based repeating unit, and a polyvinylamine-based repeating unit. In addition, the oligoimine-based resin is preferably a resin having a repeating unit that has a partial structure X having a functional group of pKa14 or less and a repeating unit that has a side chain containing an oligomer chain having 40 to 10,000 atoms or a polymer chain Y. The oligoimine-based resin may further

have a repeating unit having an acid group. With regard to oligoimine-based resin, reference can be made to the description of paragraphs [0102] to [0166] of JP2012-255128A, the contents of which are incorporated into the present specification.

<Resin as dispersant>

The composition according to the embodiment of the present invention can also contain a resin as a dispersant, and it preferably contains a resin as a dispersant. The resin as a dispersant may correspond to the alkali-soluble resin.

Examples of the resin as a dispersant include an acidic dispersant (acidic resin) and a basic dispersant (basic resin). Here, the acidic dispersant (acidic resin) represents a resin in which the amount of the acid group is larger than the amount of the basic group. The acidic dispersant (acidic resin) is preferably a resin in which the amount of the acid group accounts for 70% by mole or more in a case where the total amount of the acid group and the basic group is 100% by mole, and more preferably a resin substantially consisting of only an acid group. The acid group included in the acidic dispersant (acidic resin) is preferably a carboxyl group. In addition, the basic dispersant (basic resin) represents a resin in which the amount of the basic group is larger than the amount of the acid group. The basic dispersant (basic resin) is preferably a resin in which the amount of the basic group is more than 50% by mole in a case where the total amount of the acid group and the basic group is 100% by mole. The dispersant is preferably a resin having a basic group and more preferably a basic dispersant.

Examples of the resin as a dispersant include the above-described resin having a tertiary amino group and a quaternary ammonium base and an oligoimine-based resin. In addition, it is also preferable that the resin used as a dispersant is a graft resin. Examples of the graft resin include a resin having a repeating unit having a graft chain. The graft resin may further have a repeating unit having an acid group. With regard to details of the graft resin, reference can be made to the description in paragraphs [0025] to [0094] of JP2012-255128A, the contents of which are incorporated into the present specification.

In order to improve interactive properties between the graft chain and the solvent, and thus enhance the dispersibility of the coloring material or the like, the graft chain is preferably a graft chain having at least one selected from the group consisting of a polyester structure, a polyether structure, and a poly(meth)acrylate structure, and more preferably a graft chain having at least one of a polyester structure or a polyether structure.

In addition, it is also preferable that the resin as a dispersant is a resin containing a repeating unit having an acid group. In addition, it is also preferable that the resin used as a dispersant is a resin having a structure in which a plurality of polymer chains are bonded to a core portion. Examples of such a resin include dendrimers (including star polymers). In addition, specific examples of the dendrimer include polymer compounds C-1 to C-31 described in paragraphs [0196] to [0209] of JP2013-043962A. In addition, the alkali-soluble resin can also be used as a dispersant.

The resin as a dispersant is also available as a commercial product. Specific examples thereof include Disperbyk-111 (manufactured by BYK Chemie), and Solsperse 20000 and Solsperse 76500 (manufactured by Lubrizol Japan Limited). The dispersants described in paragraphs [0041] to [0130] of JP2014-130338A can also be used, the contents of which are incorporated into the present specification.

It is also preferable to use the dispersant described in JP2019-078878A.

<Polyalkyleneimine>

The composition according to the embodiment of the present invention may contain polyalkyleneimine.

The polyalkyleneimine, which is a polymer obtained by subjecting an alkyleneimine to a ring opening polymerization, is preferably a polymer having a branched structure containing each of a primary amino group, a secondary amino group, and a tertiary amino group. The number of carbon atoms in the alkyleneimine is preferably 2 to 6, more preferably 2 to 4, still more preferably 2 or 3, and particularly preferably 2.

Specific examples of the alkyleneimine include ethyleneimine, propyleneimine, 1,2-butyleneimine, and 2,3-butyleneimine, where ethyleneimine or propyleneimine is preferable, and ethyleneimine is more preferable.

The molecular weight of the polyalkyleneimine is preferably 100 or more, more preferably 200 or more, and still more preferably 250 or more. The upper limit thereof is preferably 100,000 or less, more preferably 50,000 or less, still more preferably 10,000 or less, and particularly preferably 2,000 or less.

It is noted that regarding the value of the molecular weight of polyalkyleneimine, in a case where the molecular weight can be calculated from the structural formula, the molecular weight of the polyalkyleneimine is a value calculated from the structural formula. On the other hand, in a case where the molecular weight of the polyalkyleneimine cannot be calculated from the structural formula or is difficult to calculate, a value of a number-average molecular weight measured by a boiling point increase method is used. In addition, even in a case where it cannot be measured by the boiling point increase method or is difficult to be measured, a value of a number-average molecular weight measured by a viscosity method is used. In addition, in a case where it cannot be measured by the viscosity method either or is

difficult to be measured by the viscosity method, a value of a number-average molecular weight in terms of polystyrene through measurement according to a gel permeation chromatography (GPC) method is used.

The amine value of the polyalkyleneimine is preferably 2.7 mmol/g or more, more preferably 5 mmol/g or more, still more preferably 10 mmol/g or more, and particularly preferably 15 mmol/g or more.

The polyalkyleneimine is preferably polyethyleneimine. In addition, the polyethyleneimine preferably includes the primary amino group in an amount of 10% by mole or more, more preferably includes the primary amino group in an amount of 20% by mole or more, and still more preferably includes the primary amino group in an amount of 30% by mole or more with respect to the total of the primary amino group, the secondary amino group, and the tertiary amino group. Examples of the commercial product of the polyethyleneimine include EPOMIN SP-003, SP-006, SP-012, SP-018, SP-200, and P-1000 (all of which are manufactured by Nippon Shokubai Co., Ltd.).

The content of the resin is preferably 1% to 50% by mass with respect to the total solid content of the composition. The lower limit thereof is preferably 5% by mass or more and more preferably 7% by mass or more. The upper limit thereof is preferably 40% by mass or less and more preferably 30% by mass or less.

In a case where the composition according to the embodiment of the present invention contains an alkali-soluble resin, the content of the alkali-soluble resin is preferably 1% to 50% by mass with respect to the total solid content of the composition. The lower limit thereof is preferably 5% by mass or more and more preferably 7% by mass or more. The upper limit thereof is preferably 40% by mass or less and more preferably 30% by mass or less. In addition, the content of the alkali-soluble resin in the resin contained in the composition is preferably 50% to 100% by mass, more preferably 75% to 100% by mass, and still more preferably 90% to 100% by mass with respect to the total mass of the resin.

In addition, the content of the resin as a dispersant in the resin contained in the composition (for example, the total content of a resin that corresponds to both the alkali-soluble resin and the resin as a dispersant, and a resin that does not correspond to the alkali-soluble resin but corresponds to the resin as a dispersant) is preferably 50% to 100% by mass, more preferably 75% to 100% by mass, and still more preferably 90% to 100% by mass.

The composition may contain only one kind of resin or may contain two or more kinds thereof. In a case where two or more kinds thereof are contained, the total amount thereof is preferably within the above-described range.

[Dispersion aid]

The composition may include a dispersion aid.

The dispersion aid is a component other than the above-described resin, which is a component that can suppress the aggregation and/or the sedimentation of a component that is present in the composition in a solid state, such as a black pigment.

Examples of the dispersion aid include a pigment derivative.

The content of the dispersion aid is preferably 0.01% to 10% by mass, more preferably 0.1% to 8% by mass, and still more preferably 0.3% to 4% by mass, with respect to the total solid content of the composition.

[Polymerization Initiator]

The composition according to the embodiment of the present invention may contain a polymerization initiator.

As the polymerization initiator, for example, known polymerization initiators can be used. Examples of the polymerization initiator include a photopolymerization initiator and a thermal polymerization initiator, and a photopolymerization initiator is preferable.

The content of the polymerization initiator is preferably 0.5% to 20% by mass, more preferably 1.0% to 10% by mass, and still more preferably 1.5% to 8% by mass, with respect to the total solid content of the composition.

The composition may contain only one kind of polymerization initiator or may contain two or more kinds thereof. In a case where two or more kinds thereof are contained, the total amount thereof is preferably within the above-described range.

<Thermal polymerization initiator>

Examples of the thermal polymerization initiator include an azo compound such as 2,2'-azobisisobutyronitrile (AIBN), 3-carboxypropionitrile, azobismalononitrile, and dimethyl-(2,2')-azobis(2-methylpropionate) [V-601] and an organic peroxide such as benzoyl peroxide, lauroyl peroxide, and potassium persulfate.

Specific examples of the thermal polymerization initiator include the polymerization initiators described on pages 65 to 148 of "Ultraviolet Curing System" written by Kiyomi Kato (published by GL Sciences Inc.: 1989).

<Photopolymerization initiator>

The photopolymerization initiator is not particularly limited and can be appropriately selected from known photopolymerization initiators. For example, a compound having photosensitivity to a ray in a range from an ultraviolet ray range to a visible light range is preferable. The photopolymerization initiator is preferably a photoradical polymerization initiator.

Examples of the photopolymerization initiator include a halogenated hydrocarbon derivative (for example, a compound having a triazine skeleton, a compound having an oxadiazole skeleton, or the like), an acylphosphine compound, a hexaarylbiimidazole, an oxime compound, an organic peroxide, a thio compound, a ketone compound, an aromatic onium salt, an α-hydroxyketone compound, and an α-aminoketone compound.

In addition, from the viewpoint of exposure sensitivity, the photopolymerization initiator is preferably a trihalomethyltriazine compound, a benzyl dimethyl ketal compound, an α-hydroxyketone compound, an α-aminoketone compound, an acylphosphine compound, a phosphine oxide compound, a metallocene compound, an oxime compound, a triarylimidazole dimer, an onium compound, a benzothiazole compound, a benzophenone compound, an acetophenone compound, a cyclopentadiene-benzene-iron complex, a halomethyl oxadiazole compound, or a 3-aryl-substituted coumarin compound, more preferably a compound selected from an oxime compound, an α-hydroxyketone compound, an α-aminoketone compound, or an acylphosphine compound, and still more preferably an oxime compound.

Examples of the photopolymerization initiator include compounds described in paragraphs [0065] to [0111] of JP2014-130173A, and JP6301489B, the contents of which are incorporated into the present specification.

Examples of the commercial product of the α-hydroxyketone compound include OMNIRAD 184, OMNIRAD 1173, OMNIRAD 2959, and OMNIRAD 127 (all of which are manufactured by IGM Resins B.V), and IRGACURE 184, IRGACURE 1173, IRGACURE 2959, and IRGACURE 127 (all of which are manufactured by BASF SE). Examples of the commercial product of the α-aminoketone compound include OMNIRAD 907, OMNIRAD 369, OMNIRAD 369E, and OMNIRAD 379EG (all of which are manufactured by IGM Resins B.V), and IRGACURE 907, IRGACURE 369, IRGACURE 369E, and IRGACURE 379EG (all of which are manufactured by BASF SE). Examples of the commercial product of the acylphosphine compound include OMNIRAD 819 and OMNIRAD TPO (both of which are manufactured by IGM Resins B.V), and IRGACURE 819 and IRGACURE TPO (both of which are manufactured by BASF SE).

Examples of the oxime compound include the compounds described in JP2001-233842A, the compounds described in JP2000-080068A, the compounds described in JP2006-342166A, the compounds described in J. C. S. Perkin II (1979, pp. 1653-1660), the compounds described in J. C. S. Perkin II (1979, pp. 156-162), the compounds described in Journal of Photopolymer Science and Technology (1995, pp. 202-232), the compounds described in JP2000-066385A, the compounds described in JP2000-080068A, the compounds described in JP2004-534797A, the compounds described in JP2006-342166A, the compounds described in JP2017-019766A, the compounds described in JP6065596B, the compounds described in WO2015/152153A, the compounds described in WO2017/051680A, the compounds described in JP2017-198865A, the compounds described in paragraphs [0025] to [0038] of WO2017/164127A, the compounds described in WO2013/167515A, and the compounds described in WO2019/088055A. Specific examples of the oxime compound include 3-benzoyloxyiminobutan-2-one, 3-acetoxyiminobutan-2-one, 3-propionyloxyiminobutan-2-one, 2-acetoxyiminopentan-3-one, 2-acetoxyimino-1-phenylpropan-1-one, 2-benzoyloxyimino-1-phenylpropan-1-one, 3-(4-toluenesulfonyloxy)iminobutan-2-one, and 2-ethoxycarbonyloxyimino-1-phenylpropan-1-one. Examples of the commercial product of the oxime compound include IRGACURE-OXE01, IRGACURE-OXE02, IRGACURE-OXE03, or IRGACURE-OXE04 (all of which are manufactured by BASF SE), TR-PBG-304 (manufactured by Changzhou Tronly New Electronic Materials Co., Ltd.), and ADEKA OPTOMER N-1919 (manufactured by Adeka Corporation, a photopolymerization initiator 2 described in JP2012-014052A). In addition, it is also preferable to use a compound having no colorability and a compound having high transparency and resistance to discoloration as the oxime compound. Examples of the commercial product of such compounds include ADEKA ARKLS NCI-730, NCI-831, and NCI-930 (all of which are manufactured by ADEKA Corporation).

In the present invention, an oxime compound having a fluorene ring can also be used as the photopolymerization initiator. Specific examples of the oxime compound having a fluorene ring include the compounds described in JP2014-137466A.

In addition, as the photopolymerization initiator, an oxime compound having a skeleton in which at least one benzene ring of a carbazole ring is a naphthalene ring can also be used. Specific examples of such an oxime compound include the compounds described in WO2013/083505A.

In the present invention, an oxime compound having a fluorine atom can also be used as the photopolymerization initiator. Specific examples of the oxime compound having a fluorine atom include the compounds described in JP2010-262028A, Compounds 24, and 36 to 40 described in JP2014-500852A, and Compound (C-3) described in JP2013-164471A.

In the present invention, as the photopolymerization initiator, an oxime compound having a nitro group can be used. The oxime compound having a nitro group is also preferably used in the form of a dimer. Specific examples of the

oxime compound having a nitro group include a compound described in paragraphs [0031] to [0047] of JP2013-114249A and paragraphs [0008] to [0012] and [0070] to [0079] of JP2014-137466A, a compound described in paragraphs [0007] to [0025] of JP4223071B, and ADEKA ARKLS NCI-831 (manufactured by ADEKA CORPORATION).

In the present invention, as the photopolymerization initiator, an oxime compound having a benzofuran skeleton can also be used. Specific examples thereof include OE-01 to OE-75 described in WO2015/036910A.

Specific examples of the oxime compound which are preferably used in the present invention are shown below, but the present invention is not limited thereto.

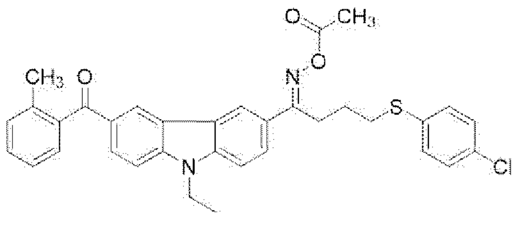

(C-1)

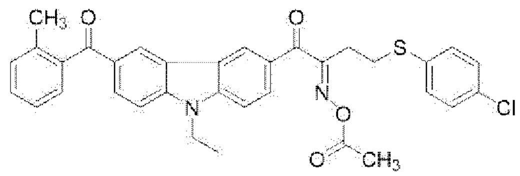

(C-2)

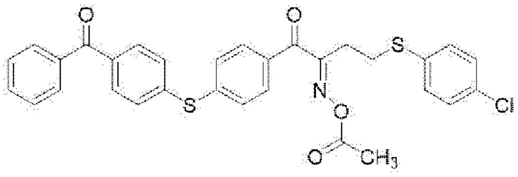

(C-3)

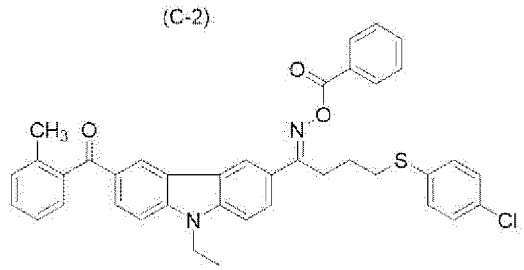

(C-4)

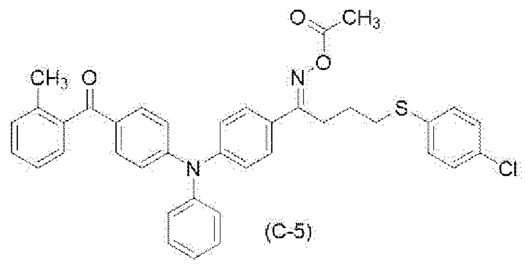

(C-5)

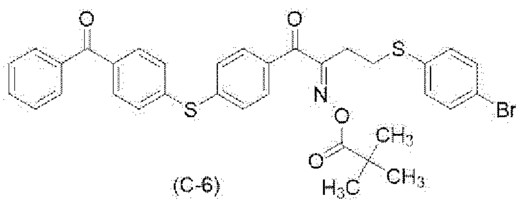

(C-6)

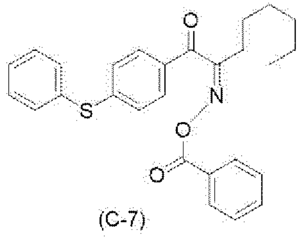

(C-7)

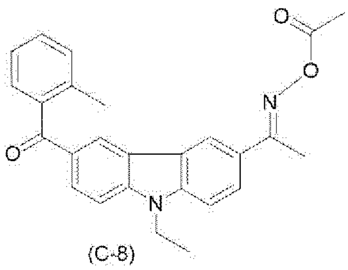

(C-8)

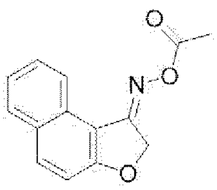

(C-9)

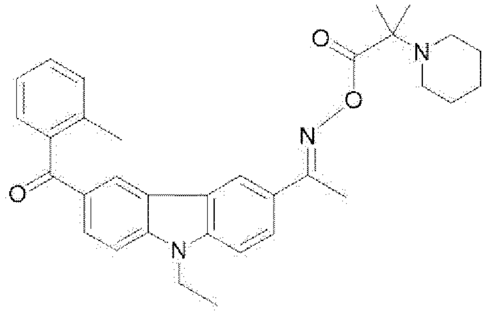

(C-10)

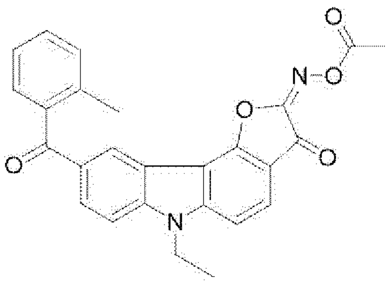

(C-11)

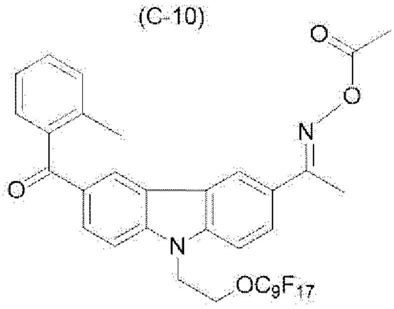

(C-12)

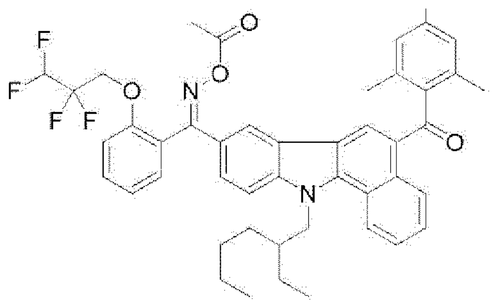

(C-13)

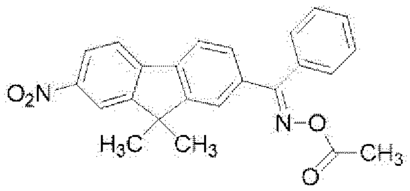

(C-14)

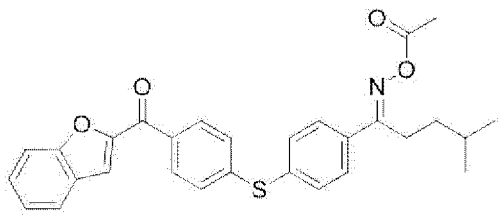

(C-15)

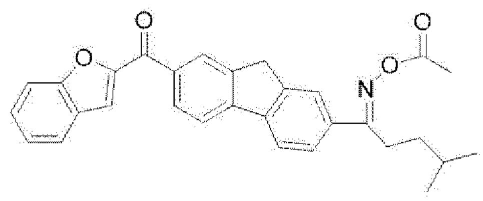

(C-16)

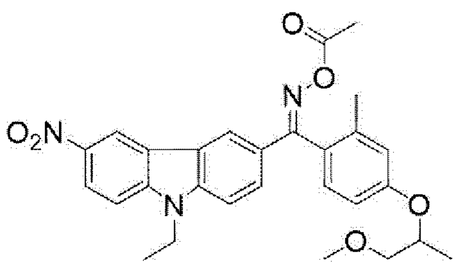

The oxime compound is preferably a compound having a maximal absorption wavelength in a wavelength range of 350 to 500 nm and more preferably a compound having a maximal absorption wavelength in a wavelength

range of 360 to 480 nm. In addition, from the viewpoint of sensitivity, the molar absorption coefficient of the oxime compound at a wavelength of 365 nm or 405 nm is preferably high, more preferably 1,000 to 300,000, still more preferably 2,000 to 300,000, and even still more preferably 5,000 to 200,000. The molar absorption coefficient of the compound can be measured using a known method. For example, the molar absorption coefficient is preferably measured by a spectrophotometer (Cary-5 spectrophotometer, manufactured by Varian Medical Systems, Inc.) using an ethyl acetate solvent at a concentration of 0.01 g/L.

A difunctional or tri- or higher functional photoradical polymerization initiator may be used as the photopolymerization initiator. By using such a photoradical polymerization initiator, two or more radicals are generated from one molecule of the photoradical polymerization initiator, and as a result, good sensitivity is obtained. In addition, in a case where a compound having an asymmetric structure is used, the crystallinity is lowered, the solubility in a solvent or the like is improved, and the precipitation is less likely to occur over time, so that the temporal stability of the composition can be improved. Specific examples of the difunctional or tri- or higher functional photoradical polymerization initiator include dimers of the oxime compounds described in JP2010-527339A, JP2011-524436A, WO2015/004565A, paragraphs [0407] to [0412] of JP2016-532675A, and paragraphs [0039] to [0055] of WO2017/033680A; the compound (E) and compound (G) described in JP2013-522445A; Cmpd 1 to 7 described in WO2016/034963A; the oxime ester photoinitiators described in paragraph [0007] of JP2017-523465A; the photoinitiators described in paragraphs [0020] to [0033] of JP2017-167399A; and the photopolymerization initiator (A) described in paragraphs [0017] to [0026] of JP2017-151342A.

It is also preferable that the photopolymerization initiator contains an oxime compound and an $\alpha$-aminoketone compound. By using the oxime compound and the $\alpha$-aminoketone compound in combination, the developability is improved, and a pattern having excellent rectangularity can be easily formed. In a case where the oxime compound and the $\alpha$-aminoketone compound are used in combination, the content of the $\alpha$-aminoketone compound is preferably 50 to 600 parts by mass and more preferably 150 to 400 parts by mass with respect to 100 parts by mass of the oxime compound.

The content of the photopolymerization initiator is preferably 0.1% to 40% by mass, more preferably 0.5% to 30% by mass, and still more preferably 1% to 20% by mass, with respect to the total solid content of the composition.

The composition may contain only one kind of photopolymerization initiator or may contain two or more kinds thereof. In a case where two or more kinds thereof are contained, the total amount thereof is preferably within the above-described range.

[Polymerization inhibitor]

The composition may contain a polymerization inhibitor.

As the polymerization inhibitor, for example, known polymerization inhibitors can be used. Examples of the polymerization inhibitor include a phenol-based polymerization inhibitor (for example, p-methoxyphenol, 2,5-di-tert-butyl-4-methylphenol, 2,6-di-tert-butyl-4-methylphenol, 4,4'-thiobis(3-methyl-6-t-butylphenol), 2,2'-methylenebis(4-methyl-6-t-butylphenol), or 4-methoxynaphthol); a hydroquinone-based polymerization inhibitor (for example, hydroquinone or 2,6-di-tert-butyl hydroquinone); a quinone-based polymerization inhibitor (for example, benzoquinone); a free radical-based polymerization inhibitor (for example, a 2,2,6,6-tetramethylpiperidine 1-oxyl free radical or a 4-hydroxy-2,2,6,6-tetramethylpiperidine 1-oxyl free radical); a nitrobenzene-based polymerization inhibitor (for example, nitrobenzene, 4-nitrotoluene); and a phenothiazine-based polymerization inhibitor (for example, phenothiazine or 2-methoxyphenothiazine).

Among them, a phenol-based polymerization inhibitor or a free radical-based polymerization inhibitor is preferable from the viewpoint that the effect of the present invention is more excellent.

The content of the polymerization inhibitor is preferably 0.0001% to 0.5% by mass, more preferably 0.001% to 0.2% by mass, and still more preferably 0.002% to 0.05% by mass, with respect to the total solid content of the composition.

The composition may contain only one kind of polymerization inhibitor or may contain two or more kinds thereof. In a case where two or more kinds thereof are contained, the total amount thereof is preferably within the above-described range.

In addition, a ratio (content of polymerization inhibitor/content of polymerizable compound (mass ratio)) of the content of the polymerization inhibitor to the content of the polymerizable compound in the composition is preferably 0.00005 to 0.02 and more preferably 0.0001 to 0.005.

[Surfactant]

The composition may contain a surfactant. The surfactant contributes to improvement of the coatability of the composition.

In a case where the composition contains a surfactant, the content of the surfactant is preferably 0.001% to

2.0% by mass, more preferably 0.003% to 0.5% by mass, and still more preferably 0.005% to 0.1% by mass, with respect to the total solid content of the composition.

The composition may contain only one kind of surfactant or may contain two or more kinds thereof. In a case where two or more kinds thereof are contained, the total amount thereof is preferably within the above-described range.

Examples of the surfactant include a fluorine-based surfactant, a nonionic surfactant, a cationic surfactant, an anionic surfactant, and a silicone-based surfactant.

Examples of the fluorine-based surfactant include MEGAFACE F171, MEGAFACE F172, MEGAFACE F173, MEGAFACE F176, MEGAFACE F177, MEGAFACE F141, MEGAFACE F142, MEGAFACE F143, MEGAFACE F144, MEGAFACE R30, MEGAFACE F437, MEGAFACE F475, MEGAFACE F479, MEGAFACE F482, MEGAFACE F554, MEGAFACE F780, and MEGAFACE F781F (all of which are manufactured by DIC Corporation); Florard FC430, Florard FC431, and Florard FC171 (all of which are manufactured by Sumitomo 3M Limited); Surflon S-382, Surflon SC-101, Surflon SC-103, Surflon SC-104, Surflon SC-105, Surflon SC1068, Surflon SC-381, Surflon SC-383, Surflon S393, and Surflon KH-40 (all of which are manufactured by AGC Inc.); and PF636, PF656, PF6320, PF6520, and PF7002 (manufactured by OMNOVA Solutions Inc.).

As the fluorine-based surfactant, a block polymer can also be used, and specific examples thereof include the compound described in JP2011-089090A.

[Solvent]

The composition according to the embodiment of the present invention preferably contains a solvent. As the solvent, an organic solvent is preferable. Examples of the organic solvent include an ester-based solvent, a ketone-based solvent, an alcohol-based solvent, an amide-based solvent, an ether-based solvent, and a hydrocarbon-based solvent. For details thereof, paragraph [0223] of WO2015/166779A can be referenced, the contents of which are incorporated into the present specification. In addition, an ester-based solvent in which a cyclic alkyl group is substituted or a ketone-based solvent in which a cyclic alkyl group is substituted can also be preferably used. Specific examples of the organic solvent include polyethylene glycol monomethyl ether, dichloromethane, methyl 3-ethoxypropionate, ethyl 3-ethoxypropionate, ethyl cellosolve acetate, ethyl lactate, diethylene glycol dimethyl ether, butyl acetate, 3-methoxybutyl acetate, methyl 3-methoxypropionate, 2-heptanone, cyclohexanone, cyclohexyl acetate, cyclopentanone, ethyl carbitol acetate, butyl carbitol acetate, propylene glycol monomethyl ether, and propylene glycol monomethyl ether acetate. However, it may be good that the content of aromatic hydrocarbons (such as benzene, toluene, xylene, and ethylbenzene) as the organic solvent is low (for example, 50 parts per million (ppm) by mass or less, 10 ppm by mass or less, or 1 ppm by mass or less with respect to the total amount of the organic solvent) in consideration of environmental aspects and the like.

In the present invention, an organic solvent having a low metal content is preferably used. For example, the metal content in the organic solvent is preferably 10 mass parts per billion (ppb) or less. Optionally, an organic solvent having a metal content at a mass parts per trillion (ppt) level may be used. For example, such an organic solvent is available from Toyo Gosei Co., Ltd. (The Chemical Daily, November 13, 2015).

Examples of the method for removing impurities such as a metal from the organic solvent include distillation (such as molecular distillation and thin-film distillation) and filtration using a filter. The filter pore diameter of the filter used for the filtration is preferably 10 μm or less, more preferably 5 μm or less, and still more preferably 3 μm or less. The lower limit thereof is preferably 1 nm or more. As a material of the filter, polytetrafluoroethylene, polyethylene, or nylon is preferable.

The organic solvent may include an isomer (a compound having the same number of atoms and a different structure). In addition, only one kind of isomers may be included, or a plurality of isomers may be included.

The organic solvent preferably has the content of peroxides of 0.8 mmol/L or less, and more preferably, the organic solvent does not substantially include peroxides.

The content of the solvent is preferably 10% to 97% by mass with respect to the total amount of the composition. The lower limit thereof is more preferably 30% by mass or more, still more preferably 40% by mass or more, particularly preferably 50% by mass or more, even still more preferably 60% by mass or more, and most preferably 65% by mass or more. The upper limit thereof is more preferably 95% by mass or less and still more preferably 80% by mass or less.

The composition may contain only one kind of solvent or may contain two or more kinds thereof. In a case where two or more kinds thereof are contained, the total amount thereof is preferably within the above-described range.

[Other optional components]

The composition may further contain optional components other than the aforementioned components.

Examples thereof include a coloring material (which may be a pigment or a dye) other than the black pigment, an ultraviolet absorbing agent, a silane coupling agent, a surfactant, a sensitizer, a co-sensitizer, a crosslinking agent,

a curing accelerator, a heat curing accelerator, a plasticizer, a diluent, and an oil sensitizing agent, and known additives such as an adhesion promoter to the surface of the substrate and other auxiliaries (for example, conductive particles, a filler, an antifoaming agent, a flame retardant, a leveling agent, a peeling accelerator, an antioxidant, a fragrance, a surface tension adjuster, and a chain transfer agent) may be further added, as necessary.

Regarding these components, reference can be made to, for example, the descriptions in paragraphs [0183] to [0228] of JP2012-003225A (corresponding to paragraphs [0237] to [0309] of US2013/0034812A), paragraphs [0101], [0102], [0103], [0104], and [0107] to [0109] of JP2008-250074A, and paragraphs [0159] to [0184] of JP2013-195480A, the contents of which are incorporated into the specification of the present application.

[Production method for composition]

Regarding the composition, it is preferable that a dispersion liquid of a black pigment is produced, and the obtained composition is further mixed with other components to obtain a composition.

It is noted that each component referred to in the description of the production method for the composition is as described above.

More specifically, it is preferable to produce the composition by the production method including the following step 1 and step 2. According to this method, it is possible to obtain a composition in which the effect of the present invention is more excellent.

Step 1: A step of mixing a pre-mixture containing a black pigment, a resin, and a carboxylic acid anhydride with a beads mill to obtain a mixture (a coloring material dispersion liquid or the like)

Step 2: A step of mixing the mixture and a polymerizable compound to obtain a composition (a black photosensitive composition)

<Step 1>

The pre-mixture may contain a component other than the black pigment, the resin (preferably the resin as a dispersant), and the carboxylic acid anhydride, and examples of such a component include a dispersion aid, a polymerization inhibitor, and a solvent.

In a case of obtaining a pre-mixture to be mixed in the step 1, each of components may be formulated together as the components to be contained in the pre-mixture, or each of components may be independently dissolved or dispersed in a solvent and then sequentially formulated. In addition, the input order and the operation conditions during the formulation are not particularly limited.

The pre-mixture is mixed with a beads mill to obtain a mixture. In a case where the pre-mixture contains a solvent and the mixture contains a solvent, such a mixture is also referred to particularly as a coloring material dispersion liquid.

It is also preferable that the pre-mixture is roughly mixed before being mixed by the beads mill. The method for rough mixing is not particularly limited, and known means can be used.

As the beads in the beads mill, it is possible to use inorganic beads such as glass beads and zirconia beads, resin beads, or the like.

The bead diameter is preferably 0.01 to 1.0 mm and more preferably 0.03 to 0.65 mm.

The bead filling rate is preferably 50% to 90% and more preferably 60% to 80%.

The rotation speed (circumferential speed) is preferably 1 to 20 m/s and more preferably 5 to 14 m/s.

The temperature of the treatment target is preferably 5°C to 80°C and more preferably 30°C to 60°C.

The beads mill may be, for example, any of a batch type device, a circulation type device, or a continuous type device, and a plurality of devices may be used in combination.

In a case where the beads mill belongs to a batch type, the treatment time is preferably 0.5 to 6 hours and more preferably 2 to 4 hours.

In a case where the beads mill belongs to a circulation type, the number of passes is preferably 10 to 1,000 and more preferably 60 to 200.

In the pre-mixture and/or the mixture, the content of the solvent is preferably 10% to 95% by mass, more preferably 30% to 90% by mass, and still more preferably 50% to 80% by mass, with respect to the total mass of the pre-mixture and/or the mixture.

The content of the resin (preferably the resin as a dispersant) is preferably 1% to 50% by mass, more preferably 5% to 40% by mass, and still more preferable 15% to 35% by mass, with respect to the total solid content of the pre-mixture and/or the mixture.

The content of the carboxylic acid anhydride is preferably 0.05% to 30% by mass, more preferably 0.1% to 20% by mass, and still more preferably 1% to 10% by mass, with respect to the total solid content of the pre-mixture and/or the mixture.

The content of the black pigment is preferably 20% to 95% by mass, more preferably 40% to 90% by mass, and still more preferably 60% to 80% by mass, with respect to the total solid content of the pre-mixture and/or the mixture.
The content of the dispersion aid is preferably 0.05% to 30% by mass, more preferably 0.5% to 10% by mass, and still more preferably 1% to 5% by mass, with respect to the total solid content of the pre-mixture and/or the mixture.
The mass ratio of the total content of the resin and the acid anhydride to the content of the black pigment in the pre-mixture and/or the mixture (total content of resin and acid anhydride/content of black pigment) is preferably 0.10 to 2.00, more preferably 0.15 to 1.00, and still more preferably 0.25 to 0.45.

<Step 2>

In the step 2, the mixture obtained in the step 1 and a polymerizable compound are mixed to obtain a composition (a black photosensitive composition).
In the step 2, it suffices that at least a polymerizable compound is mixed with the mixture, and other components (a polymerization initiator, a polymerization inhibitor, a surfactant, a resin to be further added, and/or a solvent to be further added, and the like) may be further mixed.
Regarding each of components (including the mixture obtained in the step 1) to be mixed to obtain the composition in the step 2, each of the components may be formulated together, or each of the components may be independently dissolved or dispersed in a solvent and then sequentially formulated. In addition, the input order and the operation conditions during the formulation are not particularly limited.
The composition can be prepared by mixing the above-described respective components by a known mixing method (for example, a mixing method using a stirrer, a homogenizer, a high-pressure emulsification device, a wet-type pulverizer, a wet-type disperser, or the like).
In the composition obtained in the step 2, it suffices that at least a part of the black pigment, the resin, and the carboxylic acid anhydride, which are contained in the composition, are derived from the mixture obtained in the step 1, and a black pigment, a resin, and/or a carboxylic acid anhydride, and the like, which are different from those contained in the mixture, may be further mixed.
In the solvent contained in the composition obtained in the step 2, the content of the solvent derived from the mixture obtained in the step 1 is preferably 10% to 100% by mass, more preferably 50% to 95% by mass, and still more preferably 70%% to 90% by mass.
In the resin contained in the composition obtained in the step 2, the content of the resin derived from the mixture obtained in the step 1 is preferably 10% to 100% by mass, more preferably 70% to 100% by mass, and still more preferably 80% to 100%.
In the carboxylic acid anhydride contained in the composition obtained in the step 2, the content of the carboxylic acid anhydride derived from the mixture obtained in the step 1 is preferably 10% to 100% by mass, more preferably 70% to 100% by mass, and still more preferably 95%% to 100% by mass.
In the black pigment contained in the composition obtained in the step 2, the content of the black pigment derived from the mixture obtained in the step 1 is preferably 10% to 100% by mass, more preferably 70% to 100% by mass, and still more preferably 95%% to 100% by mass.
In the dispersion aid contained in the composition obtained in the step 2, the content of the dispersion aid derived from the mixture obtained in the step 1 is preferably 10% to 100% by mass, more preferably 70% to 100% by mass, and still more preferably 95%% to 100% by mass.
In the polymerizable compound contained in the composition obtained in the step 2, the content of the polymerizable compound derived from the mixture obtained in the step 1 is preferably 0% to 30% by mass, more preferably 0% to 5% by mass, and still more preferably 0%% to 1% by mass.
For the purpose of removing foreign substances, reducing defects, and the like, the composition is preferably filtered with a filter. The filter can be used without particular limitation, for example, as long as the filter has been used in the related art in a filtration application or the like. Examples of the filter include filters made of a fluororesin such as polytetrafluoroethylene (PTFE), a polyamide-based resin such as nylon, and a polyolefin-based resin (having a high density and an ultrahigh molecular weight) such as polyethylene or polypropylene (PP). Among them, polypropylene (including high density polypropylene) or nylon is preferable.
A pore diameter of the filter is preferably 0.1 to 7.0 μm, more preferably 0.2 to 2.5 μm, still more preferably 0.2 to 1.5 μm, and particularly preferably 0.3 to 0.7 μm. In a case where the pore diameter is within the above range, it is possible to reliably remove fine foreign substances, such as impurities and aggregates, contained in a pigment while suppressing filtration clogging of the pigment (including a black pigment).
In a case of using a filter, different filters may be combined. In this case, filtering with a first filter may be carried out only once or may be carried out twice or more times. In a case where filtering is carried out twice or more times with the combination of different filters, the pore diameters of the filters that are used in the second and subsequent filtering are preferably the same as or larger than the pore diameter of the filter that is used in the first filtering. In addition, the

first filters having different pore diameters within the above range may be combined. With regard to the pore diameters herein, reference can be made to nominal values of filter manufacturers. A commercial filter can be selected from various filters provided by, for example, Nihon Pall Ltd., Advantec Toyo Kaisha, Ltd., Nihon Entegris K. K. (formerly Nippon Microlith Co., Ltd.), Kitz Micro Filter Corporation.

As a second filter, a filter formed of the same material as that of the first filter, or the like can be used. The pore diameter of the second filter is preferably 0.2 to 10.0 μm, more preferably 0.2 to 7.0 μm, and still more preferably 0.3 to 6.0 μm.

The composition preferably does not contain impurities such as a metal, a halogen-containing metal salt, an acid, and an alkali. The content of impurities contained in these materials is preferably equal to or less than 1 ppm by mass, more preferably equal to or less than 1 ppb by mass, still more preferably equal to or less than 100 ppt by mass, and particularly preferably equal to or less than 10 ppt by mass, and it is most preferable that the impurities are not substantially contained (the content is equal to or less than the detection limit of the measuring device).

It is noted that the impurities can be measured using an inductively coupled plasma mass spectrometer (manufactured by Agilent Technologies, Inc., Agilent 7500cs model).

[Manufacturing of cured film]

A composition layer formed from the composition according to the embodiment of the present invention is cured to obtain a cured film (including a patterned cured film).

The method for manufacturing a cured film is not particularly limited; however, it preferably includes the following steps.

- Composition layer forming step
- Exposure step
- Development step

Hereinafter, each of the steps will be described.

[Composition layer forming step]

In the composition layer forming step, prior to exposure, the composition is applied on a support or the like to form a layer (composition layer) of the composition. As the support, for example, a substrate for a solid-state imaging element, in which an imaging element (light-receiving element) such as a charge coupled device (CCD) or a complementary metal-oxide semiconductor (CMOS) is provided on a substrate (for example, a silicon substrate), can be used. In addition, in order to improve adhesion with the upper layer, prevent the diffusion of substances, and planarize the surface of the substrate, an undercoat layer may be provided on the support, as needed.

As a method for applying the composition onto the support, it is possible to apply various coating methods such as a slit coating method, an ink jet method, a spin coating method, a cast coating method, a roll coating method, and a screen printing method. A film thickness of the composition layer is preferably 0.1 to 10 μm, more preferably 0.2 to 5 μm, and still more preferably 0.2 to 3 μm. The composition layer coated on the support can be dried (pre-baked) at a temperature of 50°C to 140°C for 10 to 300 seconds, for example, using a hot plate, an oven, or the like.

[Exposure step]

In the exposure step, the composition layer formed in the composition layer forming step is exposed by irradiation with an actinic ray or a radiation, and the composition layer irradiated with light is cured.

As the method of light irradiation, it is preferable to carry out light irradiation through a photo mask having a patterned opening portion.

The exposure is preferably carried out by irradiation with a radiation. The radiation, which can be used during the exposure, is preferably ultraviolet rays such as a g-line, an h-line, or an i-line, and a light source is preferably a high-pressure mercury lamp. The irradiation intensity is preferably 5 to 1,500 $mJ/cm^2$ and more preferably 10 to 1,000 $mJ/cm^2$.

It is noted that in a case where the composition contains a thermal polymerization initiator, the composition layer may be heated in the exposure step. A heating temperature is not particularly limited; however, it is preferably 80°C to 250°C. In addition, a heating time is preferably 30 to 300 seconds.

It is noted that in a case where the composition layer is heated in the exposure step, the exposure step may serve as a post-heating step which will be described later. In other words, in a case where the composition layer is heated in the exposure step, the method for manufacturing a cured film may not include the post-heating step.

[Development step]

The development step is a step of developing the exposed composition layer to form a cured film. In this step, the composition layer of the portion which is not irradiated with light in the exposure step is eluted, only the photocured portion remains, and thus a patterned cured film can be obtained.
The kind of developer to be used in the development step is not particularly limited; however, an alkali developer which does not damage the underlying imaging element and circuit or the like is desirable.
The development temperature, for example, is 20°C to 30°C.
A development time is, for example, 20 to 90 seconds. In recent years, in order to more thoroughly remove residues, sometimes the development has been carried out for 120 to 180 seconds. Further, in order to further improve the residue removability, a step of shaking off the developer every 60 seconds and then supplying a new developer may be repeated several times.
The alkali developer is preferably an alkaline aqueous solution which is prepared by dissolving an alkaline compound in water so that the concentration thereof is 0.001% to 10% by mass (preferably 0.01% to 5% by mass).
Examples of the alkaline compounds include sodium hydroxide, potassium hydroxide, sodium carbonate, sodium silicate, sodium metasilicate, aqueous ammonia, ethylamine, diethylamine, dimethylethanolamine, tetramethylammonium hydroxide, tetraethylammonium hydroxide, tetrapropylammonium hydroxide, tetrabutylammonium hydroxide, benzyltrimethylammonium hydroxide, choline, pyrrole, piperidine, and 1,8-diazabicyclo[5.4.0]-7-undecene (among them, an organic alkali is preferable).
It is noted that in a case where an alkali developer is used, generally, a washing treatment using water is carried out after development.

[Post-baking]

A heating treatment (post-baking) is preferably carried out after the exposure step. The post-baking is a heating treatment after development to complete the curing. The heating temperature is preferably 240°C or lower, and more preferably 220°C or lower. The lower limit thereof is not particularly limited; however, it is preferably 50°C or higher and more preferably 100°C or higher, in consideration of an efficient and effective treatment.
The post-baking can be carried out continuously or batchwise by using heating units such as a hot plate, a convection oven (hot-air circulating dryer), and a high frequency heater.
It is preferable that the aforementioned post-baking be carried out in an atmosphere with a low oxygen concentration. The oxygen concentration is preferably 19% by volume or less, more preferably 15% by volume or less, still more preferably 10% by volume or less, particularly preferably 7% by volume or less, and most preferably 3% by volume or less. The lower limit thereof is not particularly limited; however, it is preferably 10 ppm by volume or more.
Instead of post-baking by heating described above, ultraviolet (UV) irradiation may be carried out to complete curing.
In this case, it is preferable that the composition further contains a UV curing agent. The UV curing agent is preferably a UV curing agent which can be cured at a wavelength shorter than 365 nm that is an exposure wavelength of a polymerization initiator added for a lithography step by ordinary i-line exposure. Examples of the UV curing agent include CIBA IRGACURE 2959 (product name). In a case where UV irradiation is carried out, it is preferable that the composition layer be a material that is cured at a wavelength of 340 nm or less. The lower limit value of the wavelength is not particularly limited; however, it is preferably 220 nm or more. In addition, an exposure amount of the UV irradiation is preferably 100 to 5,000 mJ, more preferably 300 to 4,000 mJ, and still more preferably 800 to 3,500 mJ. It is preferable that this UV curing step is carried out after the exposure step in order to carry out low temperature curing more effectively. As the exposure light source, it is preferable to use an ozoneless mercury lamp.

[Physical properties of cured film and application of cured film]

[Physical properties of cured film]

From the viewpoint that excellent light shielding properties are exhibited, in a cured film formed from the composition according to the embodiment of the present invention, an optical density (OD) per film thickness of 1.5 μm in a wavelength range of 400 to 1,100 nm is preferably equal to or higher than 2.5 and more preferably equal to or higher than 3.0. It is noted that the upper limit value thereof is not particularly limited, but is preferably 10 or less, in general. The cured film can be preferably used as a light shielding film.
It is noted that in the present specification, the expression that the optical density per film thickness of 1.5 μm in a wavelength range of 400 to 1,100 nm is equal to or higher than 2.5 means that an optical density per film thickness of 1.5 μm in the entire wavelength range of 400 to 1,100 nm is equal to or higher than 2.5.

It is noted that in the present specification, as a method for measuring the optical density of the cured film, a cured film is first formed on a glass substrate, measurement using an integrating sphere-type light-receiving unit of a spectrophotometer U-4100 (product name, manufactured by Hitachi High-Tech Corporation) is carried out, the film thickness at a measurement location is also measured, and an optical density per predetermined film thickness is calculated.

The film thickness of the cured film is, for example, preferably 0.1 to 4.0 μm and more preferably 1.0 to 2.5 μm. The cured film may be thinner or thicker than the above range depending on the application.

In addition, in a case where the cured film is used as a light attenuating film, the light shielding properties may be adjusted by making the cured film thinner (for example, 0.1 to 0.5 μm) than the above-described range. In this case, the optical density per film thickness of 1.0 μm in a wavelength range of 400 to 1,200 nm is preferably 0.1 to 1.5 and more preferably 0.2 to 1.0.

The reflectivity of the cured film is preferably lower than 8%, more preferably lower than 6%, and still more preferably lower than 4%. The lower limit thereof is preferably 0% or more.

The reflectivity is obtained from the reflectivity spectrum obtained by causing light having a wavelength of 400 to 1,100 nm to be incident at an incidence angle of 5° using a VAR unit of a spectrometer V7200 (product name) manufactured by JASCO Corporation. Specifically, the reflectivity of light having a wavelength which exhibits the maximum reflectivity in a wavelength range of 400 to 1,100 nm is taken as the reflectivity of the cured film.

In addition, the cured film is suitable for a light shielding member and a light shielding film as well as an antireflection member and an antireflection film of an optical filter and a module that are used in portable instruments such as a personal computer, a tablet PC, a mobile phone, a smartphone, and a digital camera; office automation (OA) instruments such as a printer composite machine and a scanner; industrial instruments such as a surveillance camera, a barcode reader, an automated teller machine (ATM), a high-speed camera, and an instrument having a personal authentication function using face image authentication or biometric authentication; in-vehicle camera instruments; medical camera instruments such as an endoscope, a capsule endoscope, and a catheter; and a biological sensor, a biosensor, a military reconnaissance camera, a camera for a three-dimensional map, a camera for observing weather and sea, a camera for a land resource exploration, and space instruments such as an exploration camera for the astronomy of the space and a deep space target.

The cured film can also be used in applications of a micro light emitting diode (LED), a micro organic light emitting diode (OLED), and the like. The cured film is suitable for an optical filter and an optical film used in the micro LED and the micro OLED and for a member which imparts a light shielding function or an antireflection function.

Examples of the micro LED and the micro OLED include the examples described in JP2015-500562A and JP2014-533890A.

The cured film is also suitable as an optical filter and an optical film used in a quantum dot sensor and a quantum dot solid-state imaging element. In addition, the cured film is suitable as a member which imparts a light shielding function or an antireflection function. Examples of the quantum dot sensor and the quantum dot solid-state imaging element include the examples described in US2012/37789A and WO2008/131313A.

[Light shielding film, optical element, solid-state imaging element, and solid-state imaging device]

It is also preferable that the cured film according to the embodiment of the present invention is used as a so-called light shielding film. It is also preferable that such a light shielding film is used in a solid-state imaging element.

As described above, the cured film formed from the light shielding composition according to the embodiment of the present invention has excellent light shielding properties and low reflection properties.

It is noted that the light shielding film is one of the preferable applications in the cured film according to the embodiment of the present invention, and the light shielding film according to the embodiment of the present invention can be manufactured in the same manner as the method for manufacturing a cured film. Specifically, a light shielding film can be manufactured by applying the composition to a substrate to form a composition layer and carrying out exposure and development on the composition layer.

The present invention also includes an invention of an optical element. The optical element according to the embodiment of the present invention is an optical element including the aforementioned cured film (light shielding film). Examples of the optical element include an optical element that is used in an optical instrument such as a camera, binoculars, a microscope, and a semiconductor exposure device.

Among them, as the optical element, for example, a solid-state imaging element mounted on a camera or the like is preferable.

In addition, the solid-state imaging element according to the embodiment of the present invention is a solid-state imaging element including the cured film (light shielding film) according to the embodiment of the present invention.

Examples of the form in which the solid-state imaging element according to the embodiment of the present invention includes the cured film (light shielding film) include a form in which a plurality of photodiodes and light-receiving elements consisting of polysilicon or the like, which configure a light-receiving area of a solid-state imaging element (a CCD image sensor, a CMOS image sensor, or the like), are provided on a substrate, and the cured film is provided on

a surface side (for example, a portion other than light-receiving parts and/or pixels for adjusting a color tone) of a support on which the light-receiving elements are formed or on a side opposite to the surface on which the light-receiving elements are formed.

In addition, in a case where the cured film is used as a light attenuating film, for example, by disposing the light attenuating film so that a part of light passes through the light attenuating film and then is incident on a light-receiving element, the dynamic range of the solid-state imaging element can be improved.

The solid-state imaging device is equipped with the aforementioned solid-state imaging element.

Examples of the configurations of the solid-state imaging device and the solid-state imaging element will be described with reference to Figs. 1 and 2. It is noted that in Figs. 1 and 2, in order to clearly show each part, some parts are magnified in disregard of a thickness ratio and/or a width ratio between the parts.

Fig. 1 is a schematic cross-sectional view showing an example of the configuration of the solid-state imaging device including the solid-state imaging element according to the embodiment of the present invention.

As shown in Fig. 1, a solid-state imaging device 100 includes a rectangular solid-state imaging element 101 and a transparent cover glass 103 which is held above the solid-state imaging element 101 and seals the solid-state imaging element 101. Further, on the cover glass 103, a lens layer 111 is superposably provided through a spacer 104. The lens layer 111 includes a support 113 and a lens material 112. The lens layer 111 may have a configuration in which the support 113 and the lens material 112 are integrally formed. In a case where stray light is incident on the peripheral edge region of the lens layer 111, due to the diffusion of light, an effect of light condensation on the lens material 112 is weakened, and thus the light reaching an imaging unit 102 is reduced. In addition, noise is also generated due to the stray light. Therefore, a light shielding film 114 is provided in the peripheral edge region of the lens layer 111 so that light is shielded. The cured film according to the embodiment of the present invention can also be used as the light shielding film 114.

The solid-state imaging element 101 carries out photoelectric conversion on an optical image formed on the imaging unit 102 serving as a light-receiving surface of the solid-state imaging element 101, and outputs the converted optical image as an image signal. The solid-state imaging element 101 includes a laminated substrate 105 obtained by laminating two sheets of substrates. The laminated substrate 105 consists of a chip substrate 106 and a circuit board 107 which have the same size and a rectangular shape, and the circuit board 107 is laminated on the rear surface of the chip substrate 106.

As a material of the substrate used as the chip substrate 106, for example, known materials can be used.

The imaging unit 102 is provided in the central part of the surface of the chip substrate 106. In addition, a light shielding film 115 is provided in the peripheral edge region of the imaging unit 102. By shielding stray light incident on the peripheral edge region by the light shielding film 115, the generation of a dark current (noise) from a circuit in the peripheral edge region can be prevented. The cured film according to the embodiment of the present invention is preferably used as the light shielding film 115.

A plurality of electrode pads 108 are provided at an edge part of the surface of the chip substrate 106. The electrode pads 108 are electrically connected to the imaging unit 102 through a signal line (a bonding wire can also be used) (not shown) provided on the surface of the chip substrate 106.

On the rear surface of the circuit board 107, external connection terminals 109 are provided at positions approximately below the electrode pads 108, respectively. The external connection terminals 109 are respectively connected to the electrode pads 108 through a through-electrode 110 vertically passing through the laminated substrate 105. In addition, the external connection terminals 109 are connected to a control circuit controlling the driving of the solid-state imaging element 101, an image processing circuit carrying out image processing on an imaging signal output from the solid-state imaging element 101, and the like through a wiring line (not shown).

Fig. 2 shows a schematic cross-sectional view of the imaging unit 102. As shown in Fig. 2, the imaging unit 102 includes the parts, such as a light-receiving element 201, a color filter 202, and a micro lens 203, provided on a substrate 204. The color filter 202 has a blue pixel 205b, a red pixel 205r, a green pixel 205g, and a black matrix 205bm. The cured film according to the embodiment of the present invention may be used as the black matrix 205bm.

As the material of the substrate 204, for example, the same material as that of the chip substrate 106 can be used. On the surface layer of the substrate 204, a p-well layer 206 is formed. In the p-well layer 206, the light-receiving elements 201, which consist of an n-type layer and generate and accumulate signal charges by photoelectric conversion, are formed to be arranged in the form of square grids.

On one lateral side of each light-receiving element 201, through a reading gate part 207 on the surface layer of the p-well layer 206, a vertical electric charge transfer path 208 consisting of an n-type layer is formed. In addition, on the other lateral side of each light-receiving element 201, through an element separation region 209 consisting of a p-type layer, a vertical electric charge transfer path 208 belonging to the adjacent pixel is formed. The reading gate part 207 is a channel region for the signal charges accumulated in the light-receiving element 201 to be read out toward the vertical electric charge transfer path 208.

On the surface of the substrate 204, a gate insulating film 210 consisting of an oxide-nitride-oxide (ONO) film

is formed. On the gate insulating film 210, vertical electric charge transfer electrodes 211 consisting of polysilicon or amorphous silicon are formed to cover the portions which are approximately immediately above the vertical electric charge transfer path 208, the reading gate part 207, and the element separation region 209. The vertical electric charge transfer electrode 211 functions as driving electrodes for driving the vertical electric charge transfer path 208 and carrying out charge transfer, and as reading electrodes for driving the reading gate part 207 and reading out signal charges. The signal charges are transferred to a horizontal electric charge transfer path and an output part (floating diffusion amplifier), which are not shown in the drawing, in this order from the vertical electric charge transfer path 208, and then output as voltage signals.

On the vertical electric charge transfer electrode 211, a light shielding film 212 is formed to cover the surface of the electrode. The light shielding film 212 has an opening portion at a position immediately above the light-receiving element 201 and shields a region other than the opening portion from light. The cured film according to the embodiment of the present invention may be used as the light shielding film 212.

On the light shielding film 212, a transparent interlayer, which consists of an insulating film 213 consisting of borophosphosilicate glass (BPSG), an insulating film (passivation film) 214 consisting of P-SiN, and a planarization film 215 consisting of a transparent resin or the like, is provided. The color filter 202 is formed on the interlayer.

[Image display device]

An image display device according to the embodiment of the present invention is equipped with the cured film according to the embodiment of the present invention.

Examples of the form in which the image display device includes a cured film include a form in which a cured film is contained in a black matrix and a color filter including such a black matrix is used in an image display device.

Next, a black matrix and a color filter including the black matrix will be described, and a liquid crystal display device including such a color filter will be described as a specific example of the image display device.

<Black matrix>

It is also preferable that the cured film according to the embodiment of the present invention is contained in the black matrix. The black matrix may be included in a color filter, a solid-state imaging element, and an image display device such as a liquid crystal display device in some cases.

Examples of the black matrix include those described above; a black rim provided in the peripheral edge part of an image display device such as a liquid crystal display device; a lattice-formed and/or stripe-like black portion between pixels of red, blue, and green; and a dot-like and/or linear black pattern for shielding a thin film transistor (TFT) from light. The definition of the black matrix is described in, for example, "Glossary of liquid crystal display manufacturing device", written by Yasuhira KANNO, 2nd edition, NIKKAN KOGYO SHIMBUN, LTD., 1996, p. 64.

In order to improve the display contrast, and to prevent image quality deterioration resulting from current leakage of light in a case of an active matrix driving-type liquid crystal display device using a thin film transistor (TFT), the black matrix preferably has high light shielding properties (the optical density OD is equal to or higher than 3).

As the method for manufacturing the black matrix, for example, the black matrix can be manufactured according to the same manner as the method for manufacturing the cured film. Specifically, a patterned cured film (a black matrix) can be manufactured by applying the composition onto a substrate to form a composition layer and carrying out exposure and development on the composition layer. It is noted that the film thickness of the cured film used as the black matrix is preferably 0.1 to 4.0 $\mu$m.

The material of the substrate preferably has a light transmittance equal to or greater than 80% for visible light (wavelength of 400 to 800 nm). Examples of such a material include: glass such as soda lime glass, alkali-free glass, quartz glass, and borosilicate glass; and plastic such as a polyester-based resin and a polyolefin-based resin, and from the viewpoints of chemical resistance and heat resistance, alkali-free glass, quartz glass, or the like is preferable.

<Color filter>

It is also preferable that the cured film according to the embodiment of the present invention is included in a color filter.

Examples of the form in which the color filter includes the cured film include a color filter comprising a substrate and the aforementioned black matrix. That is, examples thereof include a color filter comprising colored pixels of red, green, and blue which are formed in the opening portion of the black matrix formed on a substrate.

The color filter including a black matrix (cured film) can be manufactured, for example, according to the following method.

First, in an opening portion of a patterned black matrix formed on a substrate, a composition layer of a composition

containing each of pigments corresponding to the respective colored pixels of the color filter is formed. It is noted that as the composition for each color, for example, known compositions can be used, but in the composition described in the present specification, it is preferable that a composition in which the black coloring material is replaced with a colorant corresponding to each pixel is used.

Subsequently, the composition layer is subjected to exposure through a photo mask having a pattern corresponding to the opening portion of the black matrix. Next, colored pixels can be formed in the opening portion of the black matrix by removing a non-exposed portion by a development treatment, and then carrying out baking. In a case where the series of operations are carried out using, for example, a composition for each color containing each of red, green, and blue pigments, a color filter having red, green, and blue pixels can be manufactured.

<Liquid crystal display device>

It is also preferable that the cured film according to the embodiment of the present invention is included in a liquid crystal display device. Examples of the form in which the liquid crystal display device includes the cured film include a form in which a liquid crystal display device includes the color filter including the black matrix (cured film) described above.

Examples of the liquid crystal display device according to the present embodiment include a form in which a liquid crystal display device includes a pair of substrates disposed to face each other and a liquid crystal compound sealed in the space between the substrates. The substrates are as described above, for example, as the substrate for a black matrix.

Examples of the specific form of the liquid crystal display device include a laminate including polarizing plate/substrate/color filter/transparent electrode layer/alignment film/liquid crystal layer/alignment film/transparent electrode layer/thin film transistor (TFT) element/substrate/polarizing plate/backlight unit in this order from the user side.

It is noted that examples of the liquid crystal display device include the liquid crystal display devices described in "Electronic display device (written by Akio SASAKI, Kogyo Chosakai Publishing Co., Ltd., published in 1990)", "Display device (written by Sumiaki IBUKI, Sangyo Tosho Publishing Co., Ltd., published in 1989)", or the like. In addition, examples thereof include the liquid crystal display device described in "Next-Generation Liquid Crystal Display Technology (edited by Tatsuo UCHIDA, Kogyo Chosakai Publishing Co., Ltd., published in 1994)".

[Infrared sensor]

It is also preferable that the cured film according to the embodiment of the present invention is included in an infrared sensor.

The infrared sensor according to the embodiment will be described with reference to Fig. 3. Fig. 3 is a schematic cross-sectional view showing an example of the configuration of an infrared sensor comprising the cured film according to the embodiment of the present invention. An infrared sensor 300 shown in Fig. 3 includes a solid-state imaging element 310.

An imaging region provided on the solid-state imaging element 310 is constituted with a combination of an infrared absorption filter 311 and a color filter 312 according to the embodiment of the present invention.

The infrared absorption filter 311 is a film which transmits light (for example, light having wavelengths of 400 to 700 nm) in the visible light range and shields light (for example, light having wavelengths of 800 to 1,300 nm, preferably light having wavelengths of 900 to 1,200 nm, and more preferably light having wavelengths of 900 to 1,000 nm) in the infrared range, and a cured film containing an infrared absorber (the form of the infrared absorber is as described above) as a colorant can be used.

The color filter 312 is a color filter in which pixels transmitting or absorbing light having a specific wavelength in the visible light range are formed, a color filter in which pixels of red (R), green (G), and blue (B) are formed, or the like is used as an example of the color filter, and the aspect thereof is as described above.

Between an infrared transmitting filter 313 and the solid-state imaging element 310, a resin film 314 (for example, a transparent resin film or the like), which is capable of transmitting light having the wavelength transmitted through the infrared transmitting filter 313, is disposed.

The infrared transmitting filter 313 is a filter which has visible light shielding properties and transmits infrared rays having a specific wavelength, and the cured film according to the embodiment of the present invention can be used, which contains a colorant (for example, a perylene compound and/or a bisbenzofuranone compound) absorbing light in a visible light range, and an infrared absorber (for example, a pyrrolo pyrrole compound, a phthalocyanine compound, a naphthalocyanine compound, a polymethine compound, and the like). It is preferable that the infrared transmitting filter 313 shields light having wavelengths of 400 to 830 nm and transmits light having wavelengths of 900 to 1,300 nm, for example.

On an incidence ray hv side of the color filter 312 and the infrared transmitting filter 313, micro lenses 315 are arranged. A planarization film 316 is formed to cover the micro lenses 315.

In the form shown in Fig. 3, although the resin film 314 is disposed, the infrared transmitting filter 313 may be formed instead of the resin film 314. That is, on the solid-state imaging element 310, the infrared transmitting filter 313 may be formed.

In addition, in the form shown in Fig. 3, the film thickness of the color filter 312 is the same as the film thickness of the infrared transmitting filter 313, but both the film thicknesses may be different from each other.

In addition, in the form shown in Fig. 3, the color filter 312 is provided to be closer to the incidence ray hv side than the infrared absorption filter 311, but the order of the infrared absorption filter 311 and the color filter 312 may be switched so that the infrared absorption filter 311 is provided to be closer to the incidence ray hv side than the color filter 312.

In addition, in the aspect shown in Fig. 3, the infrared absorption filter 311 and the color filter 312 are laminated to be adjacent to each other, but both the filters are not necessarily adjacent to each other, and another layer may be provided between the filters. The cured film according to the embodiment of the present invention can be used as a light shielding film on an end part of the surface and/or a lateral surface of the infrared absorption filter 311, and, by being used as a device interior wall of an infrared sensor, can prevent internal reflection and/or unintended incidence of light on the light-receiving part and can improve sensitivity.

According to the infrared sensor, image information can be simultaneously taken in, and thus motion sensing or the like by which a subject whose movement is to be detected is recognized can be carried out. In addition, according to the infrared sensor, distance information can be obtained, and thus images including 3D information and the like can also be captured. Further, the infrared sensor can also be used as a biometric authentication sensor.

Next, a solid-state imaging device to which the above-described infrared sensor is applied will be described.

The solid-state imaging device includes a lens optical system, a solid-state imaging element, an infrared light emitting diode, and the like. It is noted that regarding each of the configurations of the solid-state imaging device, reference can be made to paragraphs 0032 to 0036 of JP2011-233983A, the contents of which are incorporated into the specification of the present application.

[Headlight unit]

It is also preferable that the cured film according to the embodiment of the present invention is included, as the light shielding film, in a headlight unit of a lighting tool for a vehicle such as an automobile. The cured film according to the embodiment of the present invention, which is included in the headlight unit as the light shielding film, is preferably formed in a patterned manner to shield at least a part of light emitted from a light source.

The headlight unit according to the embodiment will be described with reference to Figs. 4 and 5. Fig. 4 is a schematic view showing an example of the configuration of the headlight unit, and Fig. 5 is a schematic perspective view showing an example of the configuration of a light shielding unit of the headlight unit.

As shown in Fig. 4, a headlight unit 10 includes a light source 12, a light shielding unit 14, and a lens 16, and the light source 12, the light shielding unit 14, and the lens 16 are arranged in this order.

As shown in Fig. 5, the light shielding unit 14 has a base body 20 and a light shielding film 22.

In the light shielding film 22, a patterned opening portion 23 for radiating light emitted from the light source 12 into a specific shape is formed. A light distribution pattern radiated from the lens 16 is determined by the shape of the opening portion 23 of the light shielding film 22. The lens 16 projects light L from the light source 12, which has passed through the light shielding unit 14. In a case where a specific light distribution pattern can be radiated from the light source 12, the lens 16 is not necessarily required. The lens 16 is appropriately determined according to an irradiation distance and an irradiation range of the light L.

In addition, a configuration of the base body 20 is not particularly limited as long as the base body 20 can hold the light shielding film 22; however, the base body 20 is preferably not deformed by the heat of the light source 12 and is made of, for example, glass.

An example of the light distribution pattern is shown in Fig. 5; however, the present invention is not limited to the example.

In addition, the number of the light sources 12 is also not limited to one, and for example, the light sources may be disposed in a row or may be disposed in a matrix. In a case where a plurality of light sources are provided, for example, one light shielding unit 14 may be provided for one light source 12. In this case, the respective light shielding films 22 of a plurality of light shielding units 14 may all have the same pattern or may have different patterns.

The light distribution pattern based on the pattern of the light shielding film 22 will be described.

Fig. 6 is a schematic view showing an example of the light distribution pattern formed by the headlight unit, and Fig. 7 is a schematic view showing another example of the light distribution pattern formed by the headlight unit. It is noted that a light distribution pattern 30 shown in Fig. 6 and a light distribution pattern 32 shown in Fig. 7 both indicate a region irradiated with light. In addition, a region 31 shown in Fig. 6 and a region 31 shown in Fig. 7 both indicate an irradiation region irradiated by the light source 12 (see Fig. 4) in a case where the light shielding film 22 is not provided.

Due to the pattern of the light shielding film 22, the intensity of light is sharply reduced at an edge 30a, for example, as in the light distribution pattern 30 shown in Fig. 6. The light distribution pattern 30 shown in Fig. 6 is, for example, a pattern in which light is not flashed at an oncoming vehicle in a case of left-side traveling.

In addition, as in the light distribution pattern 32 shown in Fig. 7, a pattern in which a part of the light distribution pattern 30 shown in Fig. 6 is notched can also be used. In this case as well, similar to the light distribution pattern 30 shown in Fig. 6, the intensity of light is sharply reduced at an edge 32a, and the pattern is, for example, a pattern in which light is not flashed at an oncoming vehicle in a case of left-side traveling. Further, the intensity of light is sharply reduced even at a notched portion 33. Therefore, in a region corresponding to the notched portion 33, a mark indicating a state where the road is curved, inclined upward, inclined downward, or the like can be displayed. This makes it possible to improve the safety during night-time traveling.

It is noted that the light shielding unit 14 is not limited to being fixedly disposed between the light source 12 and the lens 16, and a configuration in which the light shielding unit 14 is allowed to enter between the light source 12 and the lens 16, if necessary, by a driving mechanism (not shown) to obtain a specific light distribution pattern may be adopted.

In addition, in the light shielding unit 14, a shade member capable of shielding the light from the light source 12 may be formed. In this case, a configuration in which the shade member is allowed to enter between the light source 12 and the lens 16, as needed, by the driving mechanism (not shown) to obtain a specific light distribution pattern may be adopted.

Examples

Hereinafter, the present invention will be described in more detail based on Examples. The materials, amounts of use, proportions, treatments, procedures, and the like described in the following Examples can be appropriately modified as long as the gist of the present invention is maintained. Accordingly, the scope of the present invention will not be restrictively interpreted by the following Examples.

[Production of coloring material dispersion liquid]

[Production of coloring material dispersion liquid AA1]

100 g of titanium oxide MT-150A (product name: manufactured by TAYCA) having an average particle diameter of 15 nm, 25 g of silica particles AEROGII, (registered trademark) 300/30 (manufactured by Evonik Industries AG) having a BET surface area of 300 $m^2$/g, and 100 g of dispersant Disperbyk 190 (product name: manufactured by BYK JAPAN KK) were weighed, 71 g of ion electrical exchange water was added thereto, and the resultant was treated for 20 minutes at a revolution speed of 1,360 rpm and a rotation speed of 1,047 rpm by using MAZERSTAR KK-400W manufactured by KURABO INDUSTRIES LTD. to obtain a homogeneous mixture aqueous solution. A quartz container was filled with the aqueous solution and heated to 920°C in an oxygen atmosphere by using a small rotary kiln (manufactured by MOTOYAMA CO., LTD.), and then the atmosphere was replaced with nitrogen and an ammonia gas was allowed to flow at 100 mL/min for 5 hours at the same temperature, whereby a nitriding reduction treatment was carried out. After finishing the nitriding reduction treatment, the recovered powder was pulverized in a mortar, thereby obtaining a powder-shaped titanium black (a-1) [a substance to be dispersed containing titanium black particles and Si atoms] containing Si atoms and having a specific surface area of 73 $m^2$/g.

A resin X-1 (7.5 parts by mass) and S-1 (0.13 parts by mass) as an evaluation compound were added to the titanium black (a-1) (25 parts by mass) prepared above, and further, propylene glycol monomethyl ether acetate (PGMEA) and cyclopentanone were added thereto at a ratio (mass ratio) of 74.6:25.4 so that the total liquid amount was 100 parts by mass, thereby obtaining a dispersion.

The obtained dispersion was sufficiently stirred with a stirrer to carry out pre-mixing. The obtained dispersion was subjected to a dispersion treatment under the following conditions using NPM Pilot (a beads mill) manufactured by SHINMARU ENTERPRISES CORPORATION, thereby obtaining a coloring material dispersion liquid AA1.

(Dispersion conditions)

- · Bead diameter: φ 0.05 mm
- · Bead filling rate: 65% by volume
- · Circumferential speed of mill: 10 m/sec
- · Circumferential speed of separator: 11 m/s

· Amount of mixed solution subjected to dispersion treatment: 15.0 kg
· Circulation flow rate (pump supply rate): 60 kg/hour
· Temperature of treatment liquid: 20°C to 25°C
· Cooling water: Tap water of 5°C
· Inner volume of annular passage of beads mill: 2.2 L
· Number of passes: 84 passes

X-1 (a resin) and S-1 (an evaluation compound) used in the production of the coloring material dispersion liquid AA1 are as follows.
It is noted that in the subsequent coloring material adjusting liquid, X-1 and S-1 are the same compounds.
· S-1: A compound having a structure shown below

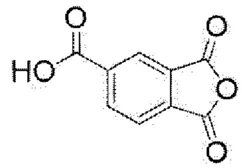

· Resin X-1: A resin having a structure shown below (corresponding to a resin having a graft chain, weight-average molecular weight: 18,000, acid value: 67 mgKOH/g, ethylenically unsaturated bond equivalent: 0.4 mmol/g).

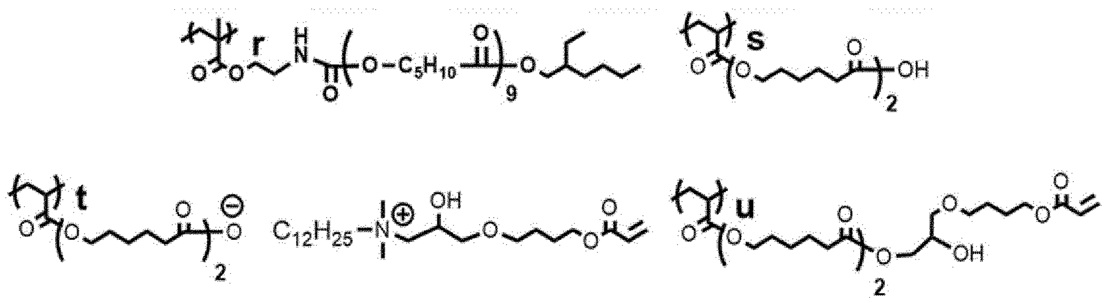

r / s / t / u = 15.1 / 59.0 /6.8 /19.1 (mol%)

Each of other coloring material dispersion liquids containing titanium black (TiBk) was also produced in the same manner, except that with reference to the production method of the coloring material dispersion liquid AA1, various requirements such as the average particle diameter of titanium black, the presence or absence of the evaluation compound, the kind of the evaluation compound, the amount of the evaluation compound, and the amount of the resin were changes as shown in Tables 1 to 5.
It is noted that "Average particle diameter (nm)" in Tables 1 to 5 indicates the average particle diameter of the titanium black in the coloring material dispersion liquid.

[Preparation of coloring material dispersion liquid BA1]

Carbon black was produced by a general oil furnace method. However, ethylene bottom oil having a small amount of Na, a small amount of Ca, and a small amount of S was used as a raw material oil, and combustion was carried out using a gas fuel. Further, pure water treated with an ion exchange resin was used as the reaction stop water.
The obtained carbon black (540 g) was stirred together with pure water (14,500 g) using a HOMO MIXER at 5,000 to 6,000 rpm for 30 minutes to obtain a slurry. The slurry was transferred to a container with a screw-type stirrer, and toluene (600 g) in which an epoxy resin "EPIKOTE 828" (manufactured by Japan Epoxy Resins Co., Ltd.) (60 g) was dissolved was added little by little while carrying out mixing at about 1,000 rpm. In about 15 minutes, the total amount of the carbon black dispersed in water was transferred to the toluene side, thereby forming grains of about 1 mm.
Next, draining was carried out with a wire mesh having 60 meshes, and then the separated grains were placed in a vacuum dryer and dried at 70°C for 7 hours to remove toluene and water, thereby obtaining coated carbon black. The resin-coating amount of the obtained coated carbon black was 10% by mass with respect to the total amount of the carbon black and the resin.

It is noted that the obtained carbon black (coated carbon black) was pulverized and then used for preparing a coloring material dispersion liquid. The average particle diameter of the carbon black (coated carbon black) after pulverization was 120 nm.

The resin X-1 (7.5 parts by mass), S-1 (0.13 parts by mass) as an evaluation compound, and S12000 (manufactured by Lubrizol Corporation) (1 part by mass) as a pigment derivative were added to the coated carbon black (25 parts by mass) prepared above, and further, propylene glycol monomethyl ether acetate (PGMEA) and cyclopentanone was added thereto at a ratio (mass ratio) of 74.6:25.4 so that the total liquid amount was 100 parts by mass, thereby obtaining a dispersion.

The obtained dispersion was sufficiently stirred with a stirrer to carry out pre-mixing. Further, the dispersion was subjected to a dispersion treatment using ULTRA APEX MILL UAM015 (a beads mill) manufactured by KOTOBUKI KOGYOU Co., Ltd. under the following conditions to obtain a dispersion composition. After the completion of the dispersion, the beads and the dispersion liquid were separated with a filter to prepare a coloring material dispersion liquid BA1.

(Dispersion conditions)

- · Bead diameter: φ 0.05 mm
- · Bead filling rate: 75% by volume
- · Circumferential speed of mill: 8 m/sec
- · Amount of mixed solution subjected to dispersion treatment: 500 g
- · Circulation flow rate (pump supply rate): 13 kg/hour
- · Temperature of treatment liquid: 25°C to 30°C
- · Cooling water: tap water
- · Inner volume of annular passage of beads mill: 0.15 L
- · Number of passes: 90 passes

Each of other coloring material dispersion liquids containing carbon black (the coated carbon black described above) was also produced in the same manner, except that with reference to the production method of the coloring material dispersion liquid BA1, various requirements such as the average particle diameter of carbon black, the presence or absence of the evaluation compound, the kind of the evaluation compound, the amount of the evaluation compound, and the amount of the resin were changes as shown in Tables 6 to 10.

It is noted that "Average particle diameter (nm)" in Tables 6 to 10 indicates the average particle diameter of the carbon black in the coloring material dispersion liquid.

[Preparation of coloring material dispersion liquid CA1]

To organic black Irgaphor Black S0100CF (manufactured by BASF SE, average particle diameter: 90 nm) (25 parts by mass), S-1 (0.12 parts by mass) as an evaluation compound and SOLSPERSE 20000 (manufactured by Lubrizol Corporation) (7. 5 parts by mass) as a resin, and 3-methoxybutyl acetate (hereinafter, "MBA") were added so that the total liquid amount was 100 parts by mass, and the resultant mixture was mixed and stirred with a HOMO MIXER (manufactured by PRIMIX Corporation) for 20 minutes to obtain a predispersion liquid. The obtained predispersion liquid was supplied to ULTRA APEX MILL (a beads mill manufactured by KOTOBUKI KOGYOU Co., Ltd.) equipped with a centrifuge separator filled up to 75% with 0.30 mmφ zirconia beads (YTZ ball; manufactured by Neturen Co., Ltd.), and dispersion was carried out at a rotation speed of 8 m/s for 3 hours to obtain a coloring material dispersion liquid CA1 having a concentration of solid contents of 32.6% by mass. It is noted that the resin SOLSPERSE 20000 has an amine value of 29 mgKOH/g, has no acid value, and has a tertiary amine as a pigment adsorbing group. The SP value of the MBA is 8.7.

Each of other coloring material dispersion liquids containing organic black (Irgaphor Black S0100CF) was also produced in the same manner, except that with reference to the production method of the coloring material dispersion liquid CA1, various requirements such as the average particle diameter of organic black, the presence or absence of the evaluation compound, the kind of the evaluation compound, the amount of the evaluation compound, and the amount of the resin were changes as shown in Tables 11 to 15.

It is noted that "Average particle diameter (nm)" in Tables 11 to 15 indicates the average particle diameter of the organic black in the coloring material dispersion liquid.

[Preparation of coloring material dispersion liquid DA1]

A resin DISPERBYK-2159 (manufactured by BYK JAPAN KK, 7.5 parts by mass) and S-1 (0.13 parts by mass) as an evaluation compound were added to zirconium oxynitride (manufactured by Mitsubishi Materials Corporation, powder-shaped, specific surface area: 65 $m^2/g$) (25 parts by mass), and further, propylene glycol monomethyl ether acetate (PGMEA) and cyclopentanone were added thereto at a ratio (mass ratio) of 74.6:25.4 so that the total amount was 100 parts by mass, thereby obtaining a dispersion. The obtained dispersion was sufficiently stirred with a stirrer to carry out pre-mixing. The obtained dispersion was subjected to a dispersion treatment under the following conditions using NPM Pilot (a beads mill) manufactured by SHINMARU ENTERPRISES CORPORATION, thereby obtaining a coloring material dispersion liquid DA1.

(Dispersion conditions)

- · Bead diameter: φ 0.05 mm
- · Bead filling rate: 65% by volume
- · Circumferential speed of mill: 10 m/sec
- · Circumferential speed of separator: 11 m/s
- · Amount of mixed solution subjected to dispersion treatment: 15.0 kg
- · Circulation flow rate (pump supply rate): 60 kg/hour
- · Temperature of treatment liquid: 20°C to 25°C
- · Cooling water: Tap water of 5°C
- · Inner volume of annular passage of beads mill: 2.2 L
- · Number of passes: 84 passes

Each of other coloring material dispersion liquids containing zirconium oxynitride was also produced in the same manner, except that with reference to the production method of the coloring material dispersion liquid DA1, various requirements such as the average particle diameter of zirconium oxynitride, the presence or absence of the evaluation compound, the kind of the evaluation compound, the amount of the evaluation compound, and the amount of the resin were changes as shown in Tables 16 to 20.

It is noted that "Average particle diameter (nm)" in Tables 16 to 20 indicates the average particle diameter of the zirconium oxynitride in the coloring material dispersion liquid.

[Preparation of coloring material dispersion liquid EA1]

A resin X-2 (7.5 parts by mass) and S-1 (0.13 parts by mass) as an evaluation compound were added to the titanium black (a-1) (25 parts by mass), and further, propylene glycol monomethyl ether acetate (PGMEA) and cyclopentanone were added thereto at a ratio (mass ratio) of 74.6:25.4 so that the total liquid amount was 100 parts by mass, thereby obtaining a dispersion. The obtained dispersion was sufficiently stirred with a stirrer to carry out pre-mixing. The obtained dispersion was subjected to a dispersion treatment under the following conditions using NPM Pilot (a beads mill) manufactured by SHINMARU ENTERPRISES CORPORATION, thereby obtaining a coloring material dispersion liquid EA1.

(Dispersion conditions)

- · Bead diameter: φ 0.05 mm
- · Bead filling rate: 65% by volume
- · Circumferential speed of mill: 10 m/sec
- · Circumferential speed of separator: 11 m/s
- · Amount of mixed solution subjected to dispersion treatment: 15.0 kg
- · Circulation flow rate (pump supply rate): 60 kg/hour
- · Temperature of treatment liquid: 20°C to 25°C
- · Cooling water: Tap water of 5°C
- · Inner volume of annular passage of beads mill: 2.2 L
- · Number of passes: 84 passes

Resin X-2 (hereinafter, structural formula)

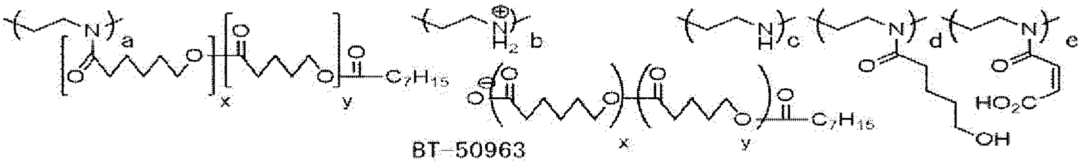

BT-50963

a/b/c/d/e=36/4/35/1/24 (mol%)
x=48 y=12

Each of other coloring material dispersion liquids containing titanium black (TiBk) was also produced in the same manner, except that with reference to the production method of the coloring material dispersion liquid EA1, various requirements such as the average particle diameter of titanium black, the presence or absence of the evaluation compound, the kind of the evaluation compound, the amount of the evaluation compound, and the amount of the resin were changes as shown in Tables 21 to 25.

It is noted that "Average particle diameter (nm)" in Tables 21 to 25 indicates the average particle diameter of the titanium black in the coloring material dispersion liquid.

[Formulation of coloring material dispersion liquid]

The following table shows the formulation of each coloring material dispersion liquid.

The formulation of the composition in the table indicates the adding amount (in terms of parts by mass) of each component.

It is noted that in the table below, TiBK means titanium black. The average particle diameter of the black pigment contained in each coloring material dispersion liquid is as shown in the column of "Average particle diameter (nm)" in the table.

In addition, the column of "Evaluation compound (specific compound or comparative compound)" indicates the kind and the formulation amount (in terms of parts by mass) of the evaluation compound used.

[Table 1]

| | | AA1 | AA2 | AA3 | AA4 | AA5 | AA6 |
|---|---|---|---|---|---|---|---|
| Solvent | PGMEA | 50.26 | 50.04 | 48.80 | 47.28 | 50.04 | 47.28 |
| | Cyclopentanone | 17.11 | 17.04 | 16.62 | 16.10 | 17.04 | 16.10 |
| Resin | X-1 | 7.50 | 7.50 | 7.50 | 7.50 | 7.50 | 7.50 |
| Black pigment | TiBk | 25.00 | 25.00 | 25.00 | 25.00 | 25.00 | 25.00 |
| Evaluation compound (specific compound or comparative compound) | Kind | S-1 | S-1 | S-1 | S-1 | S-2 | S-2 |
| | Formulation amount | 0.13 | 0.42 | 2.08 | 4.12 | 0.42 | 4.12 |
| Coloring material dispersion liquid | Average particle diameter (nm) | 90 | 92 | 85 | 90 | 88 | 87 |

[Table 2]

| | | AA7 | AA8 | AA9 | AA10 | AA11 | AA12 |
|---|---|---|---|---|---|---|---|
| Solvent | PGMEA | 48.80 | 48.80 | 48.80 | 48.80 | 48.80 | 48.80 |
| | Cyclopentanone | 16.62 | 16.62 | 16.62 | 16.62 | 16.62 | 16.62 |
| Resin | X-1 | 7.50 | 7.50 | 7.50 | 7.50 | 7.50 | 7.50 |
| Black pigment | TiBk | 25.00 | 25.00 | 25.00 | 25.00 | 25.00 | 25.00 |

(continued)

| | | AA7 | AA8 | AA9 | AA10 | AA11 | AA12 |
|---|---|---|---|---|---|---|---|
| Evaluation compound (specific compound or comparative compound) | Kind | S-3 | S-4 | S-5 | S-6 | S-7 | S-8 |
| | Formulation amount | 2.08 | 2.08 | 2.08 | 2.08 | 2.08 | 2.08 |
| Coloring material dispersion liquid | Average particle diameter (nm) | 83 | 92 | 93 | 90 | 89 | 88 |

[Table 3]

| | | AA13 | AA14 | AA15 | AA16 | AA17 | AA18 |
|---|---|---|---|---|---|---|---|
| Solvent | PGMEA | 48.80 | 48.80 | 48.80 | 48.80 | 48.80 | 48.80 |
| | Cyclopentanone | 16.62 | 16.62 | 16.62 | 16.62 | 16.62 | 16.62 |
| Resin | X-1 | 7.50 | 7.50 | 7.50 | 7.50 | 7.50 | 7.50 |
| Black pigment | TiBk | 25.00 | 25.00 | 25.00 | 25.00 | 25.00 | 25.00 |
| Evaluation compound (specific compound or comparative compound) | Kind | S-9 | S-10 | S-11 | S-12 | S-13 | S-15 |
| | Formulation amount | 2.08 | 2.08 | 2.08 | 2.08 | 2.08 | 2.08 |
| Coloring material dispersion liquid | Average particle diameter (nm) | 87 | 86 | 94 | 93 | 99 | 94 |

[Table 4]

| | | AA19 | AA20 | AA21 | AA22 | AA23 | AA24 |
|---|---|---|---|---|---|---|---|
| Solvent | PGMEA | 48.80 | 48.80 | 48.80 | 48.80 | 48.80 | 50.36 |
| | Cyclopentanone | 16.62 | 16.62 | 16.62 | 16.62 | 16.62 | 17.15 |
| Resin | X-1 | 7.50 | 7.50 | 7.50 | 7.50 | 7.50 | 6.70 |
| Black pigment | TiBk | 25.00 | 25.00 | 25.00 | 25.00 | 25.00 | 25.00 |
| Evaluation compound (specific compound or comparative compound) | Kind | S-16 | S-17 | S-18 | S-19 | S-20 | S-1 |
| | Formulation amount | 2.08 | 2.08 | 2.08 | 2.08 | 2.08 | 0.79 |
| Coloring material dispersion liquid | Average particle diameter (nm) | 93 | 99 | 93 | 99 | 99 | 87 |

[Table 5]

| | | AA25 | AB1 | AB2 | AB3 | AB4 | AB5 |
|---|---|---|---|---|---|---|---|
| Solvent | PGMEA | 50.40 | 50.36 | 50.32 | 46.94 | 48.75 | 48.75 |
| | Cyclopentanone | 17.15 | 17.15 | 17.13 | 15.98 | 16.60 | 16.60 |
| Resin | X-1 | 6.05 | 7.50 | 7.50 | 7.50 | 7.50 | 7.50 |
| Black pigment | TiBk | 25.00 | 25.00 | 25.00 | 25.00 | 25.00 | 25.00 |
| Evaluation compound (specific compound or comparative compound) | Kind | S-1 | | S-1 | S-1 | S-1 | S-14 |
| | Formulation amount | 1.40 | | 0.04 | 4.58 | 2.15 | 2.15 |

(continued)

| | | AA25 | AB1 | AB2 | AB3 | AB4 | AB5 |
|---|---|---|---|---|---|---|---|
| Coloring material dispersion liquid | Average particle diameter (nm) | 85 | 90 | 90 | 101 | 280 | 98 |

[Table 6]

| | | BA1 | BA2 | BA3 | BA4 | BA5 | BA6 |
|---|---|---|---|---|---|---|---|
| Solvent | PGMEA | 49.52 | 49.30 | 48.06 | 46.53 | 49.30 | 46.53 |
| | Cyclopentanone | 16.86 | 16.79 | 16.36 | 15.84 | 16.79 | 15.84 |
| Resin | X-1 | 7.50 | 7.50 | 7.50 | 7.50 | 7.50 | 7.50 |
| Pigment derivative | S12000 | 1.00 | 1.00 | 1.00 | 1.00 | 1.00 | 1.00 |
| Black pigment | Coated carbon black | 25.00 | 25.00 | 25.00 | 25.00 | 25.00 | 25.00 |
| Evaluation compound (specific compound or comparative compound) | Kind | S-1 | S-1 | S-1 | S-1 | S-2 | S-2 |
| | Formulation amount | 0.13 | 0.42 | 2.08 | 4.12 | 0.42 | 4.12 |
| Coloring material dispersion liquid | Average particle diameter (nm) | 100 | 102 | 101 | 99 | 95 | 98 |

[Table 7]

| | | BA7 | BA8 | BA9 | BA10 | BA11 | BA12 |
|---|---|---|---|---|---|---|---|
| Solvent | PGMEA | 48.06 | 48.06 | 48.06 | 48.06 | 48.06 | 48.06 |
| | Cyclopentanone | 16.36 | 16.36 | 16.36 | 16.36 | 16.36 | 16.36 |
| Resin | X-1 | 7.50 | 7.50 | 7.50 | 7.50 | 7.50 | 7.50 |
| Pigment derivative | S12000 | 1.00 | 1.00 | 1.00 | 1.00 | 1.00 | 1.00 |
| Black pigment | Coated carbon black | 25.00 | 25.00 | 25.00 | 25.00 | 25.00 | 25.00 |
| Evaluation compound (specific compound or comparative compound) | Kind | S-3 | S-4 | S-5 | S-6 | S-7 | S-8 |
| | Formulation amount | 2.08 | 2.08 | 2.08 | 2.08 | 2.08 | 2.08 |
| Coloring material dispersion liquid | Average particle diameter (nm) | 93 | 99 | 99 | 100 | 100 | 102 |

[Table 8]

| | | BA13 | BA14 | BA15 | BA16 | BA17 | BA18 |
|---|---|---|---|---|---|---|---|
| Solvent | PGMEA | 48.06 | 48.06 | 48.06 | 48.06 | 48.06 | 48.06 |
| | Cyclopentanone | 16.36 | 16.36 | 16.36 | 16.36 | 16.36 | 16.36 |
| Resin | X-1 | 7.50 | 7.50 | 7.50 | 7.50 | 7.50 | 7.50 |
| Pigment derivative | S12000 | 1.00 | 1.00 | 1.00 | 1.00 | 1.00 | 1.00 |
| Black pigment | Coated carbon black | 25.00 | 25.00 | 25.00 | 25.00 | 25.00 | 25.00 |
| Evaluation compound (specific compound or comparative compound) | Kind | S-9 | S-10 | S-11 | S-12 | S-13 | S-15 |
| | Formulation amount | 2.08 | 2.08 | 2.08 | 2.08 | 2.08 | 2.08 |

(continued)

| | | BA13 | BA14 | BA15 | BA16 | BA17 | BA18 |
|---|---|---|---|---|---|---|---|
| Coloring material dispersion liquid | Average particle diameter (nm) | 105 | 120 | 110 | 103 | 108 | 110 |

[Table 9]

| | | BA19 | BA20 | BA21 | BA22 | BA23 |
|---|---|---|---|---|---|---|
| Solvent | PGMEA | 48.06 | 48.06 | 48.06 | 48.06 | 48.06 |
| | Cyclopentanone | 16.36 | 16.36 | 16.36 | 16.36 | 16.36 |
| Resin | X-1 | 7.50 | 7.50 | 7.50 | 7.50 | 7.50 |
| Pigment derivative | S12000 | 1.00 | 1.00 | 1.00 | 1.00 | 1.00 |
| Black pigment | Coated carbon black | 25.00 | 25.00 | 25.00 | 25.00 | 25.00 |
| Evaluation compound (specific compound or comparative compound) | Kind | S-16 | S-17 | S-18 | S-19 | S-20 |
| | Formulation amount | 2.08 | 2.08 | 2.08 | 2.08 | 2.08 |
| Coloring material dispersion liquid | Average particle diameter (nm) | 103 | 108 | 103 | 108 | 103 |

[Table 10]

| | | BB1 | BB2 |
|---|---|---|---|
| Solvent | PGMEA | 49.61 | 48.06 |
| | Cyclopentanone | 16.89 | 16.36 |
| Resin | X-1 | 7.50 | 7.50 |
| Pigment derivative | S12000 | 1.00 | 1.00 |
| Black pigment | Coated carbon black | 25.00 | 25.00 |
| Evaluation compound (specific compound or comparative compound) | Kind | | S-1 |
| | Formulation amount | | 2.08 |
| Coloring material dispersion liquid | Average particle diameter (nm) | 103 | 280 |

[Table 11]

| | | CA1 | CA2 | CA3 | CA4 | CA5 | CA6 |
|---|---|---|---|---|---|---|---|
| Solvent | MBA | 67.38 | 67.08 | 65.42 | 63.38 | 67.08 | 62.95 |
| Resin | SOLSPERSE 20000 | 7.50 | 7.50 | 7.50 | 7.50 | 7.50 | 7.50 |
| Black pigment | Organic black | 25.00 | 25.00 | 25.00 | 25.00 | 25.00 | 25.00 |
| Evaluation compound (specific compound or comparative compound) | Kind | S-1 | S-1 | S-1 | S-1 | S-2 | S-2 |
| | Formulation amount | 0.13 | 0.42 | 2.08 | 4.12 | 0.42 | 4.55 |
| Coloring material dispersion liquid | Average particle diameter (nm) | 90 | 91 | 99 | 90 | 95 | 91 |

[Table 12]

| | | CA7 | CA8 | CA9 | CA10 | CA11 | CA12 |
|---|---|---|---|---|---|---|---|
| Solvent | MBA | 65.42 | 65.42 | 65.42 | 65.42 | 65.42 | 65.42 |
| Resin | SOLSPERSE 20000 | 7.50 | 7.50 | 7.50 | 7.50 | 7.50 | 7.50 |
| Black pigment | Organic black | 25.00 | 25.00 | 25.00 | 25.00 | 25.00 | 25.00 |
| Evaluation compound (specific compound or comparative compound) | Kind | S-3 | S-4 | S-5 | S-6 | S-7 | S-8 |
| | Formulation amount | 2.08 | 2.08 | 2.08 | 2.08 | 2.08 | 2.08 |
| Coloring material dispersion liquid | Average particle diameter (nm) | 92 | 92 | 93 | 90 | 98 | 100 |

[Table 13]

| | | CA13 | CA14 | CA15 | CA16 | CA17 | CA18 |
|---|---|---|---|---|---|---|---|
| Solvent | MBA | 65.42 | 65.42 | 65.42 | 65.42 | 65.42 | 65.42 |
| Resin | SOLSPERSE 20000 | 7.50 | 7.50 | 7.50 | 7.50 | 7.50 | 7.50 |
| Black pigment | Organic black | 25.00 | 25.00 | 25.00 | 25.00 | 25.00 | 25.00 |
| Evaluation compound (specific compound or comparative compound) | Kind | S-9 | S-10 | S-11 | S-12 | S-13 | S-15 |
| | Formulation amount | 2.08 | 2.08 | 2.08 | 2.08 | 2.08 | 2.08 |
| Coloring material dispersion liquid | Average particle diameter (nm) | 101 | 93 | 103 | 93 | 91 | 88 |

[Table 14]

| | | CA19 | CA20 | CA21 | CA22 | CA23 |
|---|---|---|---|---|---|---|
| Solvent | MBA | 65.42 | 65.42 | 65.42 | 65.42 | 65.42 |
| Resin | SOLSPERSE 20000 | 7.50 | 7.50 | 7.50 | 7.50 | 7.50 |
| Black pigment | Organic black | 25.00 | 25.00 | 25.00 | 25.00 | 25.00 |
| Evaluation compound (specific compound or comparative compound) | Kind | S-16 | S-17 | S-18 | S-19 | S-20 |
| | Formulation amount | 2.08 | 2.08 | 2.08 | 2.08 | 2.08 |
| Coloring material dispersion liquid | Average particle diameter (nm) | 86 | 84 | 82 | 80 | 78 |

[Table 15]

| | | CB1 | CB2 |
|---|---|---|---|
| Solvent | MBA | 67.50 | 65.42 |

(continued)

| | | CB1 | CB2 |
|---|---|---|---|
| Resin | SOLSPERSE 20000 | 7.50 | 7.50 |
| Black pigment | Organic black | 25.00 | 25.00 |
| Evaluation compound (specific compound or comparative compound) | Kind | | S-1 |
| | Formulation amount | | 2.08 |
| Coloring material dispersion liquid | Average particle diameter (nm) | 92 | 282 |

[Table 16]

| | | DA1 | DA2 | DA3 | DA4 | DA5 | DA6 |
|---|---|---|---|---|---|---|---|
| Solvent | PGMEA | 50.26 | 50.04 | 48.80 | 47.28 | 50.04 | 46.96 |
| | Cyclopentanone | 17.11 | 17.04 | 16.62 | 16.10 | 17.04 | 15.99 |
| Resin | DISPERBYK-2159 | 7.50 | 7.50 | 7.50 | 7.50 | 7.50 | 7.50 |
| Black pigment | Zirconium oxynitride | 25.00 | 25.00 | 25.00 | 25.00 | 25.00 | 25.00 |
| Evaluation compound (specific compound or c omparative compound) | Kind | S-1 | S-1 | S-1 | S-1 | S-2 | S-2 |
| | Formulation amount | 0.13 | 0.42 | 2.08 | 4.12 | 0.42 | 4.55 |
| Coloring material dispersion liquid | Average particle diameter (nm) | 90 | 91 | 99 | 90 | 95 | 91 |

[Table 17]

| | | DA7 | DA8 | DA9 | DA10 | DA11 | DA12 |
|---|---|---|---|---|---|---|---|
| Solvent | PGMEA | 48.80 | 48.80 | 48.80 | 48.80 | 48.80 | 48.80 |
| | Cyclopentanone | 16.62 | 16.62 | 16.62 | 16.62 | 16.62 | 16.62 |
| Resin | DISPERBYK-2159 | 7.50 | 7.50 | 7.50 | 7.50 | 7.50 | 7.50 |
| Black pigment | Zirconium oxynitride | 25.00 | 25.00 | 25.00 | 25.00 | 25.00 | 25.00 |
| Evaluation compound (specific compound or comparative compound) | Kind | S-3 | S-4 | S-5 | S-6 | S-7 | S-8 |
| | Formulation amount | 2.08 | 2.08 | 2.08 | 2.08 | 2.08 | 2.08 |
| Coloring material dispersion liquid | Average particle diameter (nm) | 92 | 92 | 93 | 90 | 98 | 100 |

[Table 18]

| | | DA13 | DA14 | DA15 | DA16 | DA17 | DA18 |
|---|---|---|---|---|---|---|---|
| Solvent | PGMEA | 48.80 | 48.80 | 48.80 | 48.80 | 48.80 | 65.42 |
| | Cyclopentanone | 16.62 | 16.62 | 16.62 | 16.62 | 16.62 | |
| Resin | DISPERBYK-2159 | 7.50 | 7.50 | 7.50 | 7.50 | 7.50 | 7.50 |
| Black pigment | Zirconium oxynitride | 25.00 | 25.00 | 25.00 | 25.00 | 25.00 | 25.00 |
| Evaluation compound (specific compound or c omparative compound) | Kind | S-9 | S-10 | S-11 | S-12 | S-13 | S-15 |
| | Formulation amount | 2.08 | 2.08 | 2.08 | 2.08 | 2.08 | 2.08 |

(continued)

| | | DA13 | DA14 | DA15 | DA16 | DA17 | DA18 |
|---|---|---|---|---|---|---|---|
| Coloring material dispersion liquid | Average particle diameter (nm) | 101 | 93 | 103 | 93 | 91 | 88 |

[Table 19]

| | | DA19 | DA20 | DA21 | DA22 | DA23 |
|---|---|---|---|---|---|---|
| Solvent | PGMEA | 65.42 | 65.42 | 65.42 | 65.42 | 65.42 |
| | Cyclopentanone | | | | | |
| Resin | DISPERBYK-2159 | 7.50 | 7.50 | 7.50 | 7.50 | 7.50 |
| Black pigment | Zirconium oxynitride | 25.00 | 25.00 | 25.00 | 25.00 | 25.00 |
| Evaluation compound (specific compound or comparative compound) | Kind | S-16 | S-17 | S-18 | S-19 | S-20 |
| | Formulation amount | 2.08 | 2.08 | 2.08 | 2.08 | 2.08 |
| Coloring material dispersion liquid | Average particle diameter (nm) | 86 | 84 | 82 | 80 | 78 |

[Table 20]

| | | DB1 | DB2 |
|---|---|---|---|
| Solvent | PGMEA | 67.50 | 65.42 |
| | Cyclopentanone | | |
| Resin | DISPERBYK-2159 | 7.50 | 7.50 |
| Black pigment | Zirconium oxynitride | 25.00 | 25.00 |
| Evaluation compound (specific compound or comparative compound) | Kind | | S-1 |
| | Formulation amount | | 2.08 |
| Coloring material dispersion liquid | Average particle diameter (nm) | 92 | 282 |

[Table 21]

| | | EA1 | EA2 | EA3 | EA4 | EA5 | EA6 |
|---|---|---|---|---|---|---|---|
| Solvent | PGMEA | 50.26 | 50.04 | 48.80 | 47.28 | 50.04 | 47.28 |
| | Cyclopentanone | 17.11 | 17.04 | 16.62 | 16.10 | 17.04 | 16.10 |
| Resin | X-2 | 7.50 | 7.50 | 7.50 | 7.50 | 7.50 | 7.50 |
| Black pigment | TiBk | 25.00 | 25.00 | 25.00 | 25.00 | 25.00 | 25.00 |
| Evaluation compound (specific compound or c omparative compound) | Kind | S-1 | S-1 | S-1 | S-1 | S-2 | S-2 |
| | Formulation amount | 0.13 | 0.42 | 2.08 | 4.12 | 0.42 | 4.12 |
| Coloring material dispersion liquid | Average particle diameter (nm) | 90 | 92 | 85 | 90 | 88 | 87 |

[Table 22]

| | | EA7 | EA8 | EA9 | EA10 | EA11 | EA12 |
|---|---|---|---|---|---|---|---|
| Solvent | PGMEA | 48.80 | 48.80 | 48.80 | 48.80 | 48.80 | 48.80 |
| | Cyclopentanone | 16.62 | 16.62 | 16.62 | 16.62 | 16.62 | 16.62 |
| Resin | X-2 | 7.50 | 7.50 | 7.50 | 7.50 | 7.50 | 7.50 |
| Black pigment | TiBk | 25.00 | 25.00 | 25.00 | 25.00 | 25.00 | 25.00 |
| Evaluation compound (specific compound or comparative compound) | Kind | S-3 | S-4 | S-5 | S-6 | S-7 | S-8 |
| | Formulation amount | 2.08 | 2.08 | 2.08 | 2.08 | 2.08 | 2.08 |
| Coloring material dispersion liquid | Average particle diameter (nm) | 83 | 92 | 93 | 90 | 89 | 88 |

[Table 23]

| | | EA13 | EA14 | EA15 | EA16 | EA17 | EA18 |
|---|---|---|---|---|---|---|---|
| Solvent | PGMEA | 48.80 | 48.80 | 48.80 | 48.80 | 48.80 | 48.80 |
| | Cyclopentanone | 16.62 | 16.62 | 16.62 | 16.62 | 16.62 | 16.62 |
| Resin | X-2 | 7.50 | 7.50 | 7.50 | 7.50 | 7.50 | 7.50 |
| Black pigment | TiBk | 25.00 | 25.00 | 25.00 | 25.00 | 25.00 | 25.00 |
| Evaluation compound (specific compound or comparative compound) | Kind | S-9 | S-10 | S-11 | S-12 | S-13 | S-15 |
| | Formulation amount | 2.08 | 2.08 | 2.08 | 2.08 | 2.08 | 2.08 |
| Coloring material dispersion liquid | Average particle diameter (nm) | 87 | 86 | 94 | 93 | 99 | 94 |

[Table 24]

| | | EA19 | EA20 | EA21 | EA22 | EA23 | EA24 |
|---|---|---|---|---|---|---|---|
| Solvent | PGMEA | 48.80 | 48.80 | 48.80 | 48.80 | 48.80 | 50.36 |
| | Cyclopentanone | 16.62 | 16.62 | 16.62 | 16.62 | 16.62 | 17.15 |
| Resin | X-2 | 7.50 | 7.50 | 7.50 | 7.50 | 7.50 | 6.70 |
| Black pigment | TiBk | 25.00 | 25.00 | 25.00 | 25.00 | 25.00 | 25.00 |
| Evaluation compound (specific compound or comparative compound) | Kind | S-16 | S-17 | S-18 | S-19 | S-20 | S-1 |
| | Formulation amount | 2.08 | 2.08 | 2.08 | 2.08 | 2.08 | 0.79 |
| Coloring material dispersion liquid | Average particle diameter (nm) | 93 | 99 | 93 | 99 | 99 | 87 |

[Table 25]

| | | EA25 | EB1 | EB2 | EB3 | EB4 | EB5 |
|---|---|---|---|---|---|---|---|
| Solvent | PGMEA | 50.40 | 50.36 | 50.32 | 46.94 | 48.75 | 48.75 |
| | Cyclopentanone | 17.15 | 17.15 | 17.13 | 15.98 | 16.60 | 16.60 |
| Resin | X-2 | 6.05 | 7.50 | 7.50 | 7.50 | 7.50 | 7.50 |
| Black pigment | TiBk | 25.00 | 25.00 | 25.00 | 25.00 | 25.00 | 25.00 |

(continued)

| | | EA25 | EB1 | EB2 | EB3 | EB4 | EB5 |
|---|---|---|---|---|---|---|---|
| Evaluation compound (specific compound or comparative compound) | Kind | S-1 | | S-1 | S-1 | S-1 | S-14 |
| | Formulation amount | 1.40 | | 0.04 | 4.58 | 2.15 | 2.15 |
| Coloring material dispersion liquid | Average particle diameter (nm) | 85 | 90 | 90 | 101 | 280 | 93 |

[Evaluation compound]

Specific structures of the evaluation compounds described in the above tables are shown below.

It is noted that the evaluation compounds are acid anhydrides and compounds other than acid anhydrides serving as comparative compounds for the compounds.

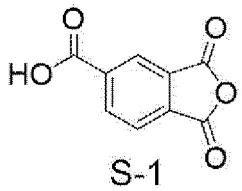
S-1

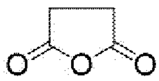
S-2

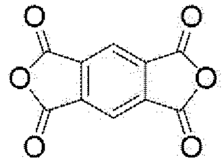
S-3

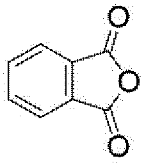
S-4

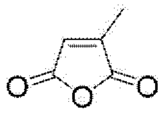
S-5

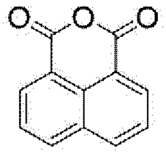
S-6

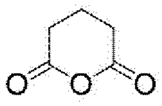
S-7

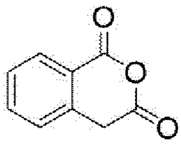
S-8

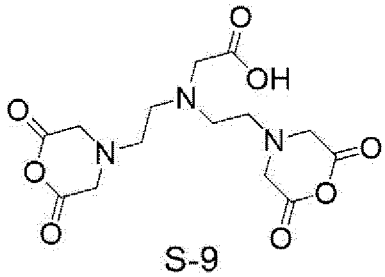
S-9

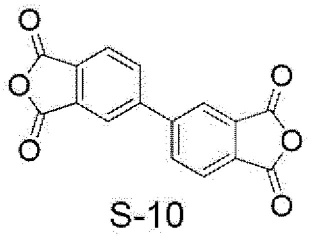
S-10

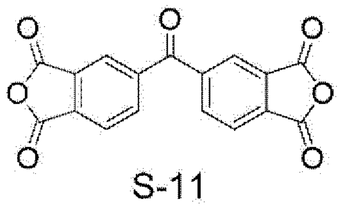
S-11

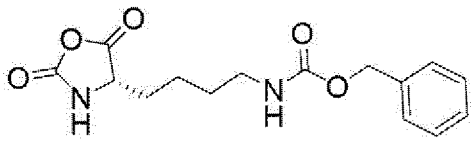

S-12

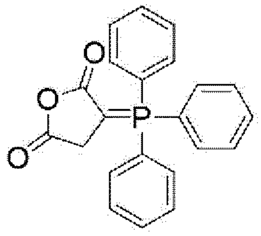

S-13

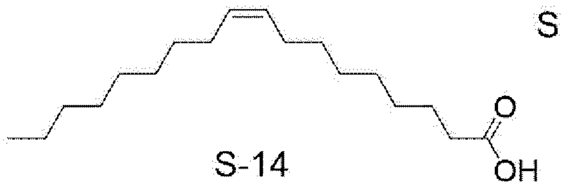

S-14

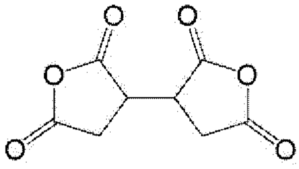

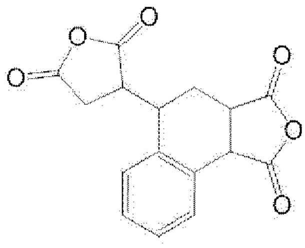

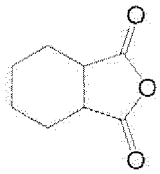

S-15 S-16 S-17

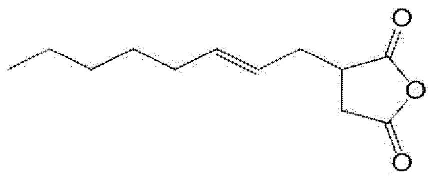

S-19

The evaluation compound S-18 is a mixture of the following two compounds (S-18-1 and S-18-2).

S-18

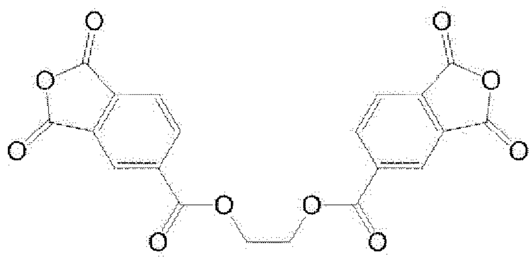

S-18-1

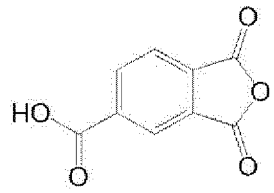

S-18-2

The evaluation compound S-20 is a mixture of the following four compounds (S-20-1 to S-20-4).

S-20

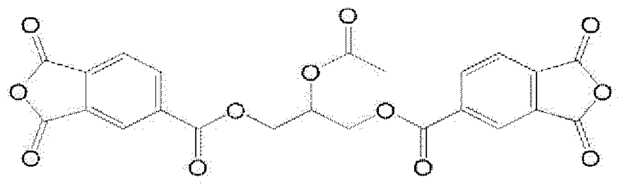

S-20-1

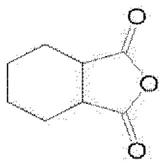

S-20-2

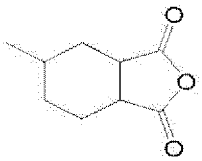

S-20-3

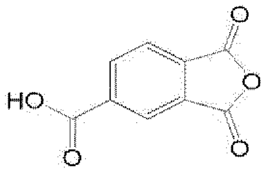

S-20-4

The molecular weight, the ClogP value, and the pKa of the evaluation compound are shown below.

In the table, the column of "Mw" indicates the molecular weight of the evaluation compound.

In the table, the column of "ClogP" indicates the ClogP value of the evaluation compound. It is noted that in the notation of "A/B" described in the column of "ClogP", "A" indicates a ClogP value in a state where the evaluation compound (the cyclic acid anhydride) is not subjected to ring opening, and "B" indicates a ClogP value of a compound obtained by subjecting the evaluation compound (the cyclic acid anhydride) to ring opening. It is noted that "-" indicates that the evaluation has not been carried out. It is noted that in S-14, the ClogP of the compound itself is indicated.

In the table, the column of "pKa" indicates the pKa of the evaluation compound. It is noted that in the notation of "C/D" described in the column of "pKa", "C" indicates a pKa in a state where the evaluation compound (the cyclic acid anhydride) is not subjected to ring opening, and "D" indicates a pKa of a compound obtained by subjecting the evaluation compound (the cyclic acid anhydride) to ring opening. It is noted that "-" indicates that the evaluation has not been carried out. It is noted that in S-14, the pKa of the compound itself is indicated.

[Table 26]

| | Kind | S-1 | S-2 | S-3 | S-4 | S-5 | S-6 | S-7 | S-8 |
|---|---|---|---|---|---|---|---|---|---|
| Evaluation compound | Mw | 192.1 | 100.1 | 194.1 | 148.1 | 112.1 | 198.2 | 114.1 | 162.1 |
| | ClogP | 1.61/ 0.57 | -0.87/ -0.52 | 1.33/ -0.77 | 1.60/ 0.73 | 0.27/ 0.14 | 2.77/ 2.97 | -0.31/ -0.13 | 1.49/ 0.86 |
| | pKa | 3.54/ 2.82 | -/ 4.06 | -/ 2.07 | -/ 2.95 | -/ 3.29 | -/ 2.74 | -/ 4.37 | -/ 3.56 |

[Table 27]

| | Kind | S-9 | S-10 | S-11 | S-12 | S-13 | S-14 | S-15 | S-16 |
|---|---|---|---|---|---|---|---|---|---|
| Evaluation compound | Mw | 357.3 | 294.2 | 322.2 | 306.3 | 360.4 | 282.5 | 193.1 | 300.0 |
| | ClogP | -1.54/ -2.90 | 3.00/ 1.22 | 2.46/ 0.36 | 1.46/ 0.87 | 5.85/ 5.32 | 7.79 | -1.97/ -1.62 | 0.151 0.17 |
| | pKa | -1.38/ -1.18 | -/ 2.71 | -/ 2.58 | -/ 3.83 | -/ 3.28 | 4.70 | -/ 3.36 | -/ 3.44 |

[Table 28]

| | Kind | S-17 | S-18 | | S-19 | S-20 | | | |
|---|---|---|---|---|---|---|---|---|---|
| | | | S-18-1 | S-18-2 | | S-20-1 | S-20-2 | S-20-3 | S-20-4 |
| Evaluation compound | Mw | 154.2 | 410.3 | 192.1 | 210.0 | 482.4 | 154.2 | 168.2 | 192.1 |
| | ClogP | 0.56/ 0.88 | 3.12/ 1.28 | 1.61/ 0.57 | 2.87/ 3.00 | 3.03/ 1.19 | 0.56/ 0.88 | 1.08/ 1.40 | 1.61/ 0.57 |
| | pKa | -/ 4.12 | -/ 3.24 | 3.54/ 2.89 | -/ 4.18 | -/ 2.90 | -/ 4.12 | -/ 4.28 | 3.54/ 2.89 |

[Production of composition (black photosensitive composition)]

The following raw materials were used and mixed according to the formulations (in terms of parts by mass) described in Tables 26 to 57 shown in the latter part to prepare a composition (a black photosensitive composition) of each of Examples and Comparative Examples.

[Solvent]

- PGMEA: Propylene glycol monomethyl ether acetate

[Resin (post-added resin)]

- B-1: A resin having a structure shown below (weight-average molecular weight: 11,000, acid value: 32 mg KOH/g, the numerical value attached to each repeating unit means the molar ratio of each repeating unit)

B-1

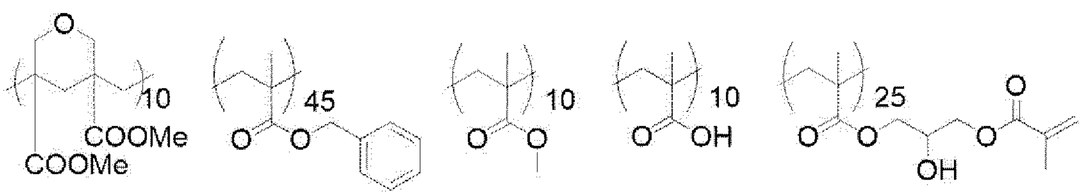

- B-2: Cardo resin V-259ME (manufactured by NIPPON STEEL & SUMITOMO METAL CORPORATION)

It is noted that the resin B-1 and the resin B-2 correspond to the alkali-soluble resin.

[Polymerizable compound]

- M-1: KAYARAD DPHA (dipentaerythritol hexaacrylate, manufactured by Nippon Kayaku Co., Ltd.)

· M-2: ARONIX TO-2349 (acid-modified polyfunctional acrylate, manufactured by Toagosei Co., Ltd.)
· M-3: See the following structural formula (in the formula, a + b = 4, n = 4)

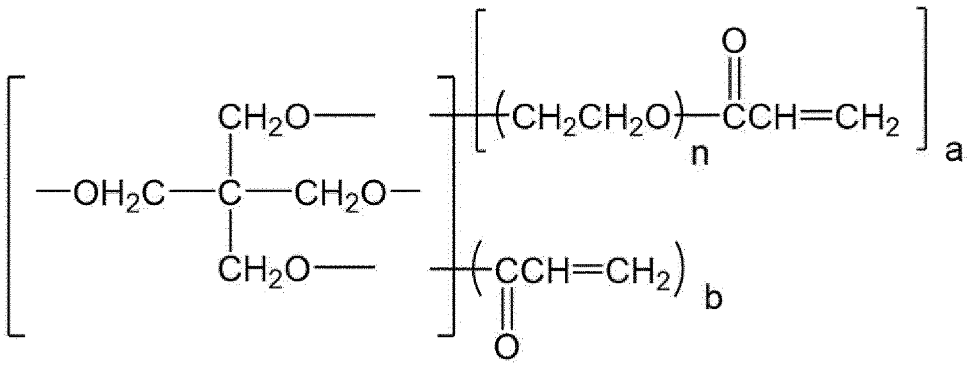

· M-4: M-305 (pentaerythritol tetraacrylate, manufactured by Toagosei Co., Ltd.)

[Polymerization Initiator]

· Ini-1: IRGACURE OXE02 (manufactured by BASF SE)
· Ini-2: See the following structural formula

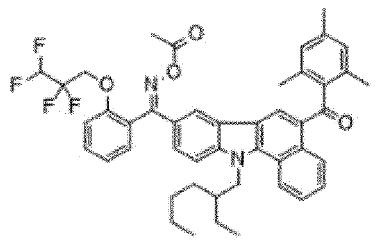

· Ini-3: See the following structural formula

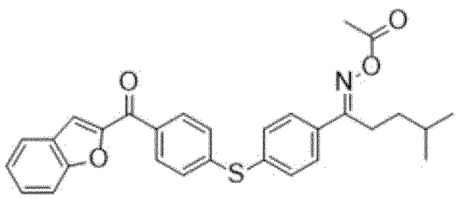

· Ini-4: NCI-831 (manufactured by ADEKA Corporation)
· Ini-5: N-1919 (manufactured by ADEKA Corporation)
• Ini-6: NCI-930 (manufactured by ADEKA Corporation)
· Ini-7: Initiator having the following structural formula

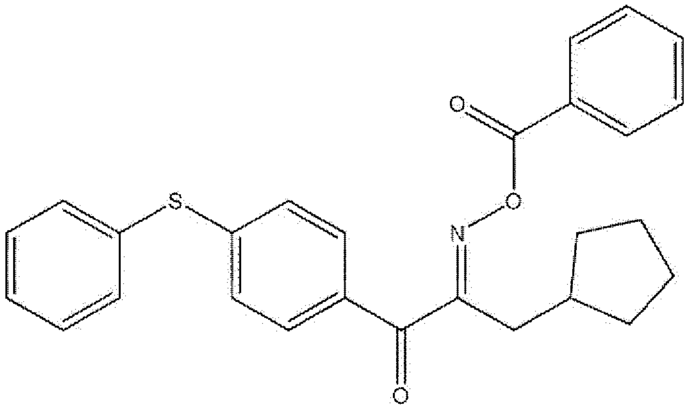

[Polymerization inhibitor]

· A-1: p-methoxyphenol

• A-2: The following compound (in the formula, t-Bu represents a tert-butyl group)

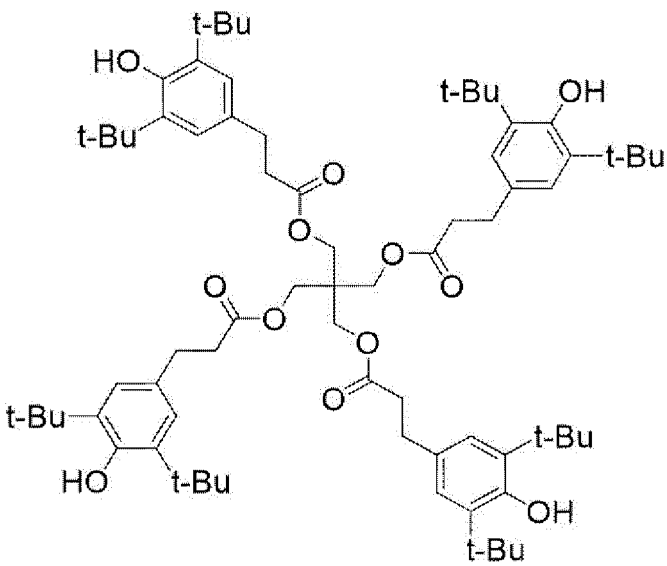

[Surfactant]

· W-1: The following surfactant (the number or letter attached to each repeating unit indicates the molar ratio of each repeating unit, weight-average molecular weight: 15,000)

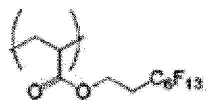 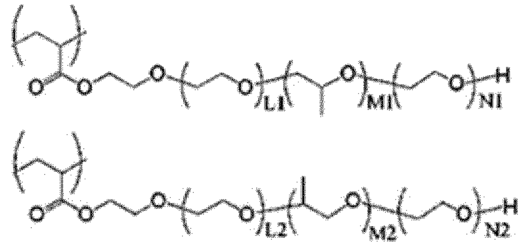

62% 38%

L1+N1+L2+N2=14

M1+M2=17

• W-2: The following surfactant (weight-average molecular weight: 3,000, in the formula, n represents an integer of 1 or more in the formula)

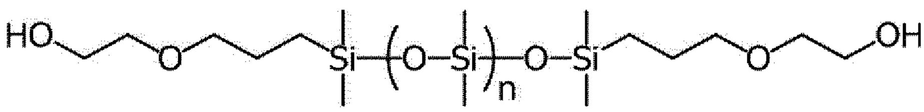

• W-3: KF6000 (manufactured by Shin-Etsu Silicone Co., Ltd.)
• W-4: FZ-2122 (manufactured by Dow Toray Co., Ltd.)

[Silica]

• T-1: PMA-ST-L (surface-modified solid silica, Nissan Chemical Corporation)

[Coloring material dispersion liquid]

• Each coloring material dispersion liquid prepared as described above was used for the preparation of the composition.

[Evaluation]

[Production of light shielding film substrate with pattern using composition]

The composition obtained above was applied onto a glass substrate according to a spin coating method to produce a coating film having a thickness of 1.5 μm in terms of the film thickness after drying. The substrate was subjected to prebaking at 100°C for 120 seconds and then subjected to exposure in a proximity manner through a mask with an L/S pattern (line width:space width = 1:1) having an opening line width of 50 μm at an exposure amount of 500 mJ/cm$^2$ with a high-pressure mercury lamp (lamp power: 50 mW/cm$^2$) using UX-1000SM-EH04 (manufactured by Ushio Inc.). Next, the exposed coating film was subjected to puddle development with a developer "CD-1040" (manufactured by FUJIFII,M Electronic Materials Co., Ltd.) for 15 seconds using AD-1200 (manufactured by Mikasa Co., Ltd.) and washed with pure water for 30 seconds by using a shower nozzle. The uncured part of the coating film was removed by development. Thereafter, the substrate was subject to post-baking at 220°C for 300 seconds to obtain a light shielding film substrate with a pattern (a substrate with a pattern having light shielding properties).

[Evaluation of residue]

Regarding the light shielding film substrate with a pattern produced by the above-described method using each composition, a space portion (non-exposed portion) on the substrate, in which the pattern was not formed, was observed using a transmission microscope, and the evaluation was made according to the following viewpoints.

A: No residue is present in the space portion.
B: A residue is confirmed in a region of less than 33.3% of the space portion.

C: A residue is confirmed in a region of 33.3% or more and less than 66.7% of the space portion.
D: A residue is confirmed in a region of 66.7% or more of the space portion.

[Evaluation of adhesiveness (peeling)]

A light shielding film substrate with a pattern was produced using each composition in the same manner as described above, except that the opening line width of the mask used in the exposure was changed to 10 μm and that the exposure was carried out while changing the exposure amounts.

Regarding the obtained light shielding film substrate with a pattern, a line pattern having a width of 10 μm was observed using an optical microscope, and the presence or absence of the pattern peeling was evaluated according to the following viewpoints. The smaller exposure amount which makes it possible to form a pattern (image portion) that is in close contact with the substrate and is not peeled off, the more preferable.

(Adhesion: evaluation standard)

A: With an exposure amount of 1,000 mJ or less, a pattern without peeling can be formed.
B: With an exposure amount of more than 1,000 mJ and 1,400 mJ or less, a pattern without peeling can be formed.
C: With an exposure amount of more than 1,400 mJ and 1,700 mJ or less, a pattern without peeling can be formed.
D: With an exposure amount of more than 1,700 mJ, a pattern without peeling can be formed.

[Evaluation of undercut width (UC evaluation)]

A light shielding film substrate with a pattern was produced using each composition in the same procedure as described above, except that the opening line width of the mask used in the exposure was changed to 300 μm.

Regarding the obtained light shielding film substrate with a pattern, a cross-sectional SEM image of a pattern having a width of 300 μm was observed using a scanning electron microscope S-4800 (manufactured by Hitachi High-Tech Corporation), the undercut width was measured, and the evaluation was made according to the following viewpoints.

It is noted that the undercut width is defined as "[(the line width at a position where the line width is widest in the pattern cross-section) - (the line width at a position where the line pattern in the pattern cross-section comes into contact with the substrate)]/2".

It is noted that "the line width at a position where the line width is widest in the pattern cross-section" is 300 μm.

A: The undercut width is less than 1.0 μm.
B: The undercut width is 1.0 μm or more and less than 1.5 μm.
C: The undercut width is 1.5 μm or more and less than 2.0 μm.
D: The undercut width is 2.0 μm or more.

The following table shows the formulation of the composition, the characteristics of the evaluation compound used, and the evaluation results.

The formulation of the composition in the table indicates the adding amount (in terms of parts by mass) of each component.

In the table, the column of "Coloring material dispersion liquid" indicates the kind and the formulation amount (in terms of parts by mass) of the coloring material dispersion liquid used.

In the table, the column of "Amount (%)" in the column of "Evaluation compound" indicates the content mass of the evaluation compound with respect to the total solid content in the composition of each of Examples or Comparative Examples.

[Table 29]

| | | Example 101 | Example 102 | Example 103 | Example 104 | Example 105 | Example 106 | Example 107 |
|---|---|---|---|---|---|---|---|---|
| Solvent | PGMEA | 14.94 | 15.16 | 16.53 | 18.40 | 15.16 | 18.40 | 16.53 |
| Resin | B-1 | | | | | | | |
| | B-2 | | | | | | | |
| Polymerizable compound | M-1 | 5.00 | 4.84 | 3.87 | 2.54 | 4.84 | 2.54 | 3.87 |
| | M-2 | | | | | | | |
| | M-3 | | | | | | | |
| | M-4 | | | | | | | |
| Polymerization initiator | Ini-1 | | | | | | | |
| | Ini-2 | 2.04 | 1.97 | 1.58 | 1.04 | 1.97 | 1.04 | 1.58 |
| | Ini-3 | | | | | | | |
| | Ini-4 | | | | | | | |
| | Ini-5 | | | | | | | |
| | Ini-6 | | | | | | | |
| | Ini-7 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Particle | T-1 | | | | | | | |
| Coloring material dispersion liquid | Kind | AA1 | AA2 | AA3 | AA4 | AA5 | AA6 | AA7 |
| | Formulation amount | 78.00 | 78.00 | 78.00 | 78.00 | 78.00 | 78.00 | 78.00 |
| Evaluation compound | Kind | S-1 | S-1 | S-1 | S-1 | S-2 | S-2 | S-3 |
| | Amount (%) | 0.3 | 1.0 | 5.0 | 10.0 | 1.0 | 10.0 | 5.0 |

(continued)

| | | Example 101 | Example 102 | Example 103 | Example 104 | Example 105 | Example 106 | Example 107 |
|---|---|---|---|---|---|---|---|---|
| Evaluation result | Residue | B | A | A | A | A | A | A |
| | Adhesiveness | A | A | A | A | A | A | A |
| | UC evaluation | A | A | A | A | A | A | A |

[Table 30]

| | | Example 108 | Example 109 | Example 110 | Example 111 | Example 112 | Example 113 | Example 114 |
|---|---|---|---|---|---|---|---|---|
| Solvent | PGMEA | 16.53 | 16.53 | 16.53 | 16.53 | 16.53 | 16.53 | 16.53 |
| Resin | B-1 | | | | | | | |
| | B-2 | | | | | | | |
| Polymerizable compound | M-1 | 3.87 | 3.87 | 3.87 | 3.87 | 3.87 | 3.87 | 3.87 |
| | M-2 | | | | | | | |
| | M-3 | | | | | | | |
| | M-4 | | | | | | | |
| Polymerization initiator | Ini-1 | | | | | | | |
| | Ini-2 | 1.58 | 1.58 | 1.58 | 1.58 | 1.58 | 1.58 | 1.58 |
| | Ini-3 | | | | | | | |
| | Ini-4 | | | | | | | |
| | Ini-5 | | | | | | | |
| | Ini-6 | | | | | | | |
| | Ini-7 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Particle | T-1 | | | | | | | |
| Coloring material dispersion liquid | Kind | AA8 | AA9 | AA10 | AA11 | AA12 | AA13 | AA14 |
| | Formulation amount | 78.00 | 78.00 | 78.00 | 78.00 | 78.00 | 78.00 | 78.00 |
| Evaluation compound | Kind | S-4 | S-5 | S-6 | S-7 | S-8 | S-9 | S-10 |
| | Amount (%) | 5.0 | 5.0 | 5.0 | 5.0 | 5.0 | 5.0 | 5.0 |

(continued)

| | | Example 108 | Example 109 | Example 110 | Example 111 | Example 112 | Example 113 | Example 114 |
|---|---|---|---|---|---|---|---|---|
| Evaluation result | Residue | A | A | A | A | A | A | A |
| | Adhesiveness | A | A | A | A | A | A | A |
| | UC evaluation | A | A | A | A | A | A | A |

[Table 31]

| | | Example 115 | Example 116 | Example 117 | Example 118 | Example 119 | Example 120 | Example 121 |
|---|---|---|---|---|---|---|---|---|
| Solvent | PGMEA | 16.53 | 16.53 | 16.53 | 16.53 | 16.53 | 16.53 | 16.53 |
| Resin | B-1 | | | | | | | |
| | B-2 | | | | | | | |
| Polymerizable compound | M-1 | 3.87 | 3.87 | 3.87 | 3.87 | 3.87 | 3.87 | 3.87 |
| | M-2 | | | | | | | |
| | M-3 | | | | | | | |
| | M-4 | | | | | | | |
| Polymerization initiator | Ini-1 | | | | | | | |
| | Ini-2 | 1.58 | 1.58 | 1.58 | 1.58 | 1.58 | 1.58 | 1.58 |
| | Ini-3 | | | | | | | |
| | Ini-4 | | | | | | | |
| | Ini-5 | | | | | | | |
| | Ini-6 | | | | | | | |
| | Ini-7 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Particle | T-1 | | | | | | | |
| Coloring material dispersion liquid | Kind | AA15 | AA16 | AA17 | AA18 | AA19 | AA20 | AA21 |
| | Formulation amount | 78.00 | 78.00 | 78.00 | 78.00 | 78.00 | 78.00 | 78.00 |
| Evaluation compound | Kind | S-11 | S-12 | S-13 | S-15 | S-16 | S-17 | S-18 |
| | Amount (%) | 5.0 | 5.0 | 5.0 | 5.0 | 5.0 | 5.0 | 5.0 |

(continued)

| | | Example 115 | Example 116 | Example 117 | Example 118 | Example 119 | Example 120 | Example 121 |
|---|---|---|---|---|---|---|---|---|
| Evaluation result | Residue | A | A | A | A | A | A | A |
| | Adhesiveness | A | A | A | A | A | A | A |
| | UC evaluation | A | A | B | A | A | A | A |

[Table 32]

| | | Example 122 | Example 123 | Example 124 | Example 125 | Example 126 | Example 127 | Example 128 |
|---|---|---|---|---|---|---|---|---|
| Solvent | PGMEA | 16.53 | 16.53 | 15.16 | 15.16 | 15.16 | 15.16 | 15.16 |
| Resin | B-1 | | | 0.066 | | | | |
| | B-2 | | | | 0.066 | 0.066 | 0.066 | 0.066 |
| Polymerizable compound | M-1 | 3.87 | 3.87 | 4.80 | 4.80 | | | 4.80 |
| | M-2 | | | | | 4.80 | | |
| | M-3 | | | | | | 4.80 | |
| | M-4 | | | | | | | |
| Polymerization initiator | Ini-1 | | | | | | | 1.95 |
| | Ini-2 | 1.58 | 1.58 | 1.95 | 1.95 | 1.95 | 1.95 | |
| | Ini-3 | | | | | | | |
| | Ini-4 | | | | | | | |
| | Ini-5 | | | | | | | |
| | Ini-6 | | | | | | | |
| | Ini-7 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Particle | T-1 | | | | | | | |
| Coloring material dispersion liquid | Kind | AA22 | AA23 | AA2 | AA2 | AA2 | AA2 | AA2 |
| | Formulation amount | 78.00 | 78.00 | 78.00 | 78.00 | 78.00 | 78.00 | 78.00 |
| Evaluation compound | Kind | S-19 | S-20 | S-1 | S-1 | S-1 | S-1 | S-1 |
| | Amount (%) | 5.0 | 5.0 | 1.0 | 1.0 | 1.0 | 1.0 | 1.0 |

(continued)

| | | Example 122 | Example 123 | Example 124 | Example 125 | Example 126 | Example 127 | Example 128 |
|---|---|---|---|---|---|---|---|---|
| Evaluation result | Residue | A | A | A | A | A | A | A |
| | Adhesiveness | A | A | A | A | A | A | A |
| | UC evaluation | A | A | A | A | A | A | A |

[Table 33]

| | | Example 129 | Example 130 | Example 131 | Example 132 | Example 133 | Example 134 | Example 135 |
|---|---|---|---|---|---|---|---|---|
| Solvent | PGMEA | 15.16 | 15.16 | 15.16 | 15.16 | 15.16 | 15.16 | 15.16 |
| Resin | B-1 | | | | | | | |
| | B-2 | 0.066 | 0.066 | 0.066 | 0.066 | 0.066 | 0.066 | 0.066 |
| Polymerizable compound | M-1 | 4.80 | 4.80 | 4.80 | 4.80 | 4.80 | 4.80 | 4.80 |
| | M-2 | | | | | | | |
| | M-3 | | | | | | | |
| | M-4 | | | | | | | |
| Polymerization initiator | Ini-1 | | | | | | | |
| | Ini-2 | | | | | | | |
| | Ini-3 | 1.95 | | | | | 1.95 | 1.95 |
| | Ini-4 | | 1.95 | | | | | |
| | Ini-5 | | | 1.95 | | | | |
| | Ini-6 | | | | 1.95 | | | |
| | Ini-7 | | | | | 1.95 | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | 0.021 | |
| | W-2 | 0.021 | 0.021 | 0.021 | 0.021 | 0.021 | | |
| | W-3 | | | | | | | 0.021 |
| | W-4 | | | | | | | |
| Particle | T-1 | | | | | | | |
| Coloring material dispersion liquid | Kind | AA2 | AA2 | AA2 | AA2 | AA2 | AA2 | AA2 |
| | Formulation amount | 78.00 | 78.00 | 78.00 | 78.00 | 78.00 | 78.00 | 78.00 |
| Evaluation compound | Kind | S-1 | S-1 | S-1 | S-1 | S-1 | S-1 | S-1 |
| | Amount (%) | 1.0 | 1.0 | 1.0 | 1.0 | 1.0 | 1.0 | 1.0 |

(continued)

| | | Example 129 | Example 130 | Example 131 | Example 132 | Example 133 | Example 134 | Example 135 |
|---|---|---|---|---|---|---|---|---|
| Evaluation result | Residue | A | A | A | A | A | A | A |
| | Adhesiveness | A | A | A | A | A | A | A |
| | UC evaluation | A | A | A | A | A | A | A |

[Table 34]

| | | Example 136 | Example 137 | Example 138 | Example 139 | Example 140 | Comparative Example 101 | Comparative Example 102 |
|---|---|---|---|---|---|---|---|---|
| Solvent | PGMEA | 15.16 | 16.47 | 11.47 | 16.47 | 11.47 | 14.85 | 14.89 |
| Resin | B-1 | | 0.30 | 0.30 | 0.30 | 0.30 | 0.38 | |
| | B-2 | 0.066 | | | | | | |
| Polymerizable compound | M-1 | 4.80 | | | | | 4.80 | 5.04 |
| | M-2 | | | | | | | |
| | M-3 | | | | | | | |
| | M-4 | | 4.18 | 4.18 | 4.18 | 4.18 | | |
| Polymerization initiator | Ini-1 | | | | | | | |
| | Ini-2 | | | | | | | |
| | Ini-3 | 1.95 | | | | | 1.95 | 2.05 |
| | Ini-4 | | 1.045 | 1.045 | 1.045 | 1.045 | | |
| | Ini-5 | | | | | | | |
| | Ini-6 | | | | | | | |
| | Ini-7 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | | | | | | 0.021 | 0.021 |
| | W-3 | | 0.004 | 0.004 | 0.004 | 0.004 | | |
| | W-4 | 0.021 | | | | | | |
| Particle | T-1 | | | 5.000 | | 5000 | | |
| Coloring material dispersion liquid | Kind | AA2 | AA24 | AA24 | AA25 | AA25 | AB1 | AB2 |
| | Formulation amount | 78.00 | 78.00 | 78.00 | 78.00 | 78.00 | 78.00 | 78.00 |

(continued)

| | | Example 136 | Example 137 | Example 138 | Example 139 | Example 140 | Comparative Example 101 | Comparative Example 102 |
|---|---|---|---|---|---|---|---|---|
| Evaluation compound | Kind | S-1 | S-1 | S-1 | S-1 | S-1 | - | S-1 |
| | Amount (%) | 1.0 | 1.9 | 1.9 | 3.5 | 3.5 | - | 0.1 |
| Evaluation result | Residue | A | A | A | A | A | D | D |
| | Adhesiveness | A | A | A | A | A | A | A |
| | UC evaluation | A | A | A | A | A | A | A |

[Table 35]

| | | Comparative Example 103 | Comparative Example 104 | Comparative Example 105 |
|---|---|---|---|---|
| Solvent | PGMEA | 18.43 | 15.16 | 15.16 |
| Resin | B-1 | | | |
| | B-2 | | | |
| Polymerizable compound | M-1 | 2.52 | 4.84 | 4.84 |
| | M-2 | | | |
| | M-3 | | | |
| | M-4 | | | |
| Polymerization initiator | Ini-I | | | |
| | Ini-2 | 1.03 | 1.97 | 1.97 |
| | Ini-3 | | | |
| | Ini-4 | | | |
| | Ini-5 | | | |
| | Ini-6 | | | |
| | Ini-7 | | | |
| Polymerization inhibitor | A-1 | 0.002 | 0.002 | 0.002 |
| | A-2 | | | |
| Surfactant | W-1 | | | |
| | W-2 | 0.021 | 0.021 | 0.021 |
| | W-3 | | | |
| | W-4 | | | |
| Particle | T-1 | | | |
| Coloring material dispersion liquid | Kind | AB3 | AB4 | AB5 |
| | Formulation amount | 78.00 | 78.00 | 78.00 |
| Evaluation compound | Kind | S-1 | S-1 | S-14 |
| | Amount (%) | 11.0 | 1.0 | 1.0 |
| Evaluation result | Residue | A | D | C |
| | Adhesiveness | C | A | D |
| | UC evaluation | C | A | D |

[Table 36]

| | | Example 201 | Example 202 | Example 203 | Example 204 | Example 205 | Example 206 | Example 207 |
|---|---|---|---|---|---|---|---|---|
| Solvent | PGMEA | 14.94 | 15.16 | 16.53 | 18.40 | 15.16 | 18.40 | 16.53 |
| Resin | B-1 | | | | | | | |
| | B-2 | | | | | | | |
| Polymerizable compound | M-1 | 5.00 | 4.84 | 3.87 | 2.54 | 4.84 | 2.54 | 3.87 |
| | M-2 | | | | | | | |
| | M-3 | | | | | | | |
| Polymerization initiator | Ini-1 | | | | | | | |
| | Ini-2 | 2.04 | 1.97 | 1.58 | 1.04 | 1.97 | 1.04 | 1.58 |
| | Ini-3 | | | | | | | |
| | Ini-4 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Coloring material dispersion liquid | Kind | BA1 | BA2 | BA3 | BA4 | BAS | BA6 | BA7 |
| | Formulation amount | 78.00 | 78.00 | 78.00 | 78.00 | 78.00 | 78.00 | 78.00 |
| Evaluation compound | Kind | S-1 | S-1 | S-1 | S-1 | S-2 | S-2 | S-3 |
| | Amount (%) | 0.3 | 1.0 | 5.0 | 10.0 | 1.0 | 10.0 | 5.0 |
| Evaluation result | Residue | B | A | A | A | A | A | A |
| | Adhesiveness | A | A | A | A | A | A | A |
| | UC evaluation | A | A | A | A | A | A | A |

[Table 37]

| | | Example 208 | Example 209 | Example 210 | Example 211 | Example 212 | Example 213 | Example 214 |
|---|---|---|---|---|---|---|---|---|
| Solvent | PGMEA | 16.53 | 16.53 | 16.53 | 16.53 | 16.53 | 16.53 | 16.53 |
| Resin | B-1 | | | | | | | |
| | B-2 | | | | | | | |
| Polymerizable compound | M-1 | 3.87 | 3.87 | 3.87 | 3.87 | 3.87 | 3.87 | 3.87 |
| | M-2 | | | | | | | |
| | M-3 | | | | | | | |
| Polymerization initiator | Ini-1 | | | | | | | |
| | Ini-2 | 1.58 | 1.58 | 1.58 | 1.58 | 1.58 | 1.58 | 1.58 |
| | Ini-3 | | | | | | | |
| | Ini-4 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Coloring material dispersion liquid | Kind | BA8 | BA9 | BA10 | BA11 | BA12 | BA13 | BA14 |
| | Formulation amount | 78.00 | 78.00 | 78.00 | 78.00 | 78.00 | 78.00 | 78.00 |
| Evaluation compound | Kind | S-4 | S-5 | S-6 | S-7 | S-8 | S-9 | S-10 |
| | Amount (%) | 5.0 | 5.0 | 5.0 | 5.0 | 5.0 | 5.0 | 5.0 |
| Evaluation result | Residue | A | A | A | A | A | A | A |
| | Adhesiveness | A | A | A | A | A | A | A |
| | UC evaluation | A | A | A | A | A | A | A |

[Table 38]

| | | Example 215 | Example 216 | Example 217 | Example 218 | Example 219 | Example 220 | Example 221 |
|---|---|---|---|---|---|---|---|---|
| Solvent | PGMEA | 16.53 | 16.53 | 16.53 | 16.53 | 16.53 | 16.53 | 16.53 |
| Resin | B-1 | | | | | | | |
| | B-2 | | | | | | | |
| Polymerizable compound | M-1 | 3.87 | 3.87 | 3.87 | 3.87 | 3.87 | 3.87 | 3.87 |
| | M-2 | | | | | | | |
| | M-3 | | | | | | | |
| Polymerization initiator | Ini-1 | | | | | | | |
| | Ini-2 | 1.58 | 1.58 | 1.58 | 1.58 | 1.58 | 1.58 | 1.58 |
| | Ini-3 | | | | | | | |
| | Ini-4 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Coloring material dispersion liquid | Kind | BA15 | BA16 | BA17 | BA18 | BA19 | BA20 | BA21 |
| | Formulation amount | 78.00 | 78.00 | 78.00 | 78.00 | 78.00 | 78.00 | 78.00 |
| Evaluation compound | Kind | S-11 | S-12 | S-13 | S-15 | S-16 | S-17 | S-18 |
| | Amount (%) | 5.0 | 5.0 | 5.0 | 5.0 | 5.0 | 5.0 | 5.0 |
| Evaluation result | Residue | A | A | A | A | A | A | A |
| | Adhesiveness | A | A | A | A | A | A | A |
| | UC evaluation | A | A | B | A | A | A | A |

[Table 39]

| | | Example 222 | Example 223 | Example 223 | Example 224 | Example 225 | Example 226 | Example 227 | Example 228 |
|---|---|---|---|---|---|---|---|---|---|
| Solvent | PGMEA | 16.53 | 16.53 | 15.16 | 15.16 | 15.16 | 15.16 | 15.16 | 15.16 |
| Resin | B-1 | | | 0.066 | | | | | |
| | B-2 | | | | 0.066 | 0.066 | 0.066 | 0.066 | 0.066 |
| Polymerizable compound | M-1 | 3.87 | 3.87 | 4.80 | 4.80 | | | 4.80 | 4.80 |
| | M-2 | | | | | 4.80 | | | |
| | M-3 | | | | | | 4.80 | | |
| Polymerization initiator | Ini-1 | | | | | | | 1.95 | |
| | Ini-2 | 1.58 | 1.58 | 1.95 | 1.95 | 1.95 | 1.95 | | |
| | Ini-3 | | | | | | | | 1.95 |
| | Ini-4 | | | | | | | | |
| Polymerization inhibitor | A-1 | 0.002 | 0.002 | 0.002 | 0.002 | 0.002 | 0.002 | 0.002 | 0.002 |
| | A-2 | | | | | | | | |
| Surfactant | W-1 | | | | | | | | |
| | W-2 | 0.021 | 0.021 | 0.021 | 0.021 | 0.021 | 0.021 | 0.021 | 0.021 |
| | W-3 | | | | | | | | |
| | W-4 | | | | | | | | |
| Coloring material dispersion liquid | Kind | BA22 | BA23 | BA2 | BA2 | BA2 | BA2 | BA2 | BA2 |
| | Formulation amount | 78.00 | 78.00 | 78.00 | 78.00 | 78.00 | 78.00 | 78.00 | 78.00 |
| Evaluation compound | Kind | S-19 | S-20 | S-1 | S-1 | S-1 | S-1 | S-1 | S-1 |
| | Amount (%) | 5.0 | 5.0 | 1.0 | 1.0 | 1.0 | 1.0 | 1.0 | 1.0 |
| Evaluation result | Residue | A | A | A | A | A | A | A | A |
| | Adhesiveness | A | A | A | A | A | A | A | A |
| | UC evaluation | A | A | A | A | A | A | A | A |

[Table 40]

| | | Example 229 | Example 230 | Example 231 | Example 232 | Comparative Example 201 | Comparative Example 202 |
|---|---|---|---|---|---|---|---|
| Solvent | PGMEA | 15.16 | 15.16 | 15.16 | 15.16 | 14.85 | 16.53 |
| Resin | B-1 | | | | | 0.38 | |
| | B-2 | 0.066 | 0.066 | 0.066 | 0.066 | | |
| Polymerizable compound | M-1 | 4.80 | 4.80 | 4.80 | 4.80 | 4.80 | 3.87 |
| | M-2 | | | | | | |
| | M-3 | | | | | | |
| Polymerization initiator | Ini-1 | | | | | | |
| | Ini-2 | | | | | | 1.58 |
| | Ini-3 | | 1.95 | 1.95 | 1.95 | 1.95 | |
| | Ini-4 | 1.95 | | | | | |
| Polymerization inhibitor | A-1 | 0.002 | 0.002 | 0.002 | 0.002 | 0.002 | 0.002 |
| | A-2 | | | | | | |
| Surfactant | W-1 | | 0.021 | | | | |
| | W-2 | 0.021 | | | | 0.021 | 0.021 |
| | W-3 | | | 0.021 | | | |
| | W-4 | | | | 0.021 | | |
| Coloring material dispersion liquid | Kind | BA2 | BA2 | BA2 | BA2 | BB1 | BB2 |
| | Formulation amount | 78.00 | 78.00 | 78.00 | 78.00 | 78.00 | 78.00 |
| Evaluation compound | Kind | S-1 | S-1 | S-1 | S-1 | - | S-1 |
| | Amount (%) | 1.0 | 1.0 | 1.0 | 1.0 | 0.0 | 5.0 |
| Evaluation result | Residue | A | A | A | A | D | D |
| | Adhesiveness | A | A | A | A | A | A |
| | UC evaluation | A | A | A | A | A | A |

[Table 41]

| | | Example 301 | Example 302 | Example 303 | Example 304 | Example 305 | Example 306 | Example 307 |
|---|---|---|---|---|---|---|---|---|
| Solvent | PGMEA | 14.94 | 15.16 | 16.53 | 18.40 | 15.16 | 18.40 | 16.53 |
| Resin | B-1 | | | | | | | |
| | B-2 | | | | | | | |
| Polymerizable compound | M-1 | 5.00 | 4.84 | 3.87 | 2.54 | 4.84 | 2.54 | 3.87 |
| | M-2 | | | | | | | |
| | M-3 | | | | | | | |
| Polymerization initiator | Ini-1 | | | | | | | |
| | Ini-2 | 2.04 | 1.97 | 1.58 | 1.04 | 1.97 | 1.04 | 1.58 |
| | Ini-3 | | | | | | | |
| | Ini-4 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Coloring material dispersion liquid | Kind | CA1 | CA2 | CA3 | CA4 | CA5 | CA6 | CA7 |
| | Formulation amount | 78.00 | 78.00 | 78.00 | 78.00 | 78.00 | 78.00 | 78.00 |
| Evaluation compound | Kind | S-1 | S-1 | S-1 | S-1 | S-2 | S-2 | S-3 |
| | Amount (%) | 0.3 | 1.0 | 5.0 | 10.0 | 1.0 | 10.0 | 5.0 |
| Evaluation result | Residue | B | A | A | A | A | A | A |
| | Adhesiveness | A | A | A | A | A | A | A |
| | UC evaluation | A | A | A | A | A | A | A |

[Table 42]

| | | Example 308 | Example 309 | Example 310 | Example 311 | Example 312 | Example 313 | Example 314 |
|---|---|---|---|---|---|---|---|---|
| Solvent | PGMEA | 16.53 | 16.53 | 16.53 | 16.53 | 16.53 | 16.53 | 16.53 |
| Resin | B-1 | | | | | | | |
| | B-2 | | | | | | | |
| Polymerizable compound | M-1 | 3.87 | 3.87 | 3.87 | 3.87 | 3.87 | 3.87 | 3.87 |
| | M-2 | | | | | | | |
| | M-3 | | | | | | | |
| Polymerization initiator | Ini-1 | | | | | | | |
| | Ini-2 | 1.58 | 1.58 | 1.58 | 1.58 | 1.58 | 1.58 | 1.58 |
| | Ini-3 | | | | | | | |
| | Ini-4 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Coloring material dispersion liquid | Kind | CA8 | CA9 | CA10 | CA11 | CA12 | CA13 | CA14 |
| | Formulation amount | 78.00 | 78.00 | 78.00 | 78.00 | 78.00 | 78.00 | 78.00 |
| Evaluation compound | Kind | S-4 | S-5 | S-6 | S-7 | S-8 | S-9 | S-10 |
| | Amount (%) | 5.0 | 5.0 | 5.0 | 5.0 | 5.0 | 5.0 | 5.0 |
| Evaluation result | Residue | A | A | A | A | A | A | A |
| | Adhesiveness | A | A | A | A | A | A | A |
| | UC evaluation | A | A | A | A | A | A | A |

[Table 43]

| | | Example 315 | Example 316 | Example 317 | Example 318 | Example 319 | Example 320 | Example 321 |
|---|---|---|---|---|---|---|---|---|
| Solvent | PGMEA | 16.53 | 16.53 | 16.53 | 16.53 | 16.53 | 16.53 | 16.53 |
| Resin | B-1 | | | | | | | |
| | B-2 | | | | | | | |
| Polymerizable compound | M-1 | 3.87 | 3.87 | 3.87 | 3.87 | 3.87 | 3.87 | 3.87 |
| | M-2 | | | | | | | |
| | M-3 | | | | | | | |
| Polymerization initiator | Ini-1 | | | | | | | |
| | Ini-2 | 1.58 | 1.58 | 1.58 | 1.58 | 1.58 | 1.58 | 1.58 |
| | Ini-3 | | | | | | | |
| | Ini-4 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Coloring material dispersion liquid | Kind | CA15 | CA16 | CA17 | CA18 | CA19 | CA20 | CA21 |
| | Formulation amount | 78.00 | 78.00 | 78.00 | 78.00 | 78.00 | 78.00 | 78.00 |
| Evaluation compound | Kind | S-11 | S-12 | S-13 | S-15 | S-16 | S-17 | S-18 |
| | Amount (%) | 5.0 | 5.0 | 5.0 | 5.0 | 5.0 | 5.0 | 5.0 |
| Evaluation result | Residue | A | A | A | A | A | A | A |
| | Adhesiveness | A | A | A | A | A | A | A |
| | UC evaluation | A | A | B | A | A | A | A |

[Table 44]

| | | Example 322 | Example 323 | Example 324 | Example 325 | Example 326 | Example 327 | Example 328 |
|---|---|---|---|---|---|---|---|---|
| Solvent | PGMEA | 16.53 | 16.53 | 15.16 | 15.16 | 15.16 | 15.16 | 15.16 |
| Resin | B-1 | | | 0.066 | | | | |
| | B-2 | | | | 0.066 | 0.066 | 0.066 | 0.066 |
| Polymerizable compound | M-1 | 3.87 | 3.87 | 4.80 | 4.80 | | | 4.80 |
| | M-2 | | | | | 4.80 | | |
| | M-3 | | | | | | 4.80 | |
| Polymerization initiator | Ini-1 | | | | | | | 1.95 |
| | Ini-2 | 1.58 | 1.58 | 1.95 | 1.95 | 1.95 | 1.95 | |
| | Ini-3 | | | | | | | |
| | Ini-4 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Coloring material dispersion liquid | Kind | CA22 | CA23 | CA2 | CA2 | CA2 | CA2 | CA2 |
| | Formulation amount | 78.00 | 78.00 | 78.00 | 78.00 | 78.00 | 78.00 | 78.00 |
| Evaluation compound | Kind | S-19 | S-20 | S-1 | S-1 | S-1 | S-1 | S-1 |
| | Amount (%) | 5.0 | 5.0 | 1.0 | 1.0 | 1.0 | 1.0 | 1.0 |
| Evaluation result | Residue | A | A | A | A | A | A | A |
| | Adhesiveness | A | A | A | A | A | A | A |
| | UC evaluation | A | A | A | A | A | A | A |

[Table 45]

| | | Example 329 | Example 330 | Example 331 | Example 332 | Example 333 | Comparative Example 301 | Comparative Example 302 |
|---|---|---|---|---|---|---|---|---|
| Solvent | PGMEA | 15.16 | 15.16 | 15.16 | 15.16 | 15.16 | 14.85 | 16.53 |
| Resin | B-1 | | | | | | 0.38 | |
| | B-2 | 0.066 | 0.066 | 0.066 | 0.066 | 0.066 | | |
| Polymerizable compound | M-1 | 4.80 | 4.80 | 4.80 | 4.80 | 4.80 | 4.80 | 3.87 |
| | M-2 | | | | | | | |
| | M-3 | | | | | | | |
| Polymerization initiator | Ini-1 | | | | | | | |
| | Ini-2 | | | | | | | 1.58 |
| | Ini-3 | 1.95 | | 1.95 | 1.95 | 1.95 | 1.95 | |
| | Ini-4 | | 1.95 | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | 0.021 | | | | |
| | W-2 | 0.021 | 0.021 | | | | 0.021 | 0.021 |
| | W-3 | | | | 0.021 | | | |
| | W-4 | | | | | 0.021 | | |
| Coloring material dispersion liquid | Kind | CA2 | CA2 | CA2 | CA2 | CA2 | CB1 | CB2 |
| | Formulation amount | 78.00 | 78.00 | 78.00 | 78.00 | 78.00 | 78.00 | 78.00 |
| Evaluation compound | Kind | S-1 | S-1 | S-1 | S-1 | S-1 | - | S-1 |
| | Amount (%) | 1.0 | 1.0 | 1.0 | 1.0 | 1.0 | 0.0 | 5.0 |
| Evaluation result | Residue | A | A | A | A | A | D | D |
| | Adhesiveness | A | A | A | A | A | A | A |
| | UC evaluation | A | A | A | A | A | A | A |

[Table 46]

| | | Example 401 | Example 402 | Example 403 | Example 404 | Example 405 | Example 406 | Example 407 |
|---|---|---|---|---|---|---|---|---|
| Solvent | PGMEA | 14.94 | 15.16 | 16.53 | 18.40 | 15.16 | 18.40 | 16.53 |
| Resin | B-1 | | | | | | | |
| | B-2 | | | | | | | |
| Polymerizable compound | M-1 | 5.00 | 4.84 | 3.87 | 2.54 | 4.84 | 2.54 | 3.87 |
| | M-2 | | | | | | | |
| | M-3 | | | | | | | |
| Polymerization initiator | Ini-1 | | | | | | | |
| | Ini-2 | 2.04 | 1.97 | 1.58 | 1.04 | 1.97 | 1.04 | 1.58 |
| | Ini-3 | | | | | | | |
| | Ini-4 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Coloring material dispersion liquid | Kind | DA1 | DA2 | DA3 | DA4 | DA5 | DA6 | DA7 |
| | Formulation amount | 78.00 | 78.00 | 78.00 | 78.00 | 78.00 | 78.00 | 78.00 |
| Evaluation compound | Kind | S-1 | S-1 | S-1 | S-1 | S-2 | S-2 | S-3 |
| | Amount (%) | 0.3 | 1.0 | 5.0 | 10.0 | 1.0 | 10.0 | 5.0 |
| Evaluation result | Residue | B | A | A | A | A | A | A |
| | Adhesiveness | A | A | A | A | A | A | A |
| | UC evaluation | A | A | A | A | A | A | A |

[Table 47]

| | | Example 408 | Example 409 | Example 410 | Example 411 | Example 412 | Example 413 | Example 414 |
|---|---|---|---|---|---|---|---|---|
| Solvent | PGMEA | 16.53 | 16.53 | 16.53 | 16.53 | 16.53 | 16.53 | 16.53 |
| Resin | B-1 | | | | | | | |
| | B-2 | | | | | | | |
| Polymerizable compound | M-1 | 3.87 | 3.87 | 3.87 | 3.87 | 3.87 | 3.87 | 3.87 |
| | M-2 | | | | | | | |
| | M-3 | | | | | | | |
| Polymerization initiator | Ini-1 | | | | | | | |
| | Ini-2 | 1.58 | 1.58 | 1.58 | 1.58 | 1.58 | 1.58 | 1.58 |
| | Ini-3 | | | | | | | |
| | Ini-4 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Coloring material dispersion liquid | Kind | DA8 | DA9 | DA10 | DA11 | DA12 | DA13 | DA14 |
| | Formulation amount | 78.00 | 78.00 | 78.00 | 78.00 | 78.00 | 78.00 | 78.00 |
| Evaluation compound | Kind | S-4 | S-5 | S-6 | S-7 | S-8 | S-9 | S-10 |
| | Amount (%) | 5.0 | 5.0 | 5.0 | 5.0 | 5.0 | 5.0 | 5.0 |
| Evaluation result | Residue | A | A | A | A | A | A | A |
| | Adhesiveness | A | A | A | A | A | A | A |
| | UC evaluation | A | A | A | A | A | A | A |

[Table 48]

| | | Example 415 | Example 416 | Example 417 | Example 418 | Example 419 | Example 420 | Example 421 |
|---|---|---|---|---|---|---|---|---|
| Solvent | PGMEA | 16.53 | 16.53 | 16.53 | 16.53 | 16.53 | 16.53 | 16.53 |
| Resin | B-1 | | | | | | | |
| | B-2 | | | | | | | |
| Polymerizable compound | M-1 | 3.87 | 3.87 | 3.87 | 3.87 | 3.87 | 3.87 | 3.87 |
| | M-2 | | | | | | | |
| | M-3 | | | | | | | |
| Polymerization initiator | Ini-1 | | | | | | | |
| | Ini-2 | 1.58 | 1.58 | 1.58 | 1.58 | 1.58 | 1.58 | 1.58 |
| | Ini-3 | | | | | | | |
| | Ini-4 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Coloring material dispersion liquid | Kind | DA15 | DA16 | DA17 | DA18 | DA19 | DA20 | DA21 |
| | Formulation amount | 78.00 | 78.00 | 78.00 | 78.00 | 78.00 | 78.00 | 78.00 |
| Evaluation compound | Kind | S-11 | S-12 | S-13 | S-15 | S-16 | S-17 | S-18 |
| | Amount (%) | 5.0 | 5.0 | 5.0 | 5.0 | 5.0 | 5.0 | 5.0 |
| Evaluation result | Residue | A | A | A | A | A | A | A |
| | Adhesiveness | A | A | A | A | A | A | A |
| | UC evaluation | A | A | B | A | A | A | A |

[Table 49]

| | | Example 422 | Example 423 | Example 424 | Example 425 | Example 426 | Example 427 | Example 428 |
|---|---|---|---|---|---|---|---|---|
| Solvent | PGMEA | 16.53 | 16.53 | 15.16 | 15.16 | 15.16 | 15.16 | 15.16 |
| Resin | B-1 | | | 0.066 | | | | |
| | B-2 | | | | 0.066 | 0.066 | 0.066 | 0.066 |
| Polymerizable compound | M-1 | 3.87 | 3.87 | 4.80 | 4.80 | | | 4.80 |
| | M-2 | | | | | 4.80 | | |
| | M-3 | | | | | | 4.80 | |
| Polymerization initiator | Ini-1 | | | | | | | 1.95 |
| | Ini-2 | 1.58 | 1.58 | 1.95 | 1.95 | 1.95 | 1.95 | |
| | Ini-3 | | | | | | | |
| | Ini-4 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Coloring material dispersion liquid | Kind | DA22 | DA23 | DA2 | DA2 | DA2 | DA2 | DA2 |
| | Formulation amount | 78.00 | 78.00 | 78.00 | 78.00 | 78.00 | 78.00 | 78.00 |
| Evaluation compound | Kind | S-19 | S-20 | S-1 | S-1 | S-1 | S-1 | S-1 |
| | Amount (%) | 5.0 | 5.0 | 1.0 | 1.0 | 1.0 | 1.0 | 1.0 |
| Evaluation result | Residue | A | A | A | A | A | A | A |
| | Adhesiveness | A | A | A | A | A | A | A |
| | UC evaluation | A | A | A | A | A | A | A |

[Table 50]

| | | Example 429 | Example 430 | Example 431 | Example 432 | Example 433 | Comparative Example 401 | Comparative Example 402 |
|---|---|---|---|---|---|---|---|---|
| Solvent | PGMEA | 15.16 | 15.16 | 15.16 | 15.16 | 15.16 | 14.85 | 16.53 |
| Resin | B-1 | | | | | | 0.38 | |
| | B-2 | 0.066 | 0.066 | 0.066 | 0.066 | 0.066 | | |
| Polymerizable compound | M-1 | 4.80 | 4.80 | 4.80 | 4.80 | 4.80 | 4.80 | 3.87 |
| | M-2 | | | | | | | |
| | M-3 | | | | | | | |
| Polymerization initiator | Ini-1 | | | | | | | |
| | Ini-2 | | | | | | | 1.58 |
| | Ini-3 | 1.95 | | 1.95 | 1.95 | 1.95 | 1.95 | |
| | Ini-4 | | 1.95 | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | 0.021 | | | | |
| | W-2 | 0.021 | 0.021 | | | | 0.021 | 0.021 |
| | W-3 | | | | 0.021 | | | |
| | W-4 | | | | | 0.021 | | |
| Coloring material dispersion liquid | Kind | DA2 | DA2 | DA2 | DA2 | DA2 | DB1 | DB2 |
| | Formulation amount | 78.00 | 78.00 | 78.00 | 78.00 | 78.00 | 78.00 | 78.00 |
| Evaluation compound | Kind | S-1 | S-1 | S-1 | S-1 | S-1 | - | S-1 |
| | Amount (%) | 1.0 | 1.0 | 1.0 | 1.0 | 1.0 | 0.0 | 5.0 |
| Evaluation result | Residue | A | A | A | A | A | D | D |
| | Adhesiveness | A | A | A | A | A | A | A |
| | UC evaluation | A | A | A | A | A | A | A |

[Table 51]

| | | Example 501 | Example 502 | Example 503 | Example 504 | Example 505 | Example 506 | Example 507 |
|---|---|---|---|---|---|---|---|---|
| Solvent | PGMEA | 14.94 | 15.16 | 16.53 | 18.40 | 15.16 | 18.40 | 16.53 |
| Resin | B-1 | | | | | | | |
| | B-2 | | | | | | | |
| Polymerizable compound | M-1 | 5.00 | 4.84 | 3.87 | 2.54 | 4.84 | 2.54 | 3.87 |
| | M-2 | | | | | | | |
| | M-3 | | | | | | | |
| | M-4 | | | | | | | |
| Polymerization initiator | Ini-1 | | | | | | | |
| | Ini-2 | 2.04 | 1.97 | 1.58 | 1.04 | 1.97 | 1.04 | 1.58 |
| | Ini-3 | | | | | | | |
| | Ini-4 | | | | | | | |
| | Ini-5 | | | | | | | |
| | Ini-6 | | | | | | | |
| | Ini-7 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Particle | T-1 | | | | | | | |
| Coloring material dispersion liquid | Kind | EA1 | EA2 | EA3 | EA4 | EA5 | EA6 | EA7 |
| | Formulation amount | 78.00 | 78.00 | 78.00 | 78.00 | 78.00 | 78.00 | 78.00 |
| Evaluation compound | Kind | S-1 | S-1 | S-1 | S-1 | S-2 | S-2 | S-3 |
| | Amount (%) | 0.3 | 1.0 | 5.0 | 10.0 | 1.0 | 10.0 | 5.0 |

(continued)

| | | Example 501 | Example 502 | Example 503 | Example 504 | Example 505 | Example 506 | Example 507 |
|---|---|---|---|---|---|---|---|---|
| Solvent | PGMEA | 14.94 | 15.16 | 16.53 | 18.40 | 15.16 | 18.40 | 16.53 |
| Evaluation result | Residue | B | A | A | A | A | A | A |
| | Adhesiveness | A | A | A | A | A | A | A |
| | UC evaluation | A | A | A | A | A | A | A |

[Table 52]

| | | Example 508 | Example 509 | Example 510 | Example 511 | Example 512 | Example 513 | Example 514 |
|---|---|---|---|---|---|---|---|---|
| Solvent | PGMEA | 16.53 | 16.53 | 16.53 | 16.53 | 16.53 | 16.53 | 16.53 |
| Resin | B-1 | | | | | | | |
| | B-2 | | | | | | | |
| Polymerizable compound | M-1 | 3.87 | 3.87 | 3.87 | 3.87 | 3.87 | 3.87 | 3.87 |
| | M-2 | | | | | | | |
| | M-3 | | | | | | | |
| | M-4 | | | | | | | |
| Polymerization initiator | Ini-1 | | | | | | | |
| | Ini-2 | 1.58 | 1.58 | 1.58 | 1.58 | 1.58 | 1.58 | 1.58 |
| | Ini-3 | | | | | | | |
| | Ini-4 | | | | | | | |
| | Ini-5 | | | | | | | |
| | Ini-6 | | | | | | | |
| | Ini-7 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Particle | T-1 | | | | | | | |
| Coloring material dispersion liquid | Kind | EA8 | EA9 | EA10 | EA11 | EA12 | EA13 | EA14 |
| | Formulation amount | 78.00 | 78.00 | 78.00 | 78.00 | 78.00 | 78.00 | 78.00 |
| Evaluation compound | Kind | S-4 | S-5 | S-6 | S-7 | S-8 | S-9 | S-10 |
| | Amount (%) | 5.0 | 5.0 | 5.0 | 5.0 | 5.0 | 5.0 | 5.0 |

(continued)

| | | Example 508 | Example 509 | Example 510 | Example 511 | Example 512 | Example 513 | Example 514 |
|---|---|---|---|---|---|---|---|---|
| Solvent | PGMEA | 16.53 | 16.53 | 16.53 | 16.53 | 16.53 | 16.53 | 16.53 |
| Evaluation result | Residue | A | A | A | A | A | A | A |
| | Adhesiveness | A | A | A | A | A | A | A |
| | UC evaluation | A | A | A | A | A | A | A |

[Table 53]

| | | Example 515 | Example 516 | Example 517 | Example 518 | Example 519 | Example 520 | Example 521 |
|---|---|---|---|---|---|---|---|---|
| Solvent | PGMEA | 16.53 | 16.53 | 16.53 | 16.53 | 16.53 | 16.53 | 16.53 |
| Resin | B-1 | | | | | | | |
| | B-2 | | | | | | | |
| Polymerizable compound | M-1 | 3.87 | 3.87 | 3.87 | 3.87 | 3.87 | 3.87 | 3.87 |
| | M-2 | | | | | | | |
| | M-3 | | | | | | | |
| | M-4 | | | | | | | |
| Polymerization initiator | Ini-1 | | | | | | | |
| | Ini-2 | 1.58 | 1.58 | 1.58 | 1.58 | 1.58 | 1.58 | 1.58 |
| | Ini-3 | | | | | | | |
| | Ini-4 | | | | | | | |
| | Ini-5 | | | | | | | |
| | Ini-6 | | | | | | | |
| | Ini-7 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Particle | T-1 | | | | | | | |
| Coloring material dispersion liquid | Kind | EA15 | EA16 | EA17 | EA18 | EA19 | EA20 | EA21 |
| | Formulation amount | 78.00 | 78.00 | 78.00 | 78.00 | 78.00 | 78.00 | 78.00 |
| Evaluation compound | Kind | S-11 | S-12 | S-13 | S-15 | S-16 | S-17 | S-18 |
| | Amount (%) | 5.0 | 5.0 | 5.0 | 5.0 | 5.0 | 5.0 | 5.0 |

(continued)

| | | Example 515 | Example 516 | Example 517 | Example 518 | Example 519 | Example 520 | Example 521 |
|---|---|---|---|---|---|---|---|---|
| Solvent | PGMEA | 16.53 | 16.53 | 16.53 | 16.53 | 16.53 | 16.53 | 16.53 |
| Evaluation result | Residue | A | A | A | A | A | A | A |
| | Adhesiveness | A | A | A | A | A | A | A |
| | UC evaluation | A | A | B | A | A | A | A |

[Table 54]

| | | Example 522 | Example 523 | Example 524 | Example 525 | Example 526 | Example 527 | Example 528 |
|---|---|---|---|---|---|---|---|---|
| Solvent | PGMEA | 16.53 | 16.53 | 15.16 | 15.16 | 15.16 | 15.16 | 15.16 |
| Resin | B-1 | | | 0.066 | | | | |
| | B-2 | | | | 0.066 | 0.066 | 0.066 | 0.066 |
| Polymerizable compound | M-1 | 3.87 | 3.87 | 4.80 | 4.80 | | | 4.80 |
| | M-2 | | | | | 4.80 | | |
| | M-3 | | | | | | 4.80 | |
| | M-4 | | | | | | | |
| Polymerization initiator | Ini-1 | | | | | | | 1.95 |
| | Ini-2 | 1.58 | 1.58 | 1.95 | 1.95 | 1.95 | 1.95 | |
| | Ini-3 | | | | | | | |
| | Ini-4 | | | | | | | |
| | Ini-5 | | | | | | | |
| | Ini-6 | | | | | | | |
| | Ini-7 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | 0.021 | 0.021 | 0.021 | 0.021 | 0.021 | 0.021 | 0.021 |
| | W-3 | | | | | | | |
| | W-4 | | | | | | | |
| Particle | T-1 | | | | | | | |
| Coloring material dispersion liquid | Kind | EA22 | EA23 | EA2 | EA2 | EA2 | EA2 | EA2 |
| | Formulation amount | 78.00 | 78.00 | 78.00 | 78.00 | 78.00 | 78.00 | 78.00 |
| Evaluation compound | Kind | S-19 | S-20 | S-1 | S-1 | S-1 | S-1 | S-1 |
| | Amount (%) | 5.0 | 5.0 | 1.0 | 1.0 | 1.0 | 1.0 | 1.0 |

(continued)

| | | Example 522 | Example 523 | Example 524 | Example 525 | Example 526 | Example 527 | Example 528 |
|---|---|---|---|---|---|---|---|---|
| Evaluation result | Residue | A | A | A | A | A | A | A |
| | Adhesiveness | A | A | A | A | A | A | A |
| | UC evaluation | A | A | A | A | A | A | A |

[Table 55]

| | | Example 529 | Example 530 | Example 531 | Example 532 | Example 533 | Example 534 | Example 535 |
|---|---|---|---|---|---|---|---|---|
| Solvent | PGMEA | 15.16 | 15.16 | 15.16 | 15.16 | 15.16 | 15.16 | 15.16 |
| Resin | B-1 | | | | | | | |
| | B-2 | 0.066 | 0.066 | 0.066 | 0.066 | 0.066 | 0.066 | 0.066 |
| Polymerizable compound | M-1 | 4.80 | 4.80 | 4.80 | 4.80 | 4.80 | 4.80 | 4.80 |
| | M-2 | | | | | | | |
| | M-3 | | | | | | | |
| | M-4 | | | | | | | |
| Polymerization initiator | Ini-1 | | | | | | | |
| | Ini-2 | | | | | | | |
| | Ini-3 | 1.95 | | | | | 1.95 | 1.95 |
| | Ini-4 | | 1.95 | | | | | |
| | Ini-5 | | | 1.95 | | | | |
| | Ini-6 | | | | 1.95 | | | |
| | Ini-7 | | | | | 1.95 | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | 0.021 | |
| | W-2 | 0.021 | 0.021 | 0.021 | 0.021 | 0.021 | | |
| | W-3 | | | | | | | 0.021 |
| | W-4 | | | | | | | |
| Particle | T-1 | | | | | | | |
| Coloring material dispersion liquid | Kind | EA2 | EA2 | EA2 | EA2 | EA2 | EA2 | EA2 |
| | Formulation amount | 78.00 | 78.00 | 78.00 | 78.00 | 78.00 | 78.00 | 78.00 |
| Evaluation compound | Kind | S-1 | S-1 | S-1 | S-1 | S-1 | S-1 | S-1 |
| | Amount (%) | 1.0 | 1.0 | 1.0 | 1.0 | 1.0 | 1.0 | 1.0 |

(continued)

| | | Example 529 | Example 530 | Example 531 | Example 532 | Example 533 | Example 534 | Example 535 |
|---|---|---|---|---|---|---|---|---|
| Evaluation result | Residue | A | A | A | A | A | A | A |
| | Adhesiveness | A | A | A | A | A | A | A |
| | UC evaluation | A | A | A | A | A | A | A |

[Table 56]

| | | Example 536 | Example 537 | Example 538 | Example 539 | Example 540 | Comparative E xample 501 | Comparative E xample 502 |
|---|---|---|---|---|---|---|---|---|
| Solvent | PGMEA | 15.16 | 16.47 | 11.47 | 16.47 | 11.47 | 14.85 | 14.89 |
| Resin | B-1 | | 0.30 | 0.30 | 0.30 | 0.30 | 0.38 | |
| | B-2 | 0.066 | | | | | | |
| Polymerizable compound | M-1 | 4.80 | | | | | 4.80 | 5.04 |
| | M-2 | | | | | | | |
| | M-3 | | | | | | | |
| | M-4 | | 4.18 | 4.18 | 4.18 | 4.18 | | |
| Polymerization initiator | Ini-1 | | | | | | | |
| | Ini-2 | | | | | | | |
| | Ini-3 | 1.95 | | | | | 1.95 | 2.05 |
| | Ini-4 | | 1.045 | 1.045 | 1.045 | 1.045 | | |
| | Ini-5 | | | | | | | |
| | Ini-6 | | | | | | | |
| | Ini-7 | | | | | | | |
| Polymerization inhibitor | A-1 | 0.002 | 0.002 | 0.002 | 0.002 | 0.002 | 0.002 | 0.002 |
| | A-2 | | | | | | | |
| Surfactant | W-1 | | | | | | | |
| | W-2 | | | | | | 0.021 | 0.021 |
| | W-3 | | 0.004 | 0.004 | 0.004 | 0.004 | | |
| | W-4 | 0.021 | | | | | | |
| Particle | T-1 | | | 5.000 | | 5000 | | |
| Coloring material dispersion liquid | Kind | EA2 | EA24 | EA24 | EA25 | EA25 | EB1 | EB2 |
| | Formulation amount | 78.00 | 78.00 | 78.00 | 78.00 | 78.00 | 78.00 | 78.00 |

(continued)

| | | Example 536 | Example 537 | Example 538 | Example 539 | Example 540 | Comparative E xample 501 | Comparative E xample 502 |
|---|---|---|---|---|---|---|---|---|
| Evaluation compound | Kind | S-1 | S-1 | S-1 | S-1 | S-1 | - | S-1 |
| | Amount (%) | 1.0 | 1.9 | 1.9 | 3.5 | 3.5 | 0.0 | 0.1 |
| Evaluation result | Residue | A | A | A | A | A | D | D |
| | Adhesiveness | A | A | A | A | A | A | A |
| | UC evaluation | A | A | A | A | A | A | A |

[Table 57]

| | | Comparative Example 503 | Comparative Example 504 | Comparative Example 505 |
|---|---|---|---|---|
| Solvent | PGMEA | 18.43 | 15.16 | 15.16 |
| Resin | B-1 | | | |
| | B-2 | | | |
| Polymerizable compound | M-1 | 2.52 | 4.84 | 4.84 |
| | M-2 | | | |
| | M-3 | | | |
| | M-4 | | | |
| Polymerization initiator | Ini-1 | | | |
| | Ini-2 | 1.03 | 1.97 | 1.97 |
| | Ini-3 | | | |
| | Ini-4 | | | |
| | Ini-5 | | | |
| | Ini-6 | | | |
| | Ini-7 | | | |
| Polymerization inhibitor | A-1 | 0.002 | 0.002 | 0.002 |
| | A-2 | | | |
| Surfactant | W-1 | | | |
| | W-2 | 0.021 | 0.021 | 0.021 |
| | W-3 | | | |
| | W-4 | | | |
| Particle | T-1 | | | |
| Coloring material dispersion liquid | Kind | EB3 | EB4 | EB5 |
| | Formulation amount | 78.00 | 78.00 | 78.00 |
| Evaluation compound | Kind | S-1 | S-1 | S-14 |
| | Amount (%) | 11.0 | 1.0 | 1.0 |
| Evaluation result | Residue | A | D | C |
| | Adhesiveness | C | A | D |
| | UC evaluation | C | A | D |

From the results shown in the above tables, it has been confirmed that the composition according to the embodiment of the present invention makes it possible to form a pattern having excellent adhesiveness and is excellent in residue suppressibility.

It has been also confirmed that the composition according to the embodiment of the present invention makes it possible to form a pattern in which undercut is suppressed.

In addition, it has been confirmed that the effect of the present invention is more excellent in a case where the content of the acid anhydride is 0.5% to 8.0% by mass with respect to the total solid content of the composition (see the comparison and the like between the results of Examples 101 to 104).

In addition, it has been confirmed that from Example 117 and other Examples, the effect of the present invention is more excellent in a case where the ClogP of the carboxylic acid anhydride is 5.00 or less.

It is noted that the same effect as in Example 137 was obtained even in a case where the trimellitic acid anhydride (S-1) of Example 137 was changed to succinic acid anhydride, pyromellitic acid anhydride, phthalic acid anhydride, tetrahydrophthalic acid anhydride, 4-methylphthalic acid anhydride, a glutaric acid anhydride, or 4,4'-biphthalic acid anhydride.

In addition, the same effect as in Example 138 was obtained even in a case where the trimellitic acid anhydride (S-1) of Example 138 was changed to succinic acid anhydride, pyromellitic acid anhydride, phthalic acid anhydride, tetrahydrophthalic acid anhydride, 4-methylphthalic acid anhydride, a glutaric acid anhydride, or 4,4'-biphthalic acid anhydride.

In addition, the same effect as in Example 139 was obtained even in a case where the trimellitic acid anhydride (S-1) of Example 139 was changed to succinic acid anhydride, pyromellitic acid anhydride, phthalic acid anhydride, tetrahydrophthalic acid anhydride, 4-methylphthalic acid anhydride, a glutaric acid anhydride, or 4,4'-biphthalic acid anhydride.

In addition, the same effect as in Example 140 was obtained even in a case where the trimellitic acid anhydride (S-1) of Example 140 was changed to succinic acid anhydride, pyromellitic acid anhydride, phthalic acid anhydride, tetrahydrophthalic acid anhydride, 4-methylphthalic acid anhydride, a glutaric acid anhydride, or 4,4'-biphthalic acid anhydride.

<Examples 601 to 607>

(Synthesis Example 1: Production of inorganic particle dispersion liquid T-2)

(Coating layer forming step)

To a solution obtained by mixing 150 parts by mass of THRULYA 4110 (manufactured by JGC Catalysts and Chemicals Ltd., concentration of solid contents: 20% by mass, an isopropyl alcohol solvent, a hollow silica sol, average primary particle diameter: 60 nm), 100 parts by mass of ethanol, 3 parts by mass of KP983 (manufactured by Shin-Etsu Silicone Co., Ltd.) which is a silane coupling agent containing a hydrophobic group, and 0.5 parts by mass of KBM-5803 (manufactured by Shin-Etsu Silicone Co., Ltd.) which is a silane coupling agent containing a methacrylate group, 1% by mass of 1% by mass aqueous ammonia was added, and the resultant mixture was stirred at 25°C for 72 hours.

(Purification treatment step)

The obtained solution was subjected to centrifugal separation (100,000 revolutions per minute), and a supernatant solution was discarded. 100 parts by mass of 1-methoxy-2-propanol was added to the precipitate, followed by stirring with a stirring blade to carry out redispersion, and then centrifugal separation was carried out again to remove a supernatant solution. Again, 1-methoxy-2-propanol was added to the precipitate so that the solid content was 30% by mass, and then stirring was carried out with a stirring blade to carry out redispersion, thereby preparing an inorganic particle dispersion liquid T-2. In the obtained modified inorganic particles, the content of the coating layer was 5 parts by mass with respect to 100 parts by mass of the modified inorganic particles. In addition, in the inorganic particle dispersion liquid T-2, the content of the uncoated substance was 0.5 parts by mass with respect to 100 parts by mass of the entire modified inorganic particles.

(Synthesis Example 2: Production of inorganic particle dispersion liquid T-3)

An inorganic particle dispersion liquid T-3 was prepared in the same manner as in Synthesis Example 1, except that KP983 was changed to a fluorine-containing silane coupling agent of the following formula and KBM-5803 was changed to 3-glycidoxypropyltrimethoxysilane. In the obtained modified inorganic particles, the content of the coating layer was 7 parts by mass with respect to 100 parts by mass of the modified inorganic particles. In addition, in the inorganic particle dispersion liquid T-3, the content of the uncoated substance was 0.1 parts by mass with respect to 100 parts by mass of the entire modified inorganic particles.

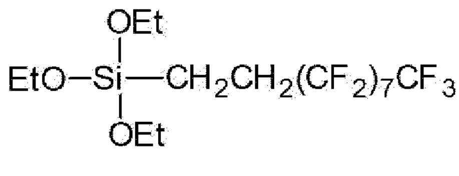

(Synthesis Example 3: Production of inorganic particle dispersion liquid T-4)

An inorganic particle dispersion liquid T-4 was prepared in the same manner as in Synthesis Example 1, except that THRULYA 4110 (150 parts by mass) was changed to 100 parts by mass of IPA-ST-L (manufactured by Nissan Chemical Corporation, an isopropanol dispersion liquid of solid silica particles, concentration of solid contents: 30% by mass, average primary particle diameter: 45 nm), and KBM-5803 was changed to 3-acryloxypropyltrimethoxysilane. In the obtained modified inorganic particles, the content of the coating layer was 3 parts by mass with respect to 100 parts by mass of the modified inorganic particles. In addition, in the inorganic particle dispersion liquid T-4, the content of the uncoated substance was 0.3 parts by mass with respect to 100 parts by mass of the modified inorganic particles.

(Synthesis Example 4: Production of inorganic particle dispersion liquid T-5)

An inorganic particle dispersion liquid T-5 was prepared in the same manner as in Synthesis Example 1, except that THRULYA 4110 (150 parts by mass) was changed to 100 parts by mass of IPA-ST-L (manufactured by Nissan Chemical Corporation, an isopropanol dispersion liquid of solid silica particles, concentration of solid contents: 30% by mass, average primary particle diameter: 45 nm), and KBM-5803 was changed to 3-ureidopropyltrialkoxysilane. In the obtained modified inorganic particles, the content of the coating layer was 2.5 parts by mass with respect to 100 parts by mass of the modified inorganic particles. In addition, in the inorganic particle dispersion liquid T-4, the content of the uncoated substance was 2 parts by mass with respect to 100 parts by mass of the modified inorganic particles.

[Preparation of coloring material dispersion liquid FA1]

A resin DISPERBYK-21116 (manufactured by BYK JAPAN KK, 6.7 parts by mass) having a tertiary amino group and a quaternary ammonium salt, and S-1 (0.79 parts by mass) as an evaluation compound were added to zirconium nitride (manufactured by Nisshin Engineering Inc., 25 parts by mass), and further, propylene glycol monomethyl ether acetate (PGMEA) and cyclopentanone was added thereto at a ratio (mass ratio) of 74.6:25.4 so that the total amount was 100 parts by mass, thereby obtaining a dispersion. The obtained dispersion was sufficiently stirred with a stirrer to carry out pre-mixing. The obtained dispersion was subjected to a dispersion treatment under the following conditions using NPM Pilot (a beads mill) manufactured by SHINMARU ENTERPRISES CORPORATION, thereby obtaining a coloring material dispersion liquid FA1. The average particle diameter of the zirconium nitride in the obtained dispersion liquid was 49 nm.

(Dispersion conditions)

- Bead diameter: φ 0.05 mm
- Bead filling rate: 65% by volume
- Circumferential speed of mill: 10 m/sec
- Circumferential speed of separator: 11 m/s
- Amount of mixed solution subjected to dispersion treatment: 15.0 kg
- Circulation flow rate (pump supply rate): 60 kg/hour
- Temperature of treatment liquid: 20°C to 25°C
- Cooling water: Tap water of 5°C
- Inner volume of annular passage of beads mill: 2.2 L
- Number of passes: 84 passes

The above-described raw materials were used and mixed according to the formulations (in terms of parts by mass) described in Table 58 shown in the latter part to prepare a composition (a black photosensitive composition) of Example.

The above-described evaluations were carried out using the obtained composition. The results are shown in Table 58.

[Table 58]

| | | Example 601 | Example 602 | Example 603 | Example 604 | Example 605 | Example 606 | Example 607 |
|---|---|---|---|---|---|---|---|---|
| Solvent | PGMEA | 8.16 | 9.53 | 9.48 | 87.47 | 9.47 | 9.47 | 8.16 |
| Resin | B-1 | | | 0.30 | 0.30 | | 0.30 | |
| | B-2 | | | | | 0.30 | | |
| Polymerizable compound | M-1 | 4.84 | 3.87 | | | | | 4.84 |
| | M-2 | | | | 4.18 | | | |
| | M-3 | | | | | 4.18 | | |
| | M-4 | | | 4.18 | | | 4.18 | |
| Polymerization initiator | Ini-1 | | | | 1.045 | | | |
| | Ini-2 | 1.97 | 1.58 | | | | | 1.97 |
| | Ini-3 | | | | | 1.045 | | |
| | Ini-4 | | | 1.045 | | | 1.045 | |
| Polymerization inhibitor | A-1 | 0.002 | 0.002 | 0.002 | 0.002 | | 0.002 | 0.002 |
| | A-2 | | | | | 0.002 | | |
| Surfactant | W-1 | | | | 0.004 | | | |
| | W-2 | 0.021 | 0.021 | | | | | 0.021 |
| | W-3 | | | | | | 0.004 | |
| | W-4 | | | | | 0.004 | | |
| Inorganic particle dispersion liquid | T-2 | 700 | | | | | | 700 |
| | T-3 | | 700 | | | | | |
| | T-4 | | | 7000 | 7000 | 7000 | | |
| | T-5 | | | | | | 7.000 | |

(continued)

| | | Example 601 | Example 602 | Example 603 | Example 604 | Example 605 | Example 606 | Example 607 |
|---|---|---|---|---|---|---|---|---|
| Coloring material dispersion liquid | AA5 | 78.00 | | | | 78.00 | | |
| | AA14 | | 78.00 | | | | | |
| | AA24 | | | 78.00 | | | | |
| | AA25 | | | | | | 78.00 | |
| | DA5 | | | | | | | 78.00 |
| | FA1 | | | | 78.00 | | | |
| Evaluation compound | Kind | S-2 | S-10 | S-1 | S-1 | S-2 | S-1 | S-2 |
| | Amount (%) | 1.0 | 5.0 | 1.9 | 1.9 | 1.0 | 3.5 | 1.0 |
| Evaluation result | Residue | A | A | A | A | A | A | A |
| | Adhesiveness | A | A | A | A | A | A | A |
| | UC evaluation | A | A | A | A | A | A | A |

As shown in Table 58, it has been confirmed that the composition according to the embodiment of the present invention makes it possible to form a pattern having excellent adhesiveness and is excellent in residue suppressibility.
It is noted that it has been confirmed that the same effect as in Example 143 can be obtained even in a case where the coloring material dispersion liquid AA24 of Example 603 is replaced with the coloring material dispersion liquid BA1 or CA1 described above.
The same effect can be obtained even in a case where each of the coloring material dispersion liquids AA5, AA14, AA24, and AA25 in Examples 601 to 603 and 606 is replaced with the coloring material dispersion liquid FA1.

Explanation of References

10: headlight unit
12: light source
14: light shielding unit
16: lens
20: base body
22: light shielding film
23: opening portion
30: light distribution pattern
30a: edge
31: region
32: light distribution pattern
32a: edge
33: notched portion
100: solid-state imaging device
101: solid-state imaging element
102: imaging unit
103: cover glass
104: spacer
105: laminated substrate
106: chip substrate
107: circuit board
108: electrode pad
109: external connection terminal
110: through-electrode
111: lens layer
112: lens material
113: support
114, 115: light shielding film
201: light-receiving element
202: color filter
203: micro lens
204: substrate
205b: blue pixel
205r: red pixel
205g: green pixel
205bm: black matrix
206: p-well layer
207: reading gate part
208: vertical electric charge transfer path
209: element separation region
210: gate insulating film
211: vertical electric charge transfer electrode
212: light shielding film
213, 214: insulating film
215: planarization film
300: infrared sensor

310: solid-state imaging element
311: infrared absorption filter
312: color filter
313: infrared transmitting filter
314: resin film
315: micro lens
316: planarization film

## Claims

**1.** A black photosensitive composition comprising:

a black pigment;
a resin;
a carboxylic acid anhydride; and
a polymerizable compound,
wherein the carboxylic acid anhydride has a molecular weight of 50 to 550,
the carboxylic acid anhydride has a content of 0.30% to 10.0% by mass with respect to a total solid content of the black photosensitive composition, and
the black pigment has an average particle diameter of 250 nm or less.

**2.** The black photosensitive composition according to claim 1,

wherein the carboxylic acid anhydride is a cyclic carboxylic acid anhydride, and
a compound obtained by subjecting the cyclic carboxylic acid anhydride to ring opening has a pKa of -1.20 to 4.50.

**3.** The black photosensitive composition according to claim 1 or 2,
wherein the carboxylic acid anhydride has a ClogP value of 6.00 or less.

**4.** The black photosensitive composition according to any one of claims 1 to 3,
wherein the carboxylic acid anhydride has 1 to 40 carbon atoms.

**5.** The black photosensitive composition according to any one of claims 1 to 4,

wherein the carboxylic acid anhydride is a carboxylic acid anhydride selected from the group consisting of a carboxylic acid anhydride represented by Formula (P1) and a carboxylic acid anhydride represented by Formula (P2),

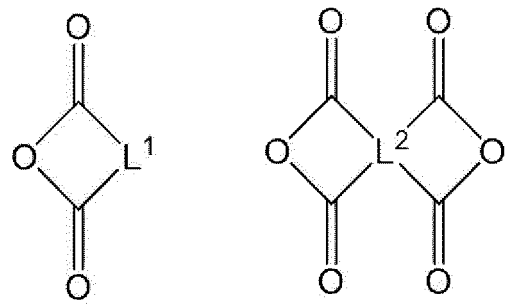

(P1) (P2)

$L^1$ represents a divalent organic group, and
$L^2$ represents a tetravalent organic group.

**6.** The black photosensitive composition according to claim 5,

wherein the divalent organic group represents an alkylene group which may have a substituent, an alkenylene group which may have a substituent, or an arylene group which may have a substituent,
a $-CH_2-$ group in the alkylene group may be substituted with a -NH- group,
in a case where the alkylene group has a plurality of substituents, the substituents may be bonded to each other to form a ring, in a case where the alkenylene group has a plurality of substituents, the substituents may be bonded to each other to form a ring, and in a case where the arylene group has a plurality of substituents, the substituents may be bonded to each other to form a ring,
the tetravalent organic group represents a tetravalent aromatic ring group which may have a substituent, a tetravalent aliphatic group which may have a substituent, a tetravalent group representative of Formula (Q1), or a tetravalent group represented by Formula (Q2), and
in a case where the tetravalent aromatic ring group has a plurality of substituents, the substituents may be bonded to each other to form a ring, and in a case where the tetravalent aliphatic group has a plurality of substituents, the substituents may be bonded to each other to form a ring,

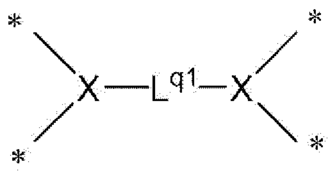
(Q1)

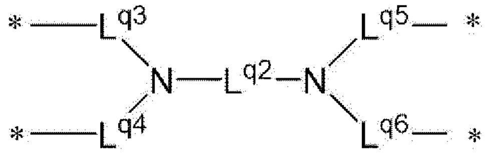
(Q2)

X's each independently represents a trivalent aromatic ring group or a trivalent aliphatic ring group,
$L^{q1}$ represents a single bond or a divalent linking group,
$L^{q2}$ represents a divalent linking group, $L^{q3}$ to $L^{q6}$ each independently represent an alkylene group, and
in Formulae (Q1) and (Q2), * represents a bonding position.

**7.** The black photosensitive composition according to any one of claims 1 to 6,
wherein the black pigment is one or more selected from the group consisting of titanium black, carbon black, and a bisbenzofuranone compound.

**8.** The black photosensitive composition according to any one of claims 1 to 7,

wherein the black photosensitive composition contains inorganic particles different from the black pigment, or the black photosensitive composition contains the inorganic particles different from the black pigment and modified inorganic particles having a coating layer that coats at least a part of the inorganic particles.

**9.** A production method for the black photosensitive composition according to any one of claims 1 to 8, the production method comprising:

a step 1 of mixing a pre-mixture containing the black pigment, the resin, and the carboxylic acid anhydride with a beads mill to obtain a mixture; and
a step 2 of mixing the mixture with the polymerizable compound to obtain the black photosensitive composition.

**10.** A cured film that is formed from the black photosensitive composition according to any one of claims 1 to 8.

**11.** A color filter comprising:
the cured film according to claim 10.

**12.** Alight shielding film comprising:
the cured film according to claim 10.

**13.** An optical element comprising:
the cured film according to claim 10.

**14.** A solid-state imaging element comprising:
the cured film according to claim 10.

**15.** A headlight unit of a lighting tool for a vehicle, comprising:

a light source; and
a light shielding unit that shields at least a part of light emitted from the light source,
wherein the light shielding unit includes the cured film according to claim 10.

FIG. 1

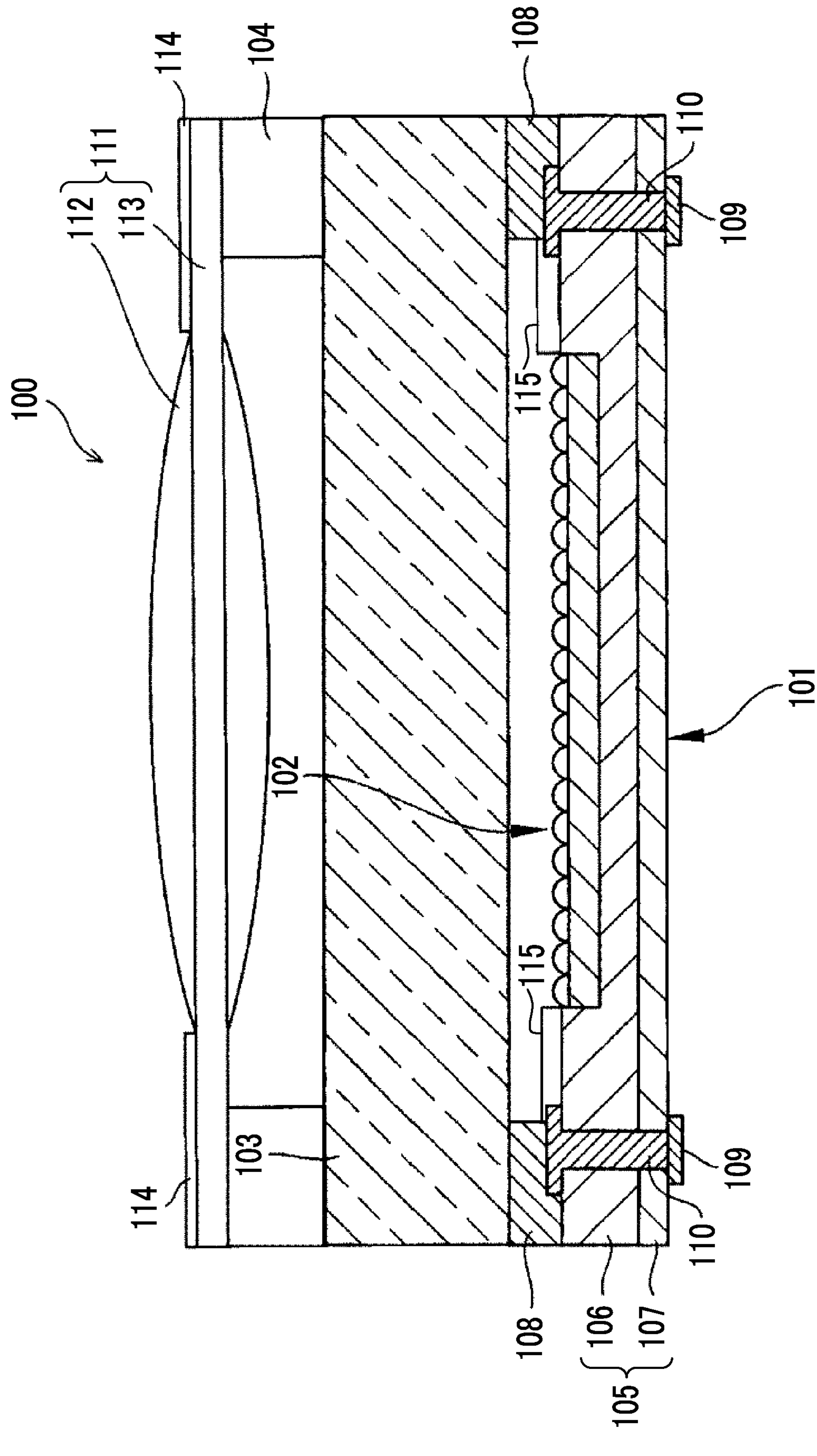
100
101
102
103
104
105
106
107
108
108
109
109
110
110
111
112
113
114
114
115
115

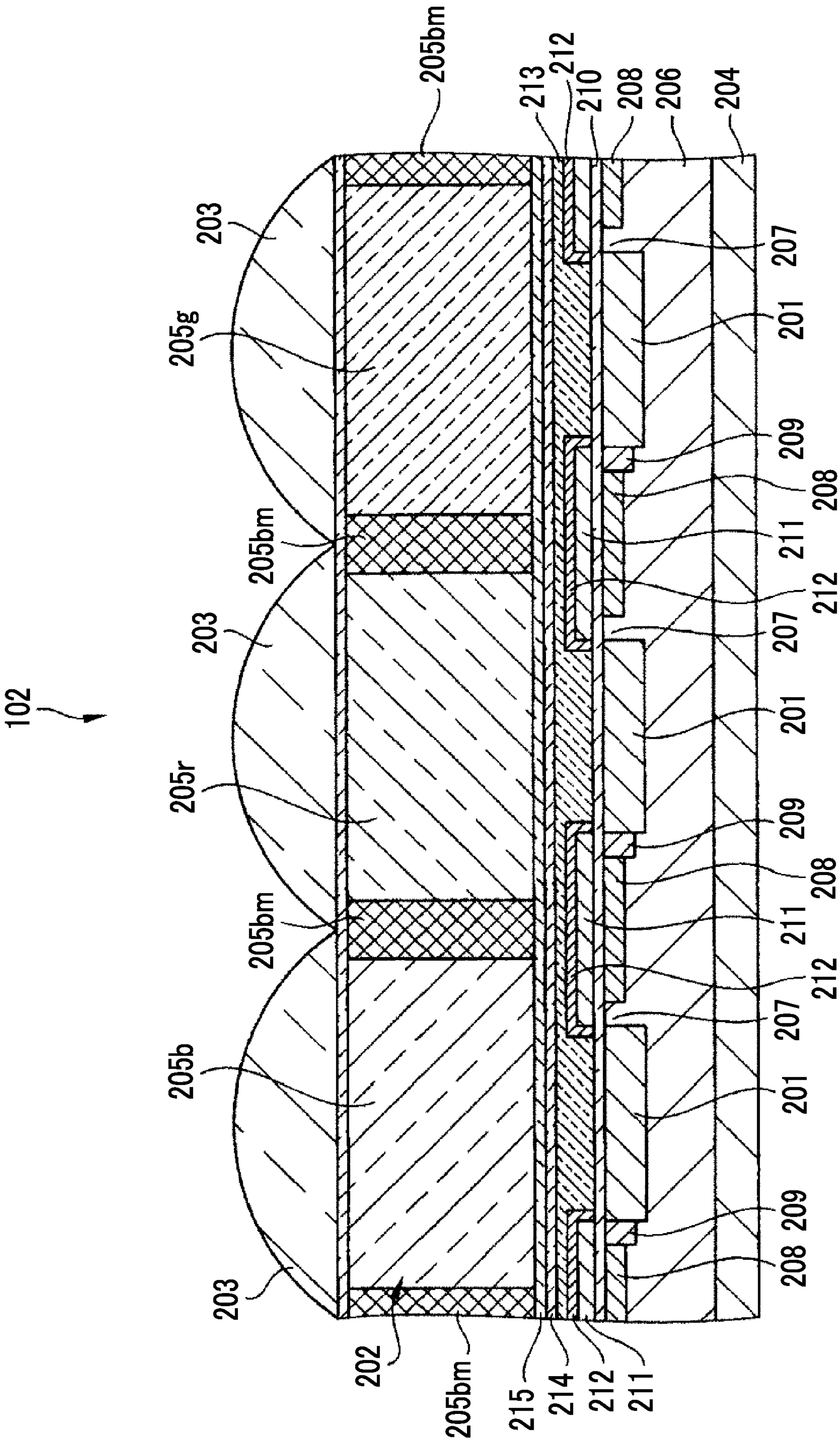
102
203
205g
205bm
205r
205b
202
215
214
213
212
211
210
209
208
207
206
204
201

FIG. 2

FIG. 3

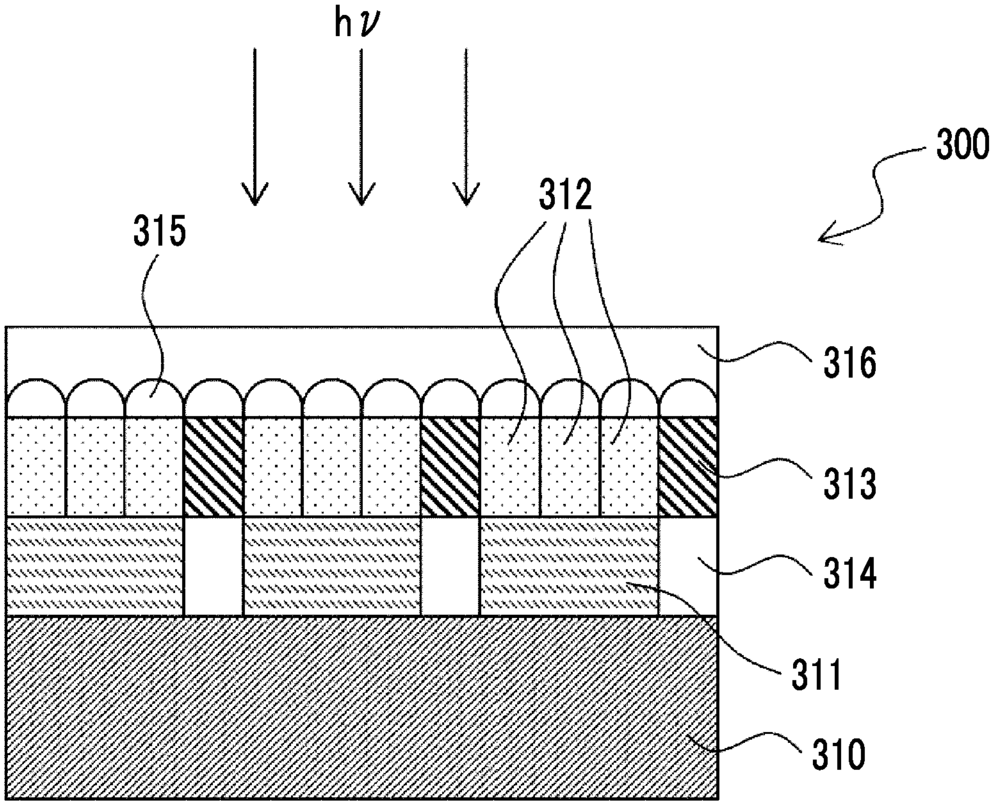


FIG. 4

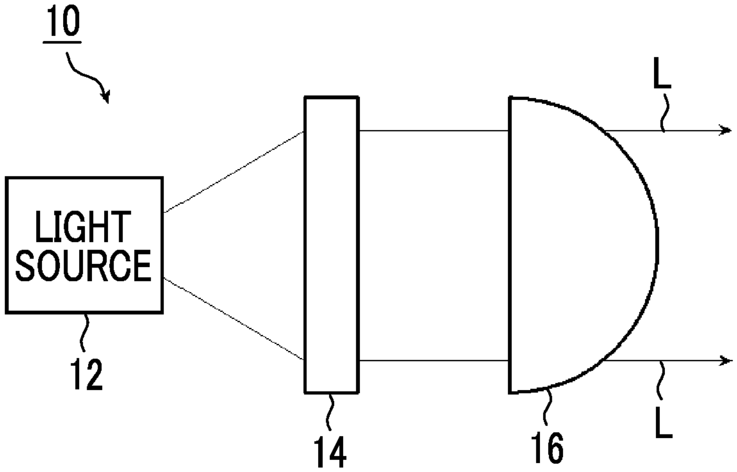

FIG. 5

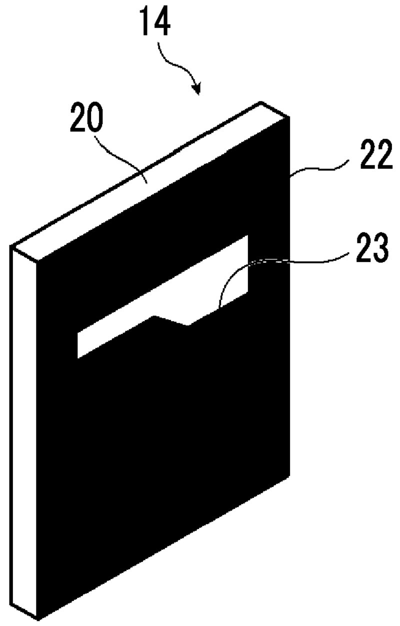


FIG. 6

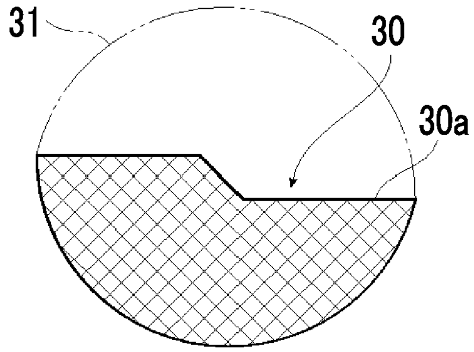


FIG. 7

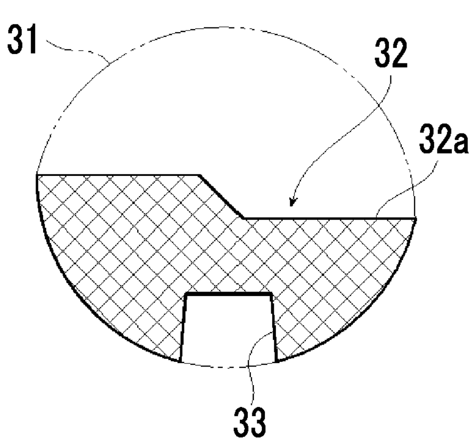

**INTERNATIONAL SEARCH REPORT**

International application No. **PCT/JP2022/013566**

**A. CLASSIFICATION OF SUBJECT MATTER**

***G02B 5/20***(2006.01)i; ***C09B 67/20***(2006.01)i; ***C09D 4/00***(2006.01)i; ***C09D 7/61***(2018.01)i; ***C09D 7/62***(2018.01)i; ***C09D 7/63***(2018.01)i; ***G02B 5/00***(2006.01)i; ***G03F 7/004***(2006.01)i; ***G03F 7/027***(2006.01)i; ***H01L 27/146***(2006.01)i
FI: G02B5/20 101; G03F7/004 505; C09B67/20 F; H01L27/146 D; G03F7/027; G02B5/00 Z; C09D4/00; C09D7/63; C09D7/61; C09D7/62; G03F7/004 501

According to International Patent Classification (IPC) or to both national classification and IPC

**B. FIELDS SEARCHED**

Minimum documentation searched (classification system followed by classification symbols)

G02B5/20; C09B67/20; C09D4/00; C09D7/61; C09D7/62; C09D7/63; G02B5/00; G03F7/004; G03F7/027; H01L27/146

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2008-203841 A (MITSUBISHI CHEMICALS CORP) 04 September 2008 (2008-09-04) paragraphs [0001], [0008], [0176], [0180], [0182], [0184], [0221], [0226], [0238]-[0239] | 1-7, 10-14<br>8-9, 14-15 |
| X<br>Y | JP 2009-145884 A (MITSUBISHI CHEMICALS CORP) 02 July 2009 (2009-07-02) paragraphs [0002], [0024], [0116], [0119]-[0121], [0170]-[0171] | 1-7, 10-13<br>8-9, 14-15 |
| Y | WO 2020/203080 A1 (FUJIFILM CORPORATION) 08 October 2020 (2020-10-08) paragraphs [0002], [0006], [0008], [0306]-[0308], [0371], [0374] | 8-9, 14-15 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **03 June 2022** | **14 June 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/013566**

| Patent document cited in search report | Publication date (day/month/year) | Patent family member(s) | Publication date (day/month/year) |
|---|---|---|---|
| JP 2008-203841 A | 04 September 2008 | (Family: none) | |
| JP 2009-145884 A | 02 July 2009 | (Family: none) | |
| WO 2020/203080 A1 | 08 October 2020 | KR 10-2021-0134712 A<br>TW 202041590 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005258254 A
- JP 2020180036 A
- JP 2020158377 A
- JP 2007302836 A
- JP 49005432 A
- JP S4905432 A
- JP 57205322 A
- JP S57205322 A
- JP 60065069 A
- JP S60065069 A
- JP 61201610 A
- JP S61201610 A
- JP 2008266045 A
- WO 2011049090 A
- JP 2009091205 A
- JP 2017222559 A
- WO 2019130772 A
- WO 2019059359 A
- JP 2010534726 A
- JP 2012515233 A
- JP 2012515234 A
- JP 62001753 A
- JP S62001753 A
- JP 63026784 B
- JP S63026784 B
- JP 2001233611 A
- JP 3272111 B
- JP 4328935 B
- JP 2013253145 A
- JP 2008260927 A
- JP 2015068893 A
- JP 2013029760 A
- JP 2008292970 A
- WO 2016088645 A
- JP 2010168539 A
- JP 2012208494 A
- US 20120235099 A
- JP 2012198408 A
- WO 2018230486 A
- JP 2018087939 A
- JP 2012255128 A
- JP 2013043962 A
- JP 2014130338 A
- JP 2019078878 A
- JP 2014130173 A
- JP 6301489 B
- JP 2001233842 A
- JP 2000080068 A
- JP 2006342166 A
- JP 2000066385 A
- JP 2004534797 A
- JP 2017019766 A
- JP 6065596 B
- WO 2015152153 A
- WO 2017051680 A
- JP 2017198865 A
- WO 2017164127 A
- WO 2013167515 A
- WO 2019088055 A
- JP 2012014052 A
- JP 2014137466 A
- WO 2013083505 A
- JP 2010262028 A
- JP 2014500852 A
- JP 2013164471 A
- JP 2013114249 A
- JP 4223071 B
- WO 2015036910 A
- JP 2010527339 A
- JP 2011524436 A
- WO 2015004565 A
- JP 2016532675 A
- WO 2017033680 A
- JP 2013522445 A
- WO 2016034963 A
- JP 2017523465 A
- JP 2017167399 A
- JP 2017151342 A
- JP 2011089090 A
- WO 2015166779 A
- JP 2012003225 A
- US 20130034812 A
- JP 2008250074 A
- JP 2013195480 A
- JP 2015500562 A
- JP 2014533890 A
- US 201237789 A
- WO 2008131313 A
- JP 2011233983 A

**Non-patent literature cited in the description**


- **A. J. LEO.** Comprehensive Medicinal Chemistry. Pergamon Press, 1990, vol. 4, 295
- **C. HANSCH ; A. J. LEO.** Substituent Constants For Correlation Analysis in Chemistry and Biology. John Wiley & Sons
- **A. J. LEO.** Calculating logPoct from structure. *Chem. Rev.,* 1993, vol. 93, 1281-1306
- Advanced Chemistry Development (ACD/Labs) Software V 8.14 for Solaris. ACD/Labs, 1994
- **KIYOMI KATO.** Ultraviolet Curing System. GL Sciences Inc, 1989, 65-148
- *J. C. S. Perkin II,* 1979, 1653-1660
- *J. C. S. Perkin II,* 1979, 156-162
- *Journal of Photopolymer Science and Technology,* 1995, 202-232
- **YASUHIRA KANNO.** Glossary of liquid crystal display manufacturing device. NIKKAN KOGYO SHIMBUN, LTD, 1996, 64
- **AKIO SASAKI.** Electronic display device. Kogyo Chosakai Publishing Co., Ltd, 1990
- **SUMIAKI IBUKI.** Display device. Sangyo Tosho Publishing Co., Ltd, 1989
- Next-Generation Liquid Crystal Display Technology. Kogyo Chosakai Publishing Co., Ltd, 1994